(19) Europäisches Patentamt
European Patent Office
Office européen des brevets

(11) EP 3 991 984 B1

(12) EUROPEAN PATENT SPECIFICATION

(45) Date of publication and mention of the grant of the patent:
**30.07.2025 Bulletin 2025/31**

(21) Application number: **20831098.7**

(22) Date of filing: **26.06.2020**

(51) International Patent Classification (IPC):
***B41C 1/10*** *(2006.01)*

(52) Cooperative Patent Classification (CPC):
**B41C 1/1016;** B41C 2201/02; B41C 2201/12; B41C 2201/14; B41C 2210/04; B41C 2210/08; B41C 2210/22; B41C 2210/24

(86) International application number:
**PCT/JP2020/025415**

(87) International publication number:
**WO 2020/262693 (30.12.2020 Gazette 2020/53)**

# (54) LITHOGRAPHIC PRINTING PLATE PRECURSOR AND METHOD FOR PREPARING A LITHOGRAPHIC PRINTING PLATE

LITHOGRAFISCHE DRUCKPLATTE UND VERFAHREN ZUR HERSTELLUNG EINER LITHOGRAFISCHEN DRUCKPLATTE

PLAQUE D'IMPRESSION LITHOGRAPHIQUE ET PROCÉDÉ DE PRODUCTION DE PLAQUE D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.06.2019 JP 2019122481**
**30.08.2019 JP 2019158813**
**18.09.2019 JP 2019169809**

(43) Date of publication of application:
**04.05.2022 Bulletin 2022/18**

(73) Proprietor: **FUJIFILM Corporation**
**Tokyo 106-8620 (JP)**

(72) Inventor: **SAKAGUCHI, Akira**
**Shizuoka 421-0396 (JP)**

(74) Representative: **HGF**
**HGF Limited**
**1 City Walk**
**Leeds LS11 9DX (GB)**

(56) References cited:
**EP-A1- 2 105 298**
**EP-A1- 2 297 611**
**EP-A1- 3 409 498**
**EP-A2- 1 449 650**
**EP-A2- 1 449 653**
**EP-A2- 1 972 439**
**EP-A2- 2 113 381**
**WO-A1-2018/159640**
**WO-A1-2019/013268**
**WO-A1-2019/013268**
**JP-A- 2000 171 974**
**JP-A- 2013 504 084**
**JP-A- 2014 079 960**
**JP-A- 2019 064 269**
**JP-A- S63 202 497**
**JP-B1- 6 461 447**
**US-A1- 2018 207 925**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

The present invention relates to a lithographic printing plate precursor, a method for preparing a lithographic printing plate, and a lithographic printing method.

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate so that only the image area receives the ink, and then printing is performed by the transfer of the ink to a printing substrate such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, in this method, after being exposed, a lithographic printing plate precursor is immediately mounted on a printer without being developed as in the related art, and an unnecessary portion of the image-recording layer is removed at an early stage of the ordinary printing step.

Examples of the lithographic printing plate precursors in the related art include those described in JP2018-508385A or JP2013-199130A.

JP2018-508385A describes a negative tone lithographic printing plate precursor including a substrate and a negative tone image forming layer disposed on the substrate, in which the image forming layer can be removed with either or both of an ink for lithographic printing and dampening water and contains (A) at least one kind of free radically polymerizable compound, (B) at least one kind of free radical polymerization initiator, and (C) at least one kind of polymer that has a polysaccharide skeleton having a radically polymerizable group and is different from (A).

JP2013-199130A describes a lithographic printing plate precursor having an image-recording layer that can be removed with water or an aqueous component and an overcoat layer in this order on a support, in which a polymer component that takes up 50% by mass or more of the total mass of polymer components contained in the overcoat layer is a polymer having a mass average molecular weight of 110,000 or more.

WO 2019/013268A1 discloses an image recording layer provided on a hydrophilic support, the image recording layer contains a polymerization initiator, an infrared absorbing agent, a polymerizable compound, and an acid coloring agent, and the infrared absorbing agent is represented by a Formula 1A.

EP 1449650 A2 discloses a photosensitive composition comprising an infrared absorbing agent, a sulfonium salt polymerization initiator, a polymerizable compound having a urethane skeleton and a binder polymer.

EP 1449653 A2 discloses a photosensitive composition comprising an infrared absorbing agent, a sulfonium salt polymerization initiator, a polymerizable compound, a binder polymer, and a compound having a weight average molecular weight of 3000 or less and having at least one carboxylic acid group.

EP 1972439 A2 discloses a lithographic printing plate precursor, which is on-press developable by supplying an oily ink and an aqueous component, comprising an image forming layer that has, in an exposed area thereof at 25°C, a water content change rate of 2.0 mass% or less when relative humidity is changed from 30% to 50%.

EP 2297611 A1 discloses a negative-working, on-press developable imageable element comprising a substrate having thereon an imageable layer comprising: a radically polymerizable component, an initiator composition capable of generating free radicals sufficient to initiate polymerization of free radically polymerizable groups upon exposure to imaging infrared radiation, a primary polymeric binder that has a backbone, and an infrared radiation absorbing dye, said element further comprising a topcoat layer disposed on said imageable layer, said topcoat layer comprising a water-soluble polymer binder and a composition that is capable of changing color upon exposure to imaging infrared radiation.

EP 2113381 A2 discloses a negative-working imageable element having an imageable layer that includes an infrared radiation absorbing dye that upon exposure to thermal irradiation, changes from colorless to a visible color or from one visible color to another visible color, providing a $\Delta E$ of at least 5 between the exposed and non-exposed regions of the imageable layer within 3 hours of its exposure to 300 $mJ/cm^2$ at a laser power of 15 Watts.

EP 2105298 A1 discloses a negative-working lithographic printing plate precursor comprising on a hydrophilic support a photopolymerizable layer that contains at least one selected from the group consisting of a polymer compound that has an

ethylenically unsaturated bond in the side chain position, a hydrophilic group and a sulfonamide group and a polymer compound that has an ethylenically unsaturated bond in the side chain position, a hydrophilic group and a cyclic structure derived from a maleimide.

EP 3409498 A1 discloses a planographic printing plate precursor for on-press development, comprising: an aluminum support; an interlayer which contains a compound containing a support absorptive group and a hydrophilic group; and an image recording layer which contains an infrared absorbing agent, a polymerization initiator, a polymerizable compound, and polymer particles formed of a styrene copolymer, on the aluminum support, wherein the aluminum support is an aluminum plate having an anodized film on a surface in contact with the interlayer and the anodized film has micropores extending in a depth direction from a surface in contact with the interlayer, and an average pore diameter of the micropores in the surface of the anodized film is in a range of 20 to 40 nm.

An object of an embodiment of the present invention is to provide a lithographic printing plate precursor that has excellent on-press developability and provides a lithographic printing plate having excellent receptivity.

An object of another embodiment of the present invention is to provide a method for preparing a lithographic printing plate or a lithographic printing method using the lithographic printing plate precursor.

According to an embodiment of the present invention, it is possible to provide a lithographic printing plate precursor that has excellent on-press developability and provides a lithographic printing plate having excellent receptivity.

According to another embodiment of the present invention, it is possible to provide a method for preparing a lithographic printing plate or a lithographic printing method using the lithographic printing plate precursor.

BRIEF DESCRIPTION OF THE DRAWINGS

Fig. 1 is a schematic cross-sectional view of an embodiment of an aluminum support.
Fig. 2 is a schematic cross-sectional view of another embodiment of the aluminum support.
Fig. 3 is an example of a waveform graph of alternating current used for an electrochemical roughening treatment in a method for manufacturing an aluminum support.
Fig. 4 is a lateral view showing an example of a radial cell in an electrochemical roughening treatment using alternating current in a method for manufacturing an aluminum support.
Fig. 5 is a lateral view showing an example of a radial cell in an electrochemical roughening treatment using alternating current in a method for manufacturing an aluminum support having an anodic oxide film.

Hereinafter, the contents of the present invention will be specifically described. The following constituents will be described on the basis of typical embodiments of the present invention, but the present invention is not limited to such embodiments.

In the present specification, a numerical range expressed using "to" includes numerical values listed before and after "to" as the lower limit and the upper limit.

Regarding the numerical ranges described stepwise in the present specification, the upper limit or lower limit of a numerical range may be replaced with the upper limit or lower limit of another numerical range described stepwise. Furthermore, the upper limit and lower limit of a numerical range described in the present specification may be replaced with the values shown in Examples.

In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved. In the present specification, "% by mass" has the same definition as "% by weight", and "part by mass" has the same definition as "part by weight".

In the present specification, a combination of two or more preferred aspects is a more preferred aspect.

In addition, in the present specification, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present specification, the term "lithographic printing plate precursor" refers not only to a lithographic

printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

Hereinafter, the present invention will be specifically described.

(Lithographic printing plate precursor)

The lithographic printing plate precursor according to the present invention has an aluminum support and an image-recording layer on the aluminum support, in which the image-recording layer contains an infrared absorber, a polymerization initiator, a polymerizable compound, and an addition polymerization-type resin having a dispersible group, and in a case where a capacitance Cp of the lithographic printing plate precursor is set to satisfy Cp (t)/Cp (20 seconds) = 0.95, t satisfies t < 12 seconds.

The capacitance Cp of the lithographic printing plate precursor is measured by bringing at least a measurement portion of the image-recording layer into contact with a 2% by mass aqueous sodium chloride solution at 25°C, t represents an elapsed time from when the measurement portion is covered with the aqueous sodium chloride solution, and Cp (t) represents a capacitance measured after t seconds.

Disclosed herein is a lithographic printing plate precursor which has an aluminum support and an image-recording layer on the aluminum support, in which the image-recording layer contains an infrared absorber, a polymerization initiator, a polymerizable compound, and an addition polymerization-type resin having a dispersible group, and a capacitance Cp of the lithographic printing plate precursor satisfies Cp (0 seconds) > 400 nF.

The capacitance Cp of the lithographic printing plate precursor is measured by bringing at least a measurement portion of the image-recording layer into contact with a 2% by mass aqueous sodium chloride solution at 25°C, and Cp (0 seconds) represents a capacitance measured immediately after the measurement portion is covered with the aqueous sodium chloride solution.

In the present specification, in a case where a term such as "lithographic printing plate precursor according to the present embodiment" is simply mentioned, unless otherwise specified, the term refers to the invention.. Furthermore, in a case where a term such as "image-recording layer" is simply mentioned, unless otherwise specified, the term refers to the image-recording layer of the invention.

In addition, the lithographic printing plate precursor according to the present invention is a negative tone lithographic printing plate precursor and can be suitably used as a lithographic printing plate precursor for on-press development.

As a result of intensive studies, the inventors of the present invention have found that adopting the above constitution makes it possible to provide a lithographic printing plate precursor that has excellent on-press developability and can provide a lithographic printing plate having excellent receptivity.

The detailed mechanism that brings about the aforementioned effect is unclear, but is assumed to be as below.

Presumably, in a case where the image-recording layer contains an addition polymerization-type resin having a dispersible group, and t < 12 seconds or Cp (0 seconds) > 400 nF is satisfied under the condition that a capacitance Cp of the lithographic printing plate precursor is set to satisfy Cp (t)/Cp (20 seconds) = 0.95, the permeability of water to the image-recording layer may be enhanced, and on-press developability may be improved. Furthermore, presumably, in an image area, due to the heat that the infrared absorber or the like produces by exposure, the dispersible group contained in the addition polymerization-type resin may move to the surface side of the image-recording layer, the surface side may be more hydrophobic, and the receptivity of the obtained lithographic printing plate may be improved.

In the present invention, the capacitance Cp of the lithographic printing plate precursor is measured by the following procedure by using 3522-50 LCR HITESTER manufactured by HIOKI E.E. CORPORATION.

A seal having a 1.0 cm × 1.5 cm window is stuck to the surface of the lithographic printing plate precursor on the side of the image-recording layer before exposure so that water is prevented from permeating sites other than the window portion. Capacitance is measured from when the window portion (measurement portion) of the lithographic printing plate precursor is completely immersed in a 2% by mass aqueous sodium chloride solution at 25°C. At this time, the lithographic printing plate precursor other than the window portion is not immersed in the aqueous sodium chloride solution. A measurement electrode is provided on the aluminum support that is immersed in the aqueous sodium chloride solution and not coated with an image-recording layer, and on the back surface of the lithographic printing plate precursor on side of the aluminum support that is not in contact with the 2% by mass aqueous sodium chloride solution. As the aluminum support that is not coated with the image-recording layer, the same aluminum support as that used in the lithographic printing plate precursor is used. Cp (t) represents the value of capacitance measured after t seconds immediately after the measurement portion is covered with the aqueous sodium chloride solution.

In a case where the capacitance Cp of the lithographic printing plate precursor in the first embodiment of the lithographic printing plate precursor according to the present invention is set to satisfy Cp (t)/Cp (20 seconds) = 0.95, t satisfies t < 12 seconds. From the viewpoint of on-press developability and receptivity of the lithographic printing plate to be obtained, t is preferably 10 seconds or less, more preferably 9 seconds or less, even more preferably 7 seconds or less, and particularly preferably 6.5 seconds or less.
Furthermore, t in the image-recording layer in the lithographic printing plate precursor according to the present invention is preferably 1 second or longer, and more preferably 2 seconds or longer.
From the viewpoint of on-press developability and receptivity of the lithographic printing plate to be obtained, the capacitance Cp of the lithographic printing plate precursor in the of the lithographic printing plate precursor according to the present invention preferably satisfies CP (0 seconds) > 400 nF. The value of CP (0 seconds) is more preferably more than 500 nF, even more preferably 550 nF or more, particularly preferably more than 600 nF, and most preferably 650 nF or more and 1,000 nF or less.
The method for causing the capacitance Cp to satisfy the above value is not particularly limited, and preferable examples thereof include the following aspects.
It is preferable that the image-recording layer contain addition polymerization-type resin particles.
The addition polymerization-type resin to be incorporated into the image-recording layer is preferably a resin having a constitutional unit formed of an acrylonitrile compound, and more preferably a resin having a constitutional unit formed of an aromatic vinyl compound and a constitutional unit formed of an acrylonitrile compound.
Furthermore, the aforementioned dispersible group is preferably an acid group or a group having a polyalkylene oxide structure, more preferably a sulfo group or a group having a polyalkylene oxide structure, and particularly preferably a group having a polyalkylene oxide structure.
In addition, it is preferable that the image-recording layer contain a compound satisfying $\delta p$ = 12.3 to 26.0 in the Hansen solubility parameters which will be described later.
The compound satisfying $\delta p$ = 2.4 to 14 is preferably a compound having a hydrophilic group, more preferably a compound having an acid group, and even more preferably a compound having a sulfo group.

<Image-recording layer>

The lithographic printing plate precursor according to the present invention has an image-recording layer formed on an aluminum support, and contains an infrared absorber, a polymerization initiator, a polymerizable compound, and an addition polymerization-type resin having a dispersible group.
From the viewpoint of printing durability and photosensitivity, the image-recording layer used in the present invention preferably further contains an electron-accepting polymerization initiator as the aforementioned polymerization initiator.
The image-recording layer inventionmay further contain an acid color-developing agent so that the exposed portion is checked before development.
In the lithographic printing plate precursor according to the present invention, from the viewpoint of on-press developability, it is preferable that a non-exposed portion of the image-recording layer can be removed with at least one material selected from the group consisting of dampening water and a printing ink.
Furthermore, from the viewpoint of receptivity, the image-recording layer in the lithographic printing plate precursor according to the present invention is preferably the outermost layer.
Hereinafter, each of the components contained in the image-recording layer will be specifically described.

-Addition polymerization-type resin having dispersible group-

The image-recording layer in the present invention contains an addition polymerization-type resin having a dispersible group (hereinafter, also simply called "addition polymerization-type resin").
The addition polymerization-type resin in the present invention may be particles or a binder resin (binder polymer) that is not in the form of particles. From the viewpoint of receptivity, the addition polymerization-type resin is preferably particles. Furthermore, in a case where the image-recording layer is formed by coating, from the viewpoint of the stability of a coating solution, the addition polymerization-type resin is preferably a binder polymer (not being particles).

[Dispersible group]

The addition polymerization-type resin has a dispersible group, and preferably has a dispersible group-containing constitutional unit.
Examples of the dispersible group include an acid group such as a carboxy group or a sulfo group, a hydroxyl group, an amino group, a long-chain alkyl group having 8 or more carbon atoms, and a group having a polyalkylene oxide

structure or the like.

Among these, an acid group or a group having a polyalkylene oxide structure is preferable, a sulfo group or a group having a polyalkylene oxide structure is more preferable, and a group having a polyalkylene oxide structure is particularly preferable.

Furthermore, from the viewpoint of on-press developability and inhibiting the occurrence of development residues during on-press development, the polyalkylene oxide structure preferably has a polypropylene oxide structure, and more preferably has a polyethylene oxide structure and a polypropylene oxide structure.

Furthermore, from the viewpoint of printing durability, receptivity, and on-press developability, the dispersible group preferably includes a group represented by Formula Z.

*-Q-W-Y Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

Q in Formula Z is preferably a divalent linking group having 1 to 20 carbon atoms, and more preferably a divalent linking group having 1 to 10 carbon atoms.

Furthermore, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one end of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represents a linear, branched, or cyclic alkylene group having 6 to 120 carbon atoms, a haloalkylene group having 6 to 120 carbon atoms, an arylene group having 6 to 120 carbon atoms, an alkarylene group having 6 to 120 carbon atoms (divalent group formed by removing one hydrogen atom from an alkylaryl group), or an aralkylene group having 6 to 120 carbon atoms.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group having 6 to 120 carbon atoms (alkylaryl group), an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of printing durability, receptivity, and on-press developability, in the group represented by formula Z, W is more preferably a divalent group having a hydrophilic structure, Q is more preferably a phenylene group, an ester bond, or an amide bond, W is more preferably a polyalkyleneoxy group, and Y is more preferably a polyalkyleneoxy group having a hydrogen atom or an alkyl group on a terminal.

From the viewpoint of receptivity and on-press developability, it is preferable that the addition polymerization-type resin have a constitutional unit formed of an aromatic vinyl compound and a constitutional unit formed of an acrylonitrile compound.

[Constitutional unit formed of aromatic vinyl compound]

The addition polymerization-type resin has a constitutional unit formed of an aromatic vinyl compound.

The aromatic vinyl compound has no limitations as long as it has a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these, for example, 1-vinylnaphthalene is preferable.

Preferable examples of the constitutional unit formed of an aromatic vinyl compound include a constitutional unit represented by Formula A1.

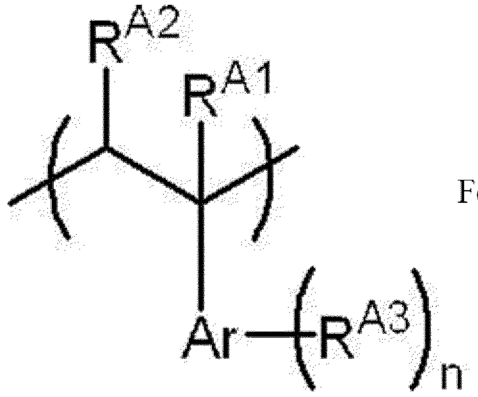

Formula A1

In Formula A1, $R^{A1}$ and $R^{A2}$ each independently represent a hydrogen atom or an alkyl group, Ar represents an aromatic ring group, $R^{A3}$ represents a substituent, and n represents an integer equal to or less than the maximum number of substituents of Ar.
In Formula A1, $R^{A1}$ and $R^{A2}$ preferably each independently represent a hydrogen atom or an alkyl group having 1 to 4 carbon atoms, more preferably each independently represent a hydrogen atom or a methyl group, and even more preferably both represent a hydrogen atom.
In Formula A1, Ar is preferably a benzene ring or a naphthalene ring, and more preferably a benzene ring.
In Formula A1, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.
In a case where there is a plurality of $R^{A3}$'s in Formula A1, the plurality of $R^{A3}$'s may be the same as or different from each other.
In Formula A1, n is preferably an integer of 0 to 2, more preferably 0 or 1, and even more preferably 0.
In the addition polymerization-type resin, the content of the constitutional unit formed of an aromatic vinyl compound with respect to the total mass of the addition polymerization-type resin is preferably 15% by mass to 85% by mass, and more preferably 30% by mass to 70% by mass.

[Constitutional unit formed of acrylonitrile compound]

The addition polymerization-type resin has a constitutional unit formed of an acrylonitrile compound.
Examples of the acrylonitrile compound include (meth)acrylonitrile and the like. Among these, for example, acrylonitrile is preferable.
Preferable examples of the constitutional unit formed of an acrylonitrile compound include a constitutional unit represented by Formula B1.

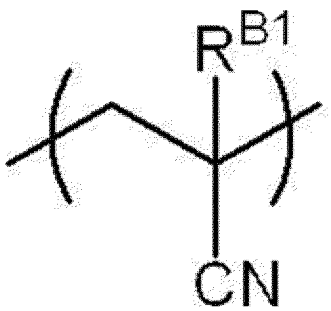

Formula B1

In Formula B1, $R^{B1}$ represents a hydrogen atom or an alkyl group.
In Formula B1, $R^{B1}$ is preferably a hydrogen atom or an alkyl group having 1 to 4 carbon atoms, more preferably a hydrogen atom or a methyl group, and even more preferably a hydrogen atom.
In the addition polymerization-type resin, the content of the constitutional unit formed of an acrylonitrile compound with respect to the total mass of the addition polymerization-type resin is preferably 15% by mass to 85% by mass, and more preferably 30% by mass to 70% by mass.

[Constitutional unit formed of N-vinyl heterocyclic compound]

From the viewpoint of printing durability and chemical resistance, it is preferable that the addition polymerization-type resin further have a constitutional unit formed of N-vinyl heterocyclic compound.

Examples of the N-vinyl heterocyclic compound include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

Preferable examples of the constitutional unit formed of a N-vinyl heterocyclic compound include a constitutional unit represented by Formula C1.

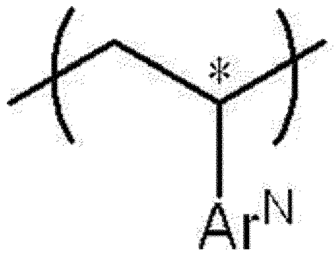

Formula C1

In Formula C1, $Ar^N$ represents a nitrogen atom-containing heterocyclic structure, and the nitrogen atom in $Ar^N$ is bonded to the carbon atom represented by *.

In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.

Furthermore, the heterocyclic structure represented by $Ar^N$ may have a known substituent.

In the addition polymerization-type resin, the content of the constitutional unit formed of a N-vinyl heterocyclic compound with respect to the total mass of the addition polymerization-type resin is preferably 5% by mass to 50% by mass, and more preferably 10% by mass to 40% by mass.

[Ethylenically unsaturated group-containing constitutional unit]

The addition polymerization-type resin may further have an ethylenically unsaturated group-containing constitutional unit.

The ethylenically unsaturated group is not particularly limited, and examples thereof include a vinyl group, an allyl group, a vinylphenyl group, a (meth)acrylamide group, a (meth)acryloyloxy group, or the like. From the viewpoint of reactivity, the ethylenically unsaturated group is preferably a (meth)acryloyloxy group.

The ethylenically unsaturated group-containing constitutional unit can be introduced into the addition polymerization-type resin by a polymer reaction or copolymerization. Specifically, this constitutional unit can be introduced into the resin, for example, by a method of reacting a compound (such as glycidyl methacrylate) having an epoxy group or an ethylenically unsaturated group with a polymer into which a constitutional unit having a carboxy group such as methacrylic acid is introduced, a method of reacting a compound (such as 2-isocyanatoethyl methacrylate) having an isocyanate group and an ethylenically unsaturated group with a polymer into which a constitutional unit having an active hydrogen-containing group such as a hydroxyl group is introduced, and the like.

Furthermore, the ethylenically unsaturated group-containing constitutional unit may be introduced into the addition polymerization-type resin by a method of reacting a compound having a carboxy group and an ethylenically unsaturated group with a polymer into which a constitutional unit having an epoxy group such as glycidyl (meth)acrylate is introduced.

In addition, the ethylenically unsaturated group-containing constitutional unit may be introduced into the addition polymerization-type resin, for example, by using a monomer having a partial structure represented by Formula d1 or Formula d2. Specifically, for example, after polymerization is performed using at least the aforementioned monomer, an ethylenically unsaturated group is formed in the partial structure represented by Formula d1 or Formula d2 by a dissociation reaction using a base compound so that the ethylenically unsaturated group-containing constitutional unit is introduced into the addition polymerization-type resin.

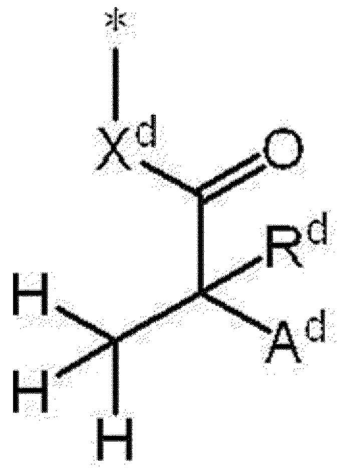

Formula d1

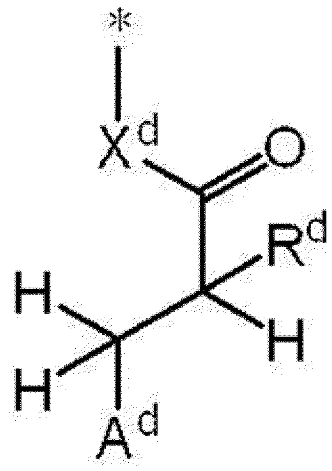

Formula d2

In Formula d1 and Formula d2, $R^d$ represents a hydrogen atom or an alkyl group, $A^d$ represents a halogen atom, $X^d$ represents -O- or $-NR^N-$, $R^N$ represents a hydrogen atom or an alkyl group, and * represents a binding site with other structures.

In Formula d1 and Formula d2, $R^d$ is preferably a hydrogen atom or a methyl group.

In Formula d1 and Formula d2, $A^d$ is preferably a chlorine atom, a bromine atom, or an iodine atom.

In Formula d1 and Formula d2, $X^d$ is preferably -O-. In a case where $X^d$ represents $-NR^N-$, $R^N$ is preferably a hydrogen atom or an alkyl group having 1 to 4 carbon atoms, and more preferably a hydrogen atom.

Examples of the ethylenically unsaturated group-containing constitutional unit include a constitutional unit represented by Formula D1.

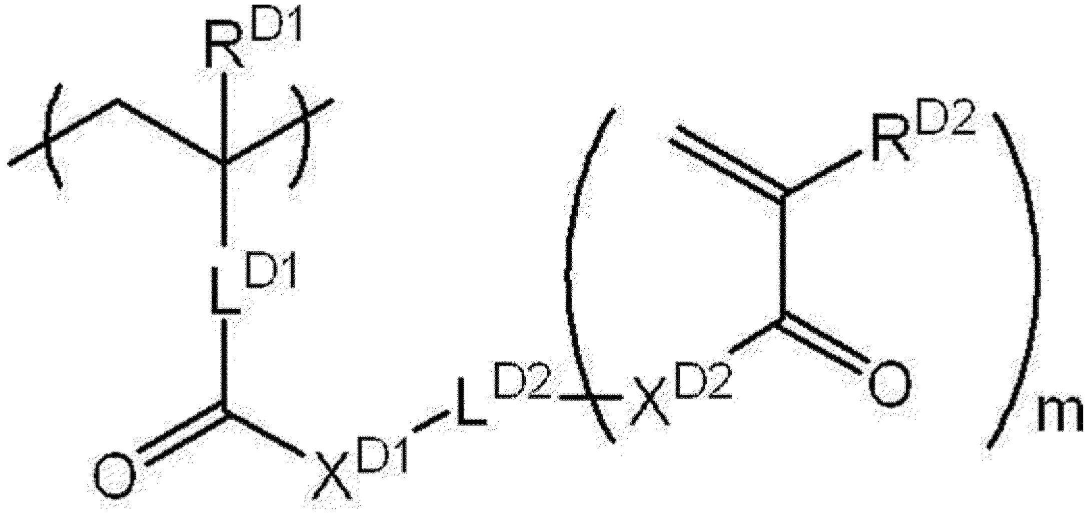

Formula D1

In Formula D1, $L^{D1}$ represents a single bond or a divalent linking group, $L^{D2}$ represents an (m + 1)-valent linking group, $X^{D1}$ and $X^{D2}$ each independently represent -O- or $-NR^N-$, $R^N$ represents a hydrogen atom or an alkyl group, $R^{D1}$ and $R^{D2}$ each independently represent a hydrogen atom or a methyl group, and m represents an integer of 1 or more.

In Formula D1, $L^{D1}$ is preferably a single bond. In a case where $L^{D1}$ represents a divalent linking group, an alkylene group, an arylene group, or a divalent group in which two or more of these are bonded is preferable, and an alkylene group having 2 to 10 carbon atoms or a phenylene group is more preferable.

In Formula D1, $L^{D2}$ is preferably a group represented by any of Formula D2 to Formula D6.

In Formula D1, $X^{D1}$ and $X^{D2}$ preferably both represent -O-. In a case where at least one of $X^{D1}$ or $X^{D2}$ represents $-NR^N-$, $R^N$ is preferably a hydrogen atom or an alkyl group having 1 to 4 carbon atoms, and more preferably a hydrogen

atom.

In Formula D1, $R^{D1}$ is preferably a methyl group.

In Formula D1, at least one of m pieces of $R^{D2}$ is preferably a methyl group.

In Formula D1, m is preferably an integer of 1 to 4, more preferably 1 or 2, and even more preferably 1.

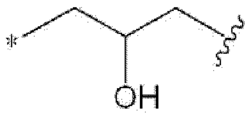

Formula D2

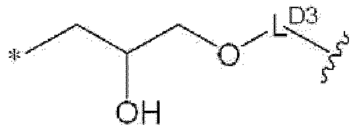

Formula D3

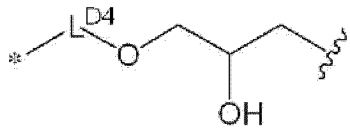

Formula D4

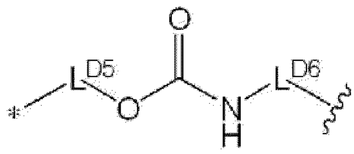

Formula D5

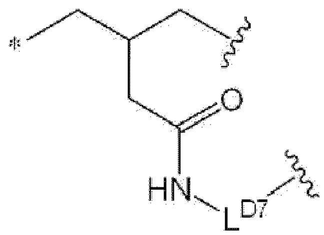

Formula D6

In Formula D2 to Formula D6, $L^{D3}$ to $L^{D7}$ each represent a divalent linking group, $L^{D5}$ and $L^{D6}$ may be different from each other, * represents a binding site with $X^{D1}$ in Formula D1, and the portion of the wavy line represents a binding site with $X^{D2}$ in Formula D1.

In Formula D3, $L^{D3}$ is preferably an alkylene group, an arylene group, or a group in which two or more of these are bonded, and more preferably an alkylene group having 1 to 10 carbon atoms, a phenylene group, or a group in which two or more of these are bonded.

In Formula D4, $L^{D4}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $L^{D5}$ is preferably an alkylene group, an arylene group, or a group in which two or more of these are bonded, and more preferably an alkylene group having 1 to 10 carbon atoms, a phenylene group, or a group in which two or more of these are bonded.

In Formula D6, $L^{D6}$ is preferably an alkylene group, an arylene group, or a group in which two or more of these are bonded, and more preferably an alkylene group having 1 to 10 carbon atoms, a phenylene group, or a group in which two or more of these are bonded.

In Formula D7, $L^{D7}$ is preferably an alkylene group, an arylene group, or a group in which two or more of these are bonded, and more preferably an alkylene group having 1 to 10 carbon atoms, a phenylene group, or a group in which two or more of these are bonded.

Specific examples of the ethylenically unsaturated group-containing constitutional unit will be shown below. However, the ethylenically unsaturated group-containing constitutional unit contained in the binder polymer is not limited thereto. In the following specific examples, R each independently represents a hydrogen atom or a methyl group.

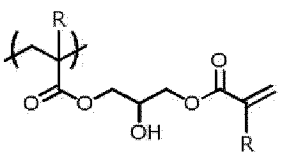

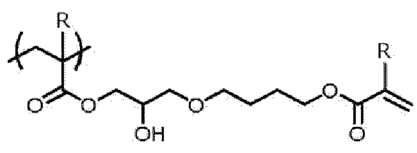

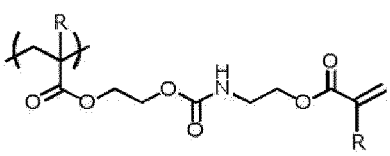

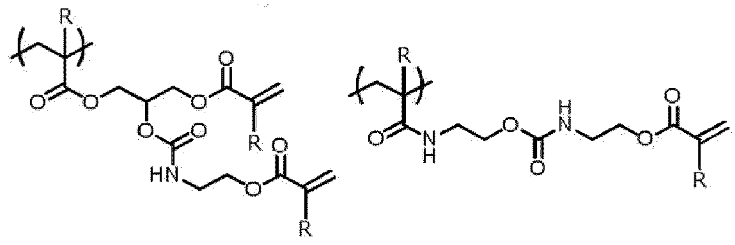

**In** the addition polymerization-type resin, the content of the ethylenically unsaturated group-containing constitutional unit with respect to the total mass of the addition polymerization-type resin is preferably 5% by mass to 60% by mass, and more preferably 10% by mass to 30% by mass.

[Acid group-containing constitutional unit]

The addition polymerization-type resin may contain an acid group-containing constitutional unit. From the viewpoint of on-press developability and ink receptivity, it is preferable that the addition polymerization-type resin do not contain an acid group-containing constitutional unit.

Specifically, in the addition polymerization-type resin, the content of the acid group-containing constitutional unit is preferably 20% by mass or less, more preferably 10% by mass or less, and even more preferably 5% by mass or less. The lower limit of the content is not particularly limited, and may be 0% by mass.

The acid value of the addition polymerization-type resin is preferably 160 mg KOH/g or less, more preferably 80 mg KOH/g or less, and even more preferably 40 mg KOH/g or less. The lower limit of the acid value is not particularly limited, and may be 0 mg KOH/g.

The acid value is determined by the measurement method based on JIS K0070: 1992.

[Hydrophobic group-containing constitutional unit]

From the viewpoint of ink receptivity, the addition polymerization-type resin may contain a hydrophobic group-containing constitutional unit.

Examples of the hydrophobic group include an alkyl group, an aryl group, an aralkyl group, and the like.

As the hydrophobic group-containing constitutional unit, a constitutional unit formed of an alkyl (meth)acrylate compound, an aryl (meth)acrylate compound, or an aralkyl (meth)acrylate compound is preferable, and a constitutional unit formed of an alkyl (meth)acrylate compound is more preferable.

The alkyl group in the alkyl (meth)acrylate compound preferably has 1 to 10 carbon atoms. The alkyl group may be linear or branched or may have a cyclic structure. Examples of the alkyl (meth)acrylate compound include methyl (meth) acrylate, ethyl (meth)acrylate, propyl (meth)acrylate, cyclohexyl (meth)acrylate, 2-ethylhexyl (meth)acrylate, dicyclopentanyl (meth)acrylate, and the like.

The aryl group in the aryl (meth)acrylate compound preferably has 6 to 20 carbon atoms. The aryl group is more preferably a phenyl group. The aryl group may further have a known substituent. Preferable examples of the aryl (meth) acrylate compound include phenyl (meth)acrylate.

The alkyl group in the aralkyl (meth)acrylate compound preferably has 1 to 10 carbon atoms. The alkyl group may be linear or branched or may have a cyclic structure. The aryl group in the aralkyl (meth)acrylate compound preferably has 6 to 20 carbon atoms. The aryl group is more preferably a phenyl group. Preferable examples of the aralkyl (meth)acrylate compound include benzyl (meth)acrylate.

In the addition polymerization-type resin, the content of the hydrophobic group-containing constitutional unit with respect to the total mass of the addition polymerization-type resin is preferably 5% by mass to 50% by mass, and more preferably 10% by mass to 30% by mass.

[Other constitutional units]

The addition polymerization-type resin may further contain other constitutional units. The addition polymerization-type resin can contain, as those other constitutional units, constitutional units other than the constitutional units described above without particular limitations. Examples thereof include constitutional units formed of an acrylamide compound, a vinyl ether compound, and the like.

Examples of the acrylamide compound include (meth)acrylamide, N-methyl (meth)acrylamide, N-ethyl (meth) acrylamide, N-propyl (meth)acrylamide, N-butyl (meth)acrylamide, N,N'-dimethyl (meth)acrylamide, N,N'-diethyl (meth) acrylamide, N-hydroxyethyl (meth)acrylamide, N-hydroxypropyl (meth)acrylamide, N-hydroxybutyl (meth)acrylamide,

and the like.

Examples of the vinyl ether compound include methyl vinyl ether, ethyl vinyl ether, propyl vinyl ether, n-butyl vinyl ether, tert-butyl vinyl ether, 2-ethylhexyl vinyl ether, n-nonyl vinyl ether, lauryl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethylcyclohexylmethyl vinyl ether, diethylene glycol monovinyl ether, polyethylene glycol vinyl ether, chloroethyl vinyl ether, chlorobutyl vinyl ether, chloroethoxyethyl vinyl ether, phenylethyl vinyl ether, phenoxypolyethylene glycol vinyl ether, and the like.

In the addition polymerization-type resin, the content of those other constitutional units with respect to the total mass of the addition polymerization-type resin is preferably 5% by mass to 50% by mass, and more preferably 10% by mass to 30% by mass.

The method for manufacturing the addition polymerization-type resin is not particularly limited. The addition polymerization-type resin can be manufactured by known methods.

For example, the addition polymerization-type resin is obtained by polymerizing a styrene compound, an acrylonitrile compound, an ethylenically unsaturated compound having a dispersible group, and at least one kind of optional compound selected from the group consisting of the aforementioned N-vinyl heterocyclic compound, a compound used for forming the aforementioned ethylenically unsaturated group-containing constitutional unit, a compound used for forming the aforementioned acid group-containing constitutional unit, a compound used for forming the aforementioned hydrophobic group-containing constitutional unit, and a compound used for forming the aforementioned other constitutional units by known methods.

In a case where the addition polymerization-type resin is particles, the average particle diameter of the particles is preferably 0.01 μm to 3.0 μm, more preferably 0.03 μm to 2.0 μm, and even more preferably 0.10 μm to 1.0 μm. In a case where the particle diameter is in this range, excellent resolution and temporal stability are obtained.

The average primary particle diameter of the above particles is measured using a light scattering method or by capturing an electron micrograph of the particles, measuring the particle diameter of a total of 5,000 particles in the photograph, and calculating the average thereof. For non-spherical particles, the value of particle diameter of spherical particles having the same area as the area of the particles on the photograph is adopted as the particle diameter.

Note that unless otherwise specified, the average particle diameter means a volume average particle diameter.

The weight-average molecular weight of the addition polymerization-type resin is preferably 3,000 to 300,000, and more preferably 5,000 to 100,000.

Specific examples of the addition polymerization-type resin will be shown in the following tables, but the addition polymerization-type resin used in the present invention is not limited thereto.

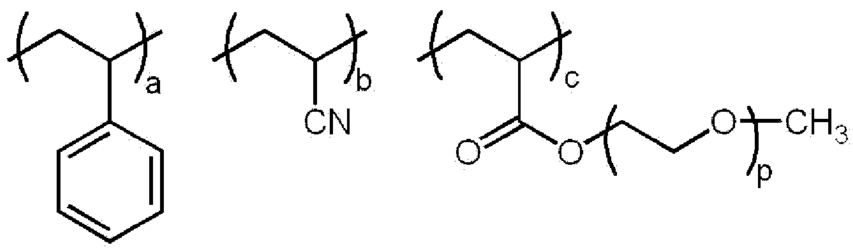

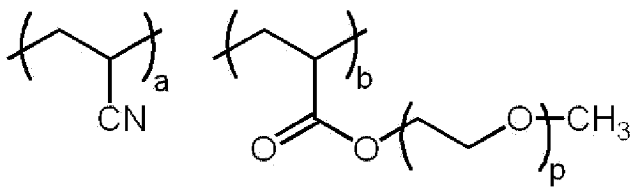

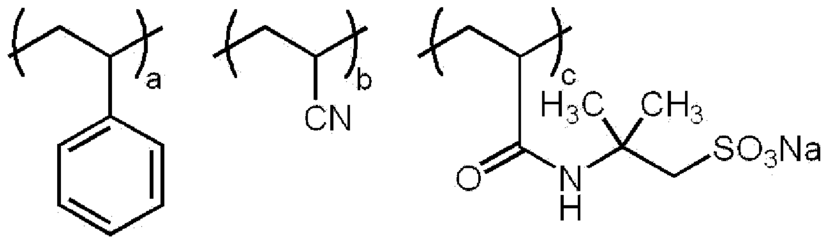

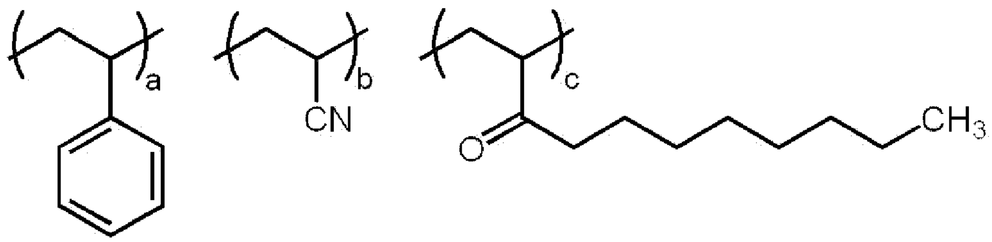

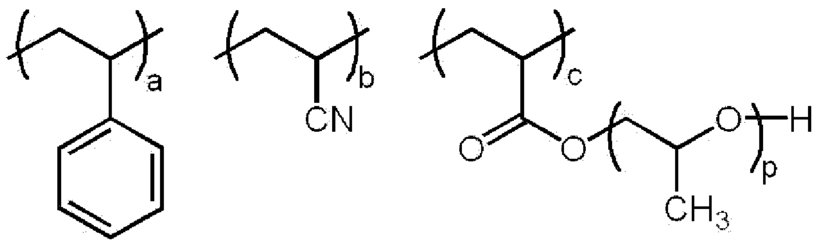

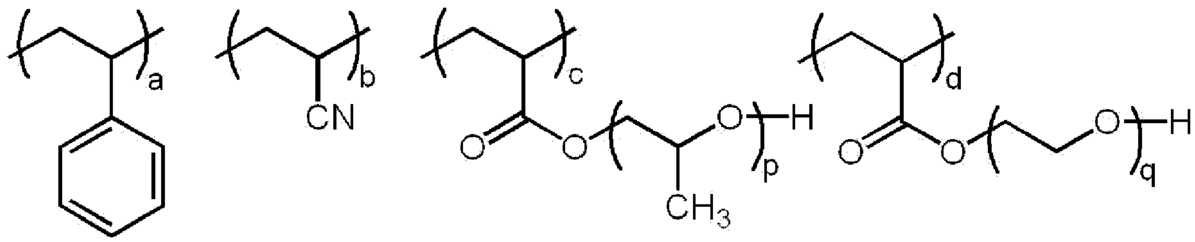

The content ratio of the constitutional units in the above specific examples can be appropriately changed according to the preferred range of the content of each of the constitutional units described above.

Note that although a to d each represent a molar ratio and may be any number, it is preferable that a to d satisfy a = 50 to 99, b = 0 to 45, c = 1 to 10, and d = 1 to 10. Furthermore, p and q each independently represent the number of repeating ethyleneoxy structures or propyleneoxy structures. Each of p and q is preferably 2 to 200, and more preferably 4 to 100.

The weight-average molecular weight of each of the compounds shown in the above specific examples can be appropriately changed according to the preferred range of the weight-average molecular weight of the addition polymerization-type resin described above.

The image-recording layer may contain only one kind of addition polymerization-type resin, or two or more kinds of addition polymerization-type resins may be used in combination.

The content of the addition polymerization-type resin with respect to the total mass of the image-recording layer is preferably 5% by mass or more and 95% by mass or less, more preferably 7% by mass or more and 80% by mass or less, and even more preferably 10% by mass or more and 60% by mass or less.

-Infrared absorber-

The image-recording layer contains an infrared absorber.

Examples of the infrared absorber include a pigment and a dye.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye,

a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Furthermore, for example, a cyanine dye or an indolenine cyanine dye is preferable. Among these, a cyanine dye is particularly preferable.

Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

Furthermore, the compounds described in paragraphs "0008" and "0009" of JP1993-005005A (JP-H05-005005A) and paragraphs "0022" to "0025" of JP2001-222101A can also be preferably used.

As pigments, the compounds described in paragraphs "0072" to "0076" of JP2008-195018A are preferable.

Furthermore, an infrared absorber that decomposes by exposure to infrared (also called "decomposable infrared absorber") can be suitably used.

As the infrared absorber that decomposes by exposure to infrared, those described in JP2008-544322A, WO2016/027886A, WO2017/141882A, or WO2018/043259A can also be suitably used.

One kind of infrared absorber may be used alone, or two or more kinds of infrared absorbers may be used in combination. In addition, as the infrared absorber, a pigment and a dye may be used in combination.

The content of the infrared absorber in the image-recording layer with respect to the total mass of the image-recording layer is preferably 0.1% by mass to 10.0% by mass, and more preferably 0.5% by mass to 5.0% by mass.

-Polymerization initiator-

The image-recording layer in the lithographic printing plate precursor according to the present invention contains a polymerization initiator.

From the viewpoint of sensitivity, printing durability, on-press developability, and receptivity, the polymerization initiator preferably includes an electron-accepting polymerization initiator, and more preferably includes an electron-accepting polymerization initiator and an electron-donating polymerization initiator.

<<Electron-accepting polymerization initiator>>

It is preferable that the image-recording layer contain an electron-accepting polymerization initiator as a polymerization initiator.

The electron-accepting polymerization initiator is a compound which accepts an electron by intermolecular electron transfer in a case where electrons of an infrared absorber are excited by exposure to infrared, and generates a polymerization initiation species such as radicals.

The electron-accepting polymerization initiator is a compound that generates a polymerization initiation species such as a radical or a cation by either or both of light energy and heat energy, and can be appropriately selected from known thermal polymerization initiators, compounds having a bond that can be dissociated by little energy, photopolymerization initiators, and the like.

The electron-accepting polymerization initiator is preferably a radical polymerization initiator and more preferably an onium salt compound.

In addition, as the electron-accepting polymerization initiator, an infrared-ray-sensitive polymerization initiator is preferable.

Examples of the electron-accepting radical polymerization initiator include (a) organic halide, (b) carbonyl compound, (c) azo compound, (d) organic peroxide, (e) metallocene compound, (f) azide compound, (g) hexaarylbiimidazole compound, (i) disulfone compound, (j) oxime ester compound, and (k) onium salt compound.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H08-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (i) disulfone compound include the compounds described in JP1986-166544A (JP-S61-166544A) and JP2002-328465A.

As (j) oxime ester compound, for example, the compounds described in paragraphs "0028" to "0030" of JP2008-195018A are preferable.

Among the above electron-accepting polymerization initiators, from the viewpoint of curing properties, an oxime ester compound and an onium salt compound are preferable. Particularly, from the viewpoint of printing durability, an iodonium salt compound, a sulfonium salt compound, or an azinium salt compound is preferable, an iodonium salt compound or a sulfonium salt compound is more preferable, and an iodonium salt compound is particularly preferable.

Specific examples of these compounds will be shown below.

As the iodonium salt compound, for example, a diaryl iodonium salt compound is preferable. Particularly, a diphenyl iodonium salt compound substituted with an electron donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=-hexafluorophosphate, and bis(4-t-butylphenyl)iodonium=hexafluorophosphate.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=-benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below. In the following specific examples, Ph represents a phenyl group, Me represents a methyl group, and Et represents an ethyl group.

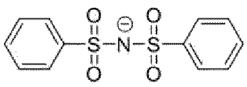

I-1

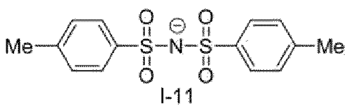

I-11

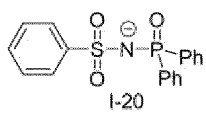

I-20

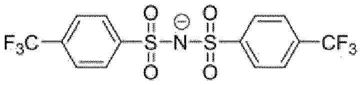
I-2

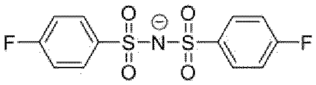
I-3

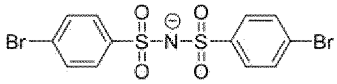
I-4

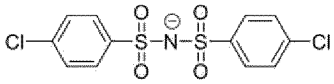
I-5

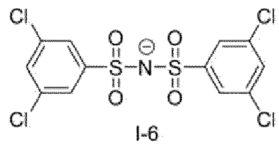
I-6

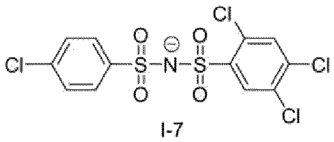
I-7

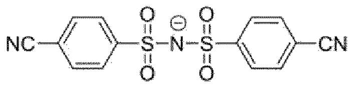
I-8

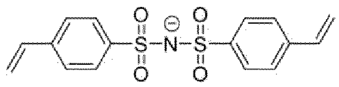
I-9

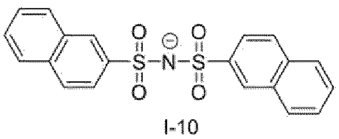
I-10

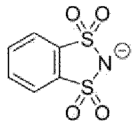
I-12

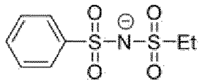
I-13

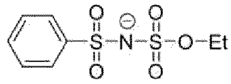
I-14

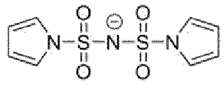
I-15

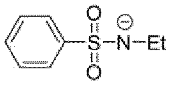
I-16

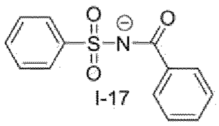
I-17

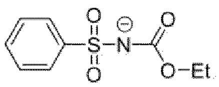
I-18

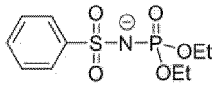
I-19

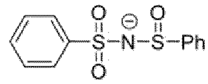
I-21

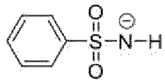
I-22

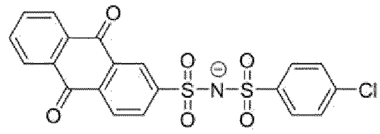
I-23

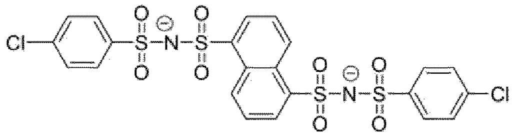
I-24

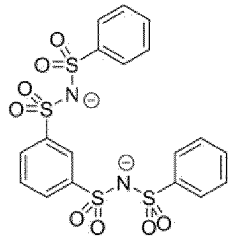
I-25

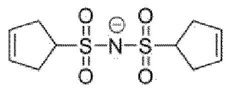
I-26

From the viewpoint of developability and UV printing durability of the lithographic printing plate to be obtained, the electron-accepting polymerization initiator may include a compound represented by Formula (II).

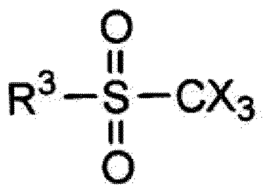
(II)

In Formula (II), X represents a halogen atom, and $R^3$ represents an aryl group.

Specifically, examples of X in Formula (II) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^3$ in Formula (II)

is preferably an aryl group substituted with an amide group.

Specific examples of the electron-accepting polymerization initiator represented by Formula (II) include compounds represented by the following formulas..

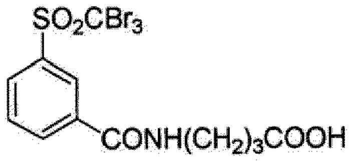
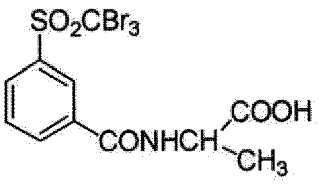
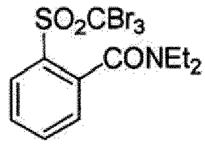

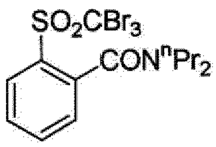
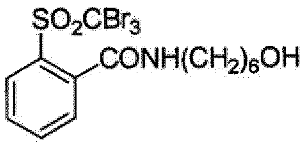
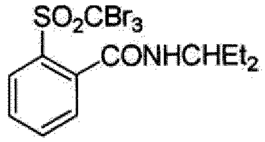

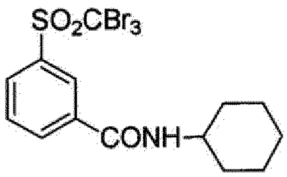
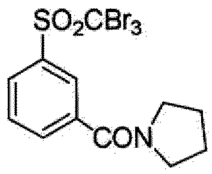
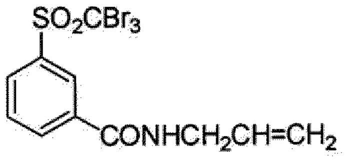

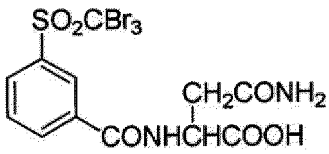
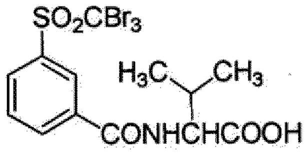
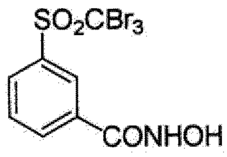

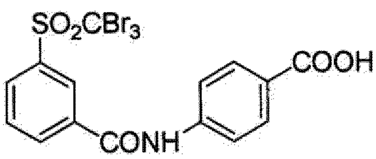
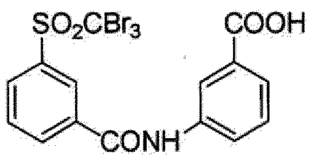
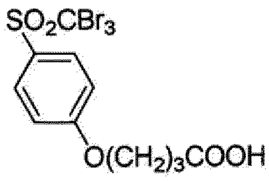

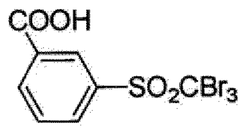
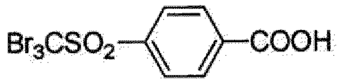
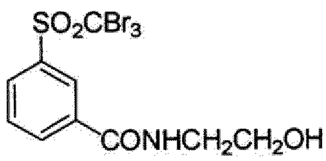

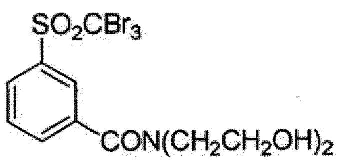
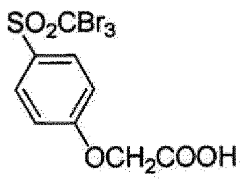
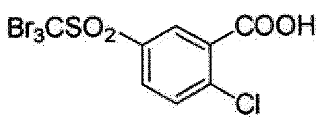

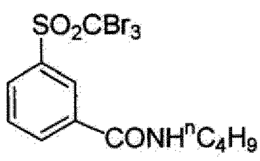
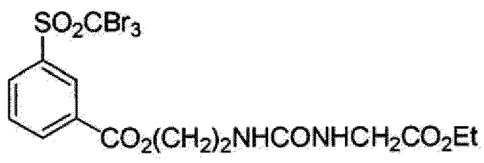

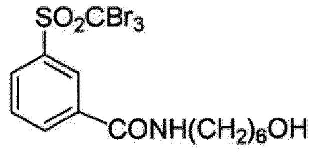
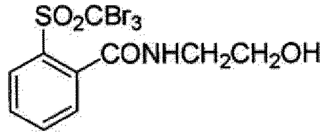

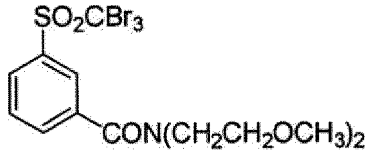
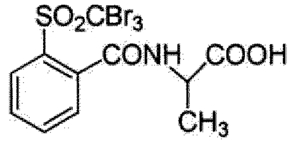

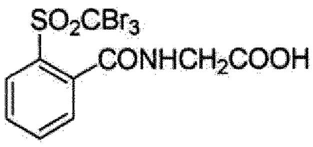
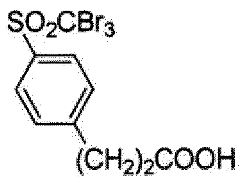
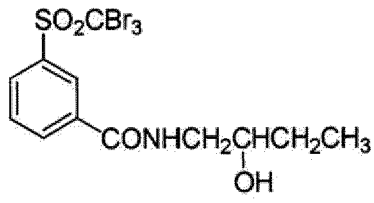

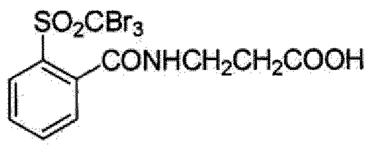
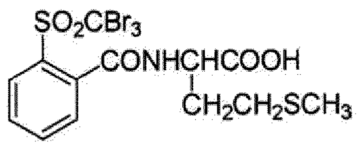

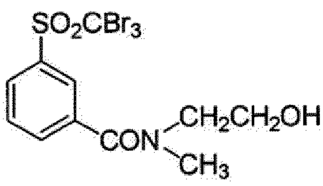
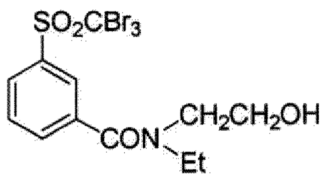
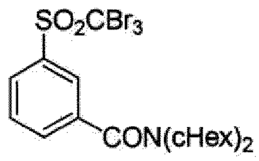

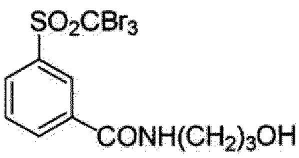
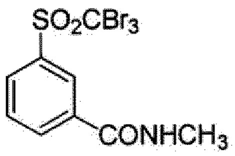
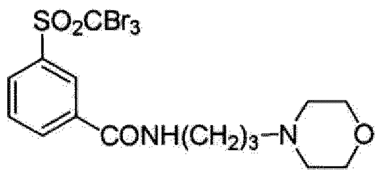

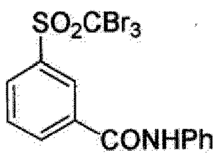
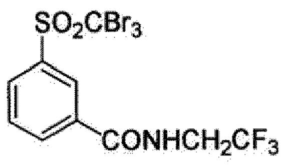
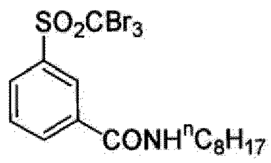

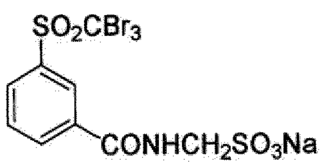
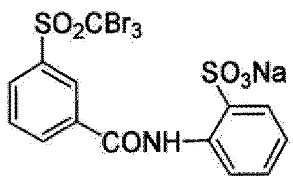
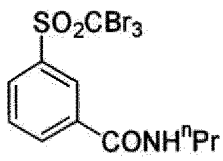

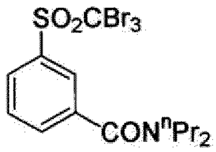
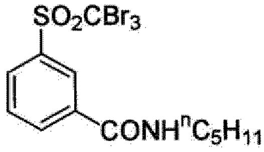
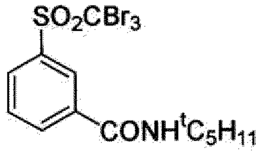

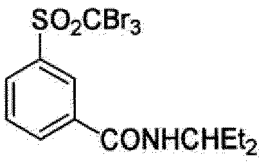
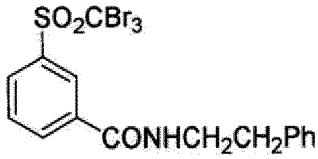
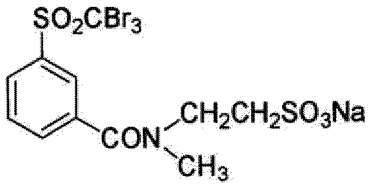

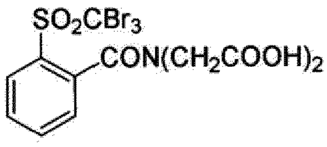
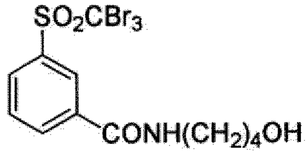

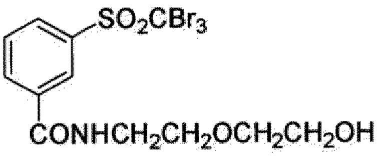
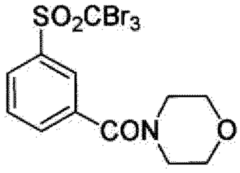
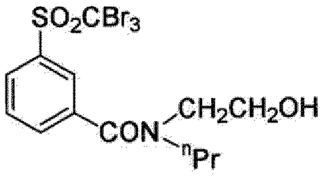

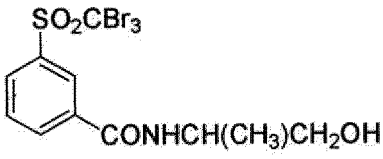
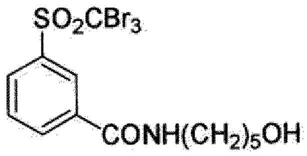

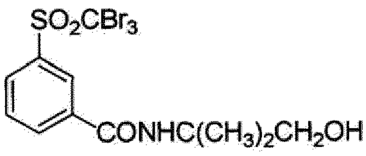
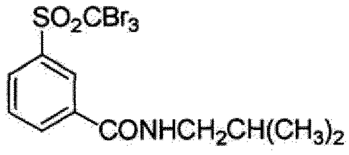

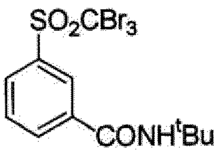
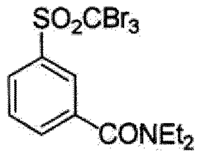
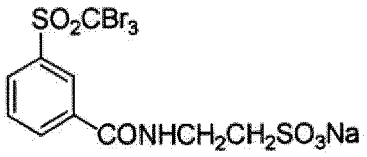

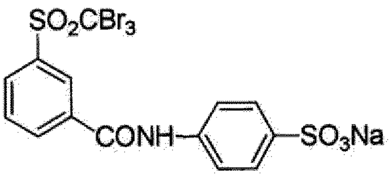
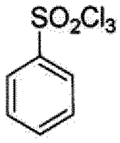
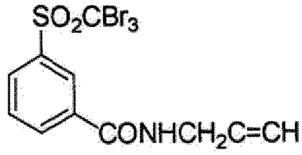

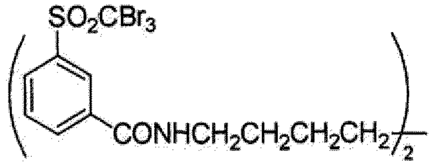

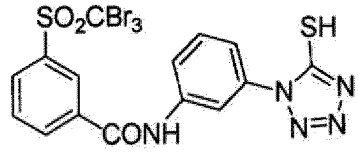

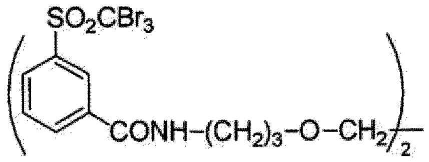

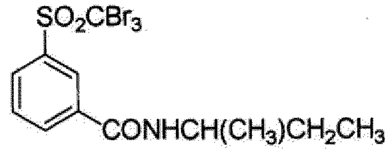

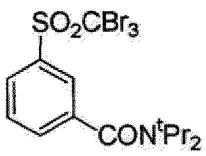

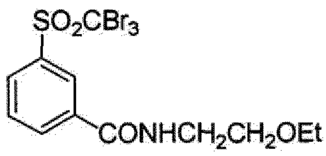

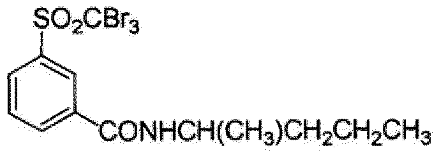

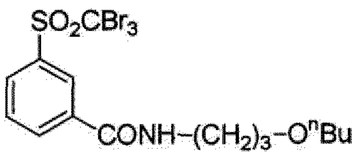

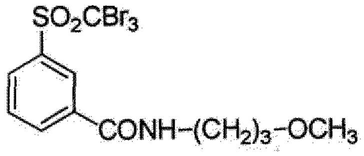

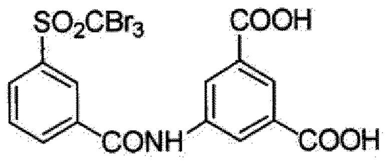

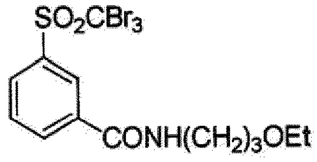

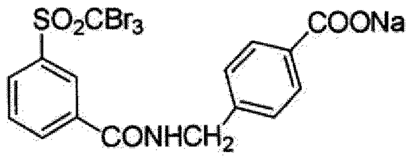

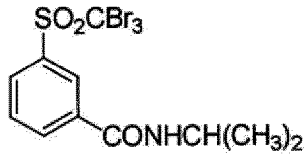

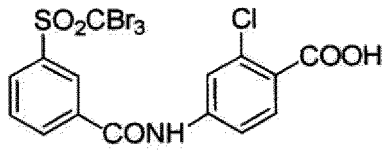

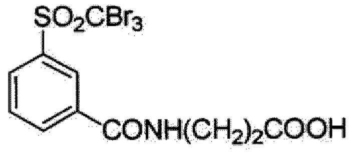

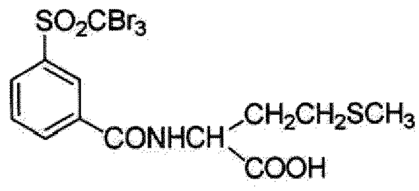

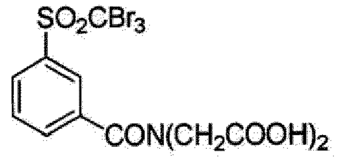

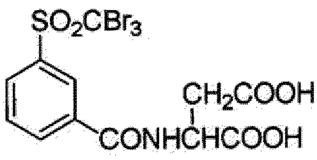
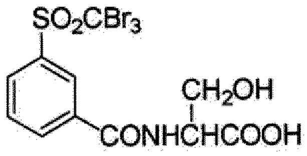
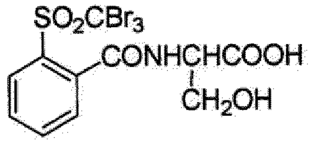

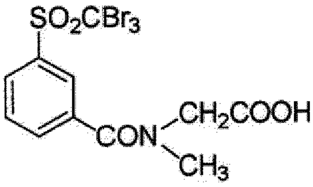
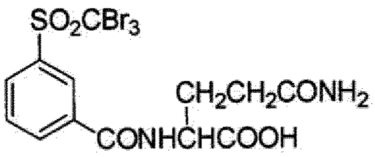
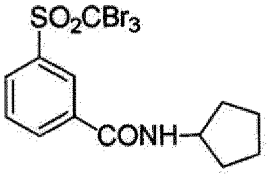

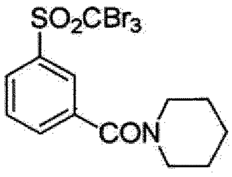
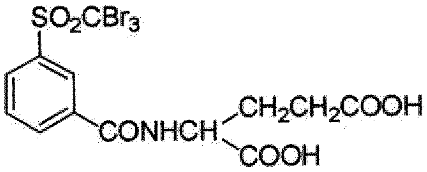

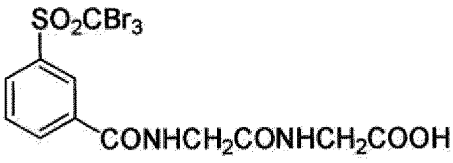
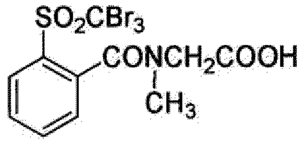

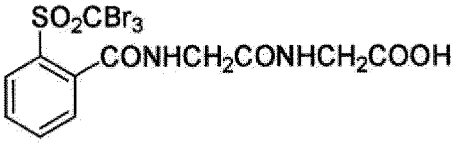
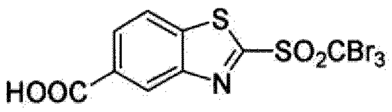

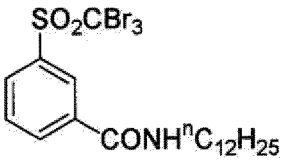
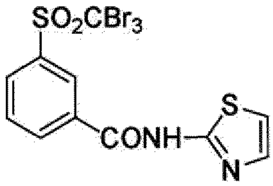
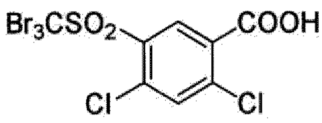

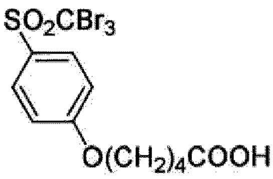
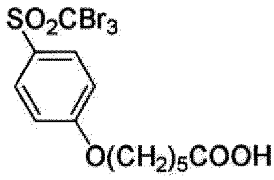

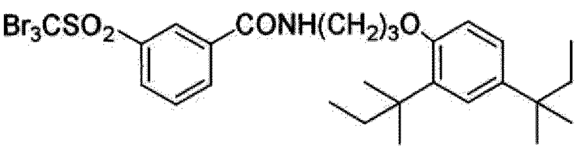
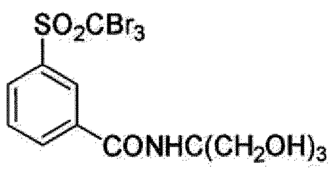

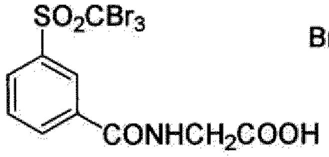

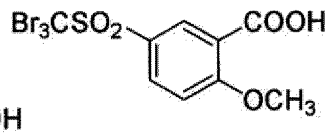

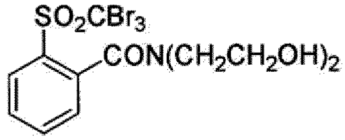

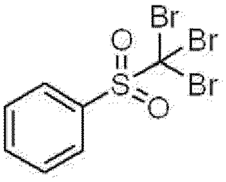

(IS-1)

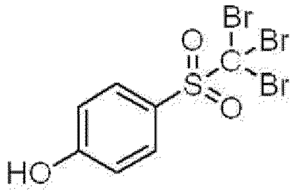

(IS-2)

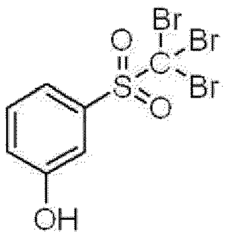

(IS-3)

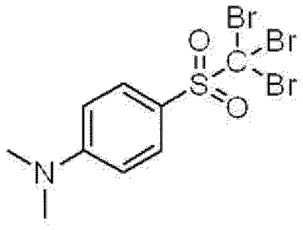

(IS-4)

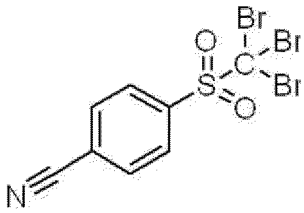

(IS-5)

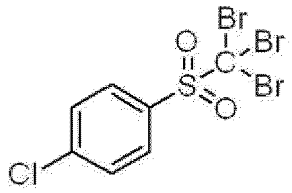

(IS-6)

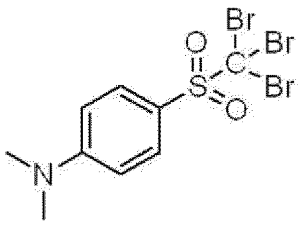

(IS-7)

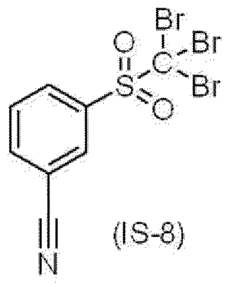

(IS-8)

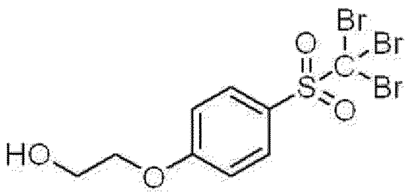

(IS-9)

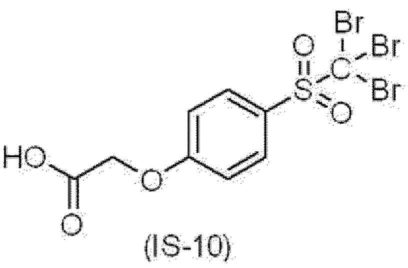

(IS-10)

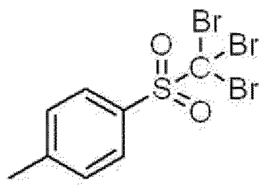

(IS-11)

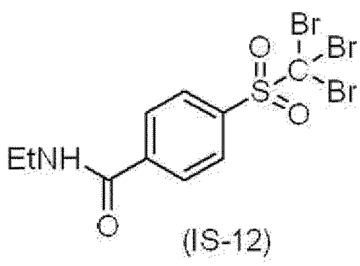

(IS-12)

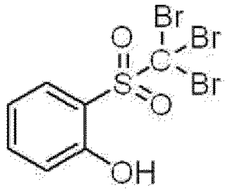

(IS-13)

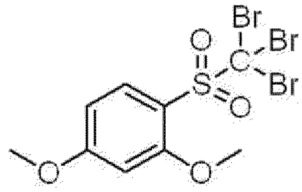

(IS-14)

From the viewpoint of improving sensitivity and suppressing the occurrence of plate missing, the lowest unoccupied molecular orbital (LUMO) of the electron-accepting polymerization initiator is preferably -3.00 eV or less, and more preferably -3.02 eV or less.

The lower limit of LUMO is preferably -3.80 eV or more, and more preferably -3.60 eV or more.

The molecular orbital (MO) energy of the highest occupied molecular orbital (HOMO) and the lowest unoccupied molecular orbital (LUMO) is calculated by the following methods.

First, free counterions in the compound as a calculation object are excluded from the calculation object. For example, for a cationic electron-accepting polymerization initiator and a cationic infrared absorber, counteranions are excluded from the calculation object, and for an anionic electron-donating polymerization initiator, countercations are excluded from the calculation object. "Free" mentioned herein means that the compound as an object and the counterions thereof are not covalently linked to each other.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO.

$$\text{Escaled} = 0.823168 \times 27.2114 \times \text{Ebare} - 1.07634$$

27.2114 is a simply a coefficient for converting hartree into eV, and 0.823168 and -1.07634 are adjustment coefficients. These are determined such that the calculated values of HOMO and LUMO of the compound as a calculation object match the measured values.

One kind of electron-accepting polymerization initiator may be used alone, or two or more kinds of electron-accepting polymerization initiators may be used in combination.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

-Relationship between electron-accepting polymerization initiator and infrared absorber-

From the viewpoint of improving sensitivity and suppressing UV plate missing, the image-recording layer contains the electron-accepting polymerization initiator and the infrared absorber described above. LUMO of the infrared absorber - LUMO of the electron-accepting polymerization initiator is preferably 1.00 eV or less, more preferably 0.70 eV or less, and particularly preferably 0.70 eV to -0.10 eV.

The negative sign means that LUMO of the electron-accepting polymerization initiator is higher than LUMO of the infrared absorber.

<<Electron-donating polymerization initiator (polymerization aid)>>

The image-recording layer preferably contains, as a polymerization initiator, an electron-donating polymerization initiator (also called "polymerization aid"), and more preferably contains an electron-accepting polymerization initiator and an electron-donating polymerization initiator.

The electron-donating polymerization initiator is a compound which donates one electron by intermolecular electron transfer to an orbit of an infrared absorber that has lost one electron in a case where electrons of the infrared absorber are excited or perform intramolecular transfer by exposure to infrared, and thus generates polymerization initiation species such as radicals.

The electron-donating polymerization initiator is preferably an electron-donating radical polymerization initiator.

From the viewpoint of improving the printing durability of the lithographic printing plate, the image-recording layer more preferably contains the electron-donating polymerization initiator that will be described below. Examples thereof include the following 5 initiators.

(i) Alkyl or arylate complex: considered to generate active radicals by oxidative cleavage of carbon-hetero bond. Specifically, a borate compound is preferable.

(ii) N-arylalkylamine compound: considered to generate active radicals by oxidation-induced cleavage of C-X bond on carbon adjacent to nitrogen X is preferably a hydrogen atom, a carboxyl group, a trimethylsilyl group, or a benzyl group. Specifically, examples thereof include N-phenylglycines (which may or may not have a substituent on a phenyl group) and N-phenyl iminodiacetic acids (which may or may not have a substituent on a phenyl group).

(iii) Sulfur-containing compound: compound obtained by substituting nitrogen atoms of the aforementioned amines with sulfur atoms and capable of generating active radicals by the same action as that of the amines. Specific examples thereof include phenylthioacetic acids (which may or may not have a substituent on a phenyl group).
(iv) Tin-containing compound: compound obtained by substituting nitrogen atoms of the aforementioned amines with tin atoms and capable of generating active radicals by the same action as that of the amines.
(v) Sulfinates: capable of generating active radicals by oxidation. Specifically, examples thereof include sodium aryl sulfinate.

From the viewpoint of printing durability, the image-recording layer preferably contains a borate compound among the above.
From the viewpoint of printing durability and color developability, the borate compound is preferably a tetraaryl borate compound or a monoalkyl triaryl borate compound, and more preferably a tetraaryl borate compound.
A countercation that the borate compound has is not particularly limited, but is preferably an alkali metal ion or a tetraalkyl ammonium ion and more preferably a sodium ion, a potassium ion, or a tetrabutylammonium ion.
Specifically, preferable examples of the borate compound include sodium tetraphenyl borate.
Specifically, as the electron-donating polymerization initiator, for example, the following B-1 to B-9 are preferable. In the following chemical formulas, Ph represents a phenyl group, and Bu represents a n-butyl group.

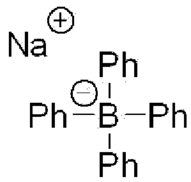
B - 1

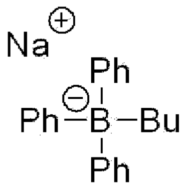
B - 2

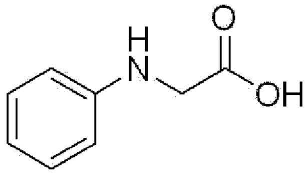
B - 3

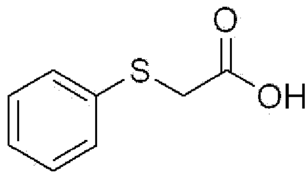
B - 4

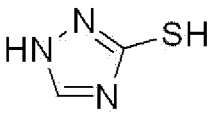
B - 5

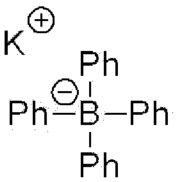
B - 6

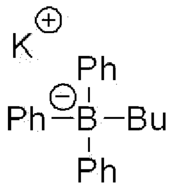
B - 7

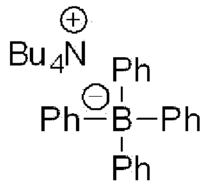
B - 8

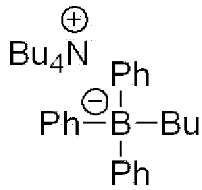
B - 9

From the viewpoint of improving sensitivity and suppressing the occurrence of plate missing, the highest occupied molecular orbital (HOMO) of the electron-donating polymerization initiator is preferably -6.00 eV or more, more preferably -5.95 eV or more, and even more preferably -5.93 eV or more.
The upper limit of HOMO is preferably -5.00 eV or less, and more preferably -5.40 eV or less.
Only one kind of electron-donating polymerization initiator may be added to the image-recording layer, or two or more kinds of electron-donating polymerization initiators may be used in combination.
From the viewpoint of sensitivity and printing durability, the content of the electron-donating polymerization initiator with respect to the total mass of the image-recording layer is preferably 0.01% by mass to 30% by mass, more preferably 0.05% by mass to 25% by mass, and even more preferably 0.1% by mass to 20% by mass.
In a case where the image-recording layer contains an onium ion and an anion of the aforementioned electron-donating polymerization initiator, the image-recording layer is regarded as containing an electron-accepting polymerization initiator and the electron-donating polymerization initiator described above.

-Relationship between electron-donating polymerization initiator and infrared absorber-

From the viewpoint of improving sensitivity and suppressing UV plate missing, the image-recording layer contains the electron-donating polymerization initiator and the infrared absorber described above. HOMO of the infrared absorber - HOMO of the electron-donating polymerization initiator is preferably 0.70 eV or less, and more preferably 0.70 eV to -0.10 eV.
The negative sign means that HOMO of the electron-donating polymerization initiator is higher than HOMO of the infrared absorber.

-Preferred aspects of infrared absorber and electron-accepting polymerization initiator-

From the viewpoint of improving sensitivity and suppressing the occurrence of plate missing, in a preferred aspect, the infrared absorber has an organic anion that satisfies $\delta d \geq 16$, $\delta p = 16$ to 32, and $\delta h \leq \delta p \times 0.6$ in the Hansen solubility parameters.

From the viewpoint of improving sensitivity and suppressing the occurrence of plate missing, in a preferred aspect, the electron-accepting polymerization initiator has an organic anion that satisfies $\delta d \geq 16$, $\delta p = 16$ to 32, and $\delta h \leq \delta p \times 0.6$ in the Hansen solubility parameters.

As δd, δp, and δh in the Hansen solubility parameters, the dispersion element δd [unit: $MPa^{0.5}$], the polarity element δp [unit: $MPa^{0.5}$], and the hydrogen bond element δh [unit: $MPa^{0.5}$] in the Hansen solubility parameters are used. The Hansen solubility parameters are obtained by dividing the solubility parameters introduced by Hildebrand into three components, a dispersion element δd, a polarity element δp, and a hydrogen bond element δh, and expressing the parameters in a three-dimensional space.

Details of the Hansen solubility parameters are described in the document "Hansen Solubility Parameters; A Users Handbook (CRC Press, 2007)" written by Charles M. Hansen.

δd, δp, and δh of the organic anion in the Hansen solubility parameters are values estimated from the chemical structure by using the computer software "Hansen Solubility Parameters in Practice (HSPiP ver. 4.1.07)".

Specifically, suitable examples of the organic anions that satisfy $\delta d \geq 16$, $\delta p = 16$ to 32, $\delta h \leq \delta p \times 0.6$ in the Hansen solubility parameters include the following anions.

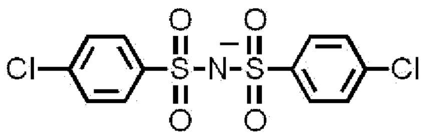

An - 1

-Polymerizable compound-

The image-recording layer contains a polymerizable compound.

The polymerizable compound used in the present invention may be, for example, a radically polymerizable compound or a cationically polymerizable compound. As the polymerizable compound, an addition polymerizable compound having at least one ethylenically unsaturated bond (ethylenically unsaturated compound) is preferable. The ethylenically unsaturated compound is preferably a compound having at least one ethylenically unsaturated bond on a terminal, and more preferably a compound having two or more ethylenically unsaturated bonds on a terminal. The chemical form of the polymerizable compound is, for example, a monomer, a prepolymer which is in other words a dimer, a trimer, or an oligomer, a mixture of these, or the like.

Examples of the monomer include unsaturated carboxylic acids (for example, acrylic acid, methacrylic acid, itaconic acid, crotonic acid, isocrotonic acid, maleic acid, and the like), and esters and amides thereof. Among these, esters of unsaturated carboxylic acids and polyhydric alcohol compounds and amides of unsaturated carboxylic acids and polyvalent amine compounds are preferably used. In addition, products of an addition reaction between unsaturated carboxylic acid esters or amides having a nucleophilic substituent such as a hydroxyl group, an amino group, or a mercapto group and monofunctional or polyfunctional isocyanates or epoxies, products of a dehydrocondensation reaction between the aforementioned unsaturated carboxylic acid esters or amides and a monofunctional or polyfunctional carboxylic acid, and the like are also suitably used. Furthermore, products of an addition reaction between unsaturated carboxylic acid esters or amides having an electrophilic substituent such as an isocyanate groups or an epoxy group and monofunctional or polyfunctional alcohols, amines, or thiols, and products of a substitution reaction between unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, a vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-064130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxyl group are also suitable, and specific examples thereof include vinyl urethane compounds having two or more polymerizable vinyl groups in one molecule obtained by adding vinyl monomers having a hydroxyl group represented by Formula (M) to a polyisocyanate compound having two or more isocyanate groups in one molecule which is described in, for example, JP1973-41708B (JP-S48-41708B).

$$CH_2=C(R^{M4})COOCH_2CH(R^{M5})OH \qquad (M)$$

In Formula (M), $R^{M4}$ and $R^{M5}$ each independently represent a hydrogen atom or a methyl group.

Furthermore, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

-Specific compound B 1-

From the viewpoint of improving printing durability, the polymerizable compound preferably includes a compound having an ethylenically unsaturated bond valence (also called "C=C valence") of 5.0 mmol/g or more (hereinafter, also called specific compound B1).

The ethylenically unsaturated bond valence of the specific compound B1 is preferably 5.5 mmol/g or more, and more preferably 6.0 mmol/g or more. The upper limit of the ethylenically unsaturated bond valence of the specific compound B1 is, for example, 10.0 mmol/g or less, and more preferably 8.5 mmol/g or less.

The ethylenically unsaturated bond valence of a compound is determined by the following method. First, for a predetermined amount (for example, 0.2 g) of sample compound, the structure of the compound is specified using, for example, pyrolysis GC/MS, FT-IR, NMR, TOF-SIMS, and the like, and the total amount (mmol) of ethylenically unsaturated groups is determined. The determined total amount (mmol) of ethylenically unsaturated groups is divided by the amount (g) of the sample compound, thereby calculating the ethylenically unsaturated bond valence of the compound.

The specific compound B1 is preferably a compound represented by Formula (I), because such a compound satisfies the C=C valence described above.

$$\text{Formula (I):} \qquad X\text{-}(Y)n$$

In Formula (I), X represents an n-valent organic group having a hydrogen bonding group, Y represents a monovalent group having 2 or more ethylenically unsaturated groups, n represents an integer of 2 or more, and molecular weight of X/(molecular weight of Y $\times$ n) is 1 or less.

The hydrogen bonding group represented by X in Formula (I) is not particularly limited as long as it is a group capable of forming a hydrogen bond. The hydrogen bonding group may be a hydrogen bond donating group or a hydrogen bond accepting group. Examples of the hydrogen bonding group include a hydroxyl group, a carboxy group, an amino group, a carbonyl group, a sulfonyl group, a urethane group, a urea group, an imide group, an amide group, a sulfonamide group, and the like. Particularly, from the viewpoint of on-press developability and printing durability, the hydrogen bonding group preferably includes at least one kind of group selected from the group consisting of a urethane group, a urea group, an imide group, an amide group, and a sulfonamide group, more preferably includes at least one kind of group selected from the group consisting of a urethane group, a urea group, an imide group, and an amide group, even more preferably includes at least one kind of group selected from the group consisting of a urethane group, a urea group, and an imide group, and particularly preferably includes at least one kind of group selected from the group consisting of a urethane group and a urea group.

X in Formula (I) is preferably an organic group that does not have an ethylenically unsaturated bond.

Furthermore, from the viewpoint of on-press developability and printing durability, X in Formula (I) is preferably a group obtained by combining two or more kinds of structures selected from the group consisting of a mono- to n-valent aliphatic hydrocarbon group, a mono- to n-valent aromatic hydrocarbon group, a urethane bond, a urea bond, a biuret bond, and an allophanate bond, and more preferably a group obtained by combining two or more kinds of structures

selected from the group consisting of a mono- to n-valent aliphatic hydrocarbon group, a mono- to n-valent aromatic hydrocarbon group, a urethane bond, a urea bond, and a biuret bond.

From the viewpoint of on-press developability and printing durability, X in Formula (I) is preferably a group obtained by removing a terminal isocyanate group from a substance prepared by multimerization of a polyfunctional isocyanate compound (including an adduct of a polyfunctional alcohol compound such as trimethylolpropane adduct), more preferably a group obtained by removing a terminal isocyanate group from a substance prepared by multimerization of a difunctional isocyanate compound (including an adduct of a polyfunctional alcohol compound), and particularly preferably a group obtained by removing a terminal isocyanate group from a substance prepared by multimerization of hexamethylene diisocyanate (including an adduct of a polyfunctional alcohol compound).

From the viewpoint of on-press developability and printing durability, the molecular weight of X in Formula (I) is preferably 100 to 1,000, more preferably 150 to 800, and particularly preferably 150 to 500.

The ethylenically unsaturated group represented by Y in Formula (I) is not particularly limited. From the viewpoint of reactivity, on-press developability, and printing durability, the ethylenically unsaturated group is preferably at least one kind of group selected from the group consisting of a vinyl phenyl group, a vinyl ester group, a vinyl ether group, an allyl group, a (meth)acryloxy group, and a (meth)acrylamide group. From the same viewpoint as above, the ethylenically unsaturated group represented by Y in Formula (I) is more preferably at least one kind of group selected from the group consisting of a vinyl phenyl group, a (meth)acryloxy group, and a (meth)acrylamide group, and even more preferably a (meth)acryloxy group. That is, from the viewpoint of on-press developability and printing durability, the ethylenically unsaturated group represented by Y in Formula (I) preferably includes a (meth)acryloxy group.

Y in Formula (I) is preferably a group having 3 or more (meth)acryloxy groups, more preferably a group having 5 or more (meth)acryloxy groups, and even more preferably a group having 5 or more and 12 or less (meth)acryloxy groups.

From the viewpoint of on-press developability and printing durability, Y in Formula (I) may have a structure represented by Formula (Y-1) or Formula (Y-2).

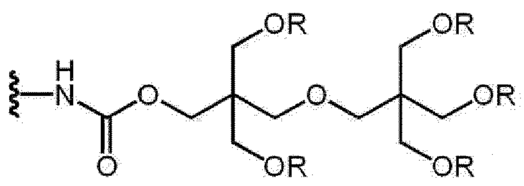

(Y-1)

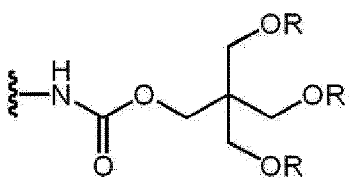

(Y-2)

In Formula (Y-1) and Formula (Y-2), R each independently represents an acryloyl group or a methacryloyl group, and the portion of the wavy line represents a position binding to other structures.

It is preferable that all Rs in Formula (Y-1) or Formula (Y-2) be the same group. Furthermore, it is preferable that all Rs in Formula (Y-1) or Formula (Y-2) be an acryloyl group.

It is preferable that all the n pieces of Y in Formula (I) be the same group.

From the viewpoint of on-press developability and printing durability, the molecular weight of Y in Formula (I) is preferably 200 or more and 1,000 or less, and more preferably 250 or more and 800 or less.

n in Formula (I) is an integer of 2 or more. From the viewpoint of on-press developability and printing durability, n is more preferably 2 or 3.

Molecular weight of X/(molecular weight of Y $\times$ n) is 1 or less. From the viewpoint of on-press developability and printing durability, the value of the expression is preferably 0.01 to 0.8, and more preferably 0.1 to 0.5.

As the structure of the specific compound B1, for example, a structure is preferable which is established by sealing a terminal isocyanate group of a multimerized substance (including an adduct) of a polyfunctional isocyanate compound with a compound having an ethylenically unsaturated group as described above. As the multimerized substance of the polyfunctional isocyanate compound, particularly, a multimerized substance of a difunctional isocyanate compound is preferable.

From the viewpoint of on-press developability and printing durability, the specific compound B1 is preferably a compound obtained by reacting a terminal isocyanate group of a multimerized substance prepared by multimerizing a polyfunctional isocyanate compound with a polyfunctional ethylenically unsaturated compound having a hydroxyl group (also called hydroxy group) on a terminal. Furthermore, from the same viewpoint as above, the specific compound B1 is more preferably a compound obtained by reacting a terminal isocyanate group of a multimerized substance prepared by multimerizing a difunctional isocyanate compound (including an adduct of a polyfunctional alcohol compound) with a polyfunctional ethylenically unsaturated compound having a hydroxyl group. Furthermore, from the same viewpoint as above, the specific compound B1 is particularly preferably a compound obtained by reacting a terminal isocyanate group of a multimerized substance prepared by multimerizing hexamethylene diisocyanate (including an adduct of a polyfunctional

alcohol compound) with a polyfunctional ethylenically unsaturated compound having a hydroxyl group.

As the polyfunctional isocyanate compound, known compounds can be used without particular limitation. This compound may be an aliphatic polyfunctional isocyanate compound or an aromatic polyfunctional isocyanate compound. As the polyfunctional isocyanate compound, specifically, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

In addition, the polyfunctional ethylenically unsaturated compound having a hydroxyl group is preferably a hydroxyl group-containing ethylenically unsaturated compound having 3 or more functional groups, and more preferably a hydroxyl group-containing ethylenically unsaturated compound having 5 or more functional groups. The aforementioned hydroxyl group-containing polyfunctional ethylenically unsaturated compound is preferably a polyfunctional (meth) acrylate compound having a hydroxyl group.

From the viewpoint of on-press developability and printing durability, the specific compound B1 preferably has at least one kind of structure selected from the group consisting of an adduct structure, a biuret structure, and an isocyanurate structure. From the same viewpoint as above, the specific compound B1 more preferably has at least one kind of structure selected from the group consisting of a trimethylolpropane adduct structure, a biuret structure, and an isocyanurate structure, and particularly preferably has a trimethylolpropane adduct structure.

From the viewpoint of on-press developability and printing durability, the specific compound B1 preferably has a structure represented by any of Formula (A-1) to Formula (A-3), and more preferably has a structure represented by Formula (A-1).

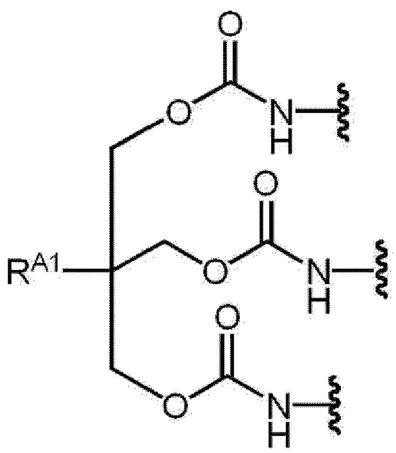

(A-1)

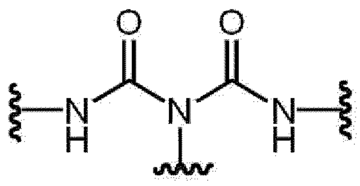

(A-2)

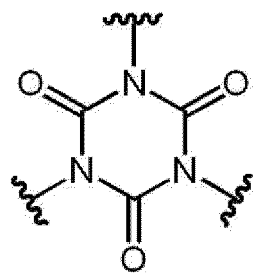

(A-3)

In Formula (A-1), $R^{A1}$ represents a hydrogen atom or an alkyl group having 1 to 8 carbon atoms, and the portion of the wavy line represents a position binding to other structures.

From the viewpoint of on-press developability and printing durability, $R^{A1}$ in Formula (A-1) is preferably a hydrogen atom or an alkyl group having 1 to 4 carbon atoms, more preferably an alkyl group having 1 to 3 carbon atoms, even more preferably a methyl group or an ethyl group, and particularly preferably an ethyl group.

From the viewpoint of on-press developability and printing durability, the specific compound B1 is preferably a (meth)acrylate compound having a urethane group, that is, a urethane (meth)acrylate oligomer.

As long as the specific compound B1 has an ethylenically unsaturated bond valence of 5.0 mmol/g or more, the specific compound B1 may be an oligomer having a polyester bond (hereinafter, also called polyester (meth)acrylate oligomer) or an oligomer having an epoxy residue (hereinafter, also called epoxy (meth)acrylate oligomer).

The epoxy residue in the epoxy (meth)acrylate oligomer is as described above.

The number of ethylenically unsaturated groups in the polyester (meth)acrylate oligomer as the specific compound B1 is preferably 3 or more, and more preferably 6 or more.

The epoxy (meth)acrylate oligomer as the specific compound B1 is preferably a compound containing a hydroxyl group. The number of ethylenically unsaturated groups in the epoxy (meth)acrylate oligomer is preferably 2 to 6, and more preferably 2 or 3. The epoxy (meth)acrylate oligomer can be obtained, for example, by reacting a compound having an epoxy group with an acrylic acid.

The molecular weight of the specific compound B1 (weight-average molecular weight in a case where the compound has molecular weight distribution) is preferably more than 1,000, more preferably 1,100 to 10,000, and even more preferably 1,100 to 5,000.

As the specific compound B1, a synthetic product or a commercially available product may be used.

Specific examples of the specific compound B1 include the following commercially available products. However, the specific compound B1 is not limited thereto. The number of functional groups (or the average number of functional groups) and C=C valence of the ethylenically unsaturated group are shown in each bracket.

Specific examples of the specific compound B1 include urethane (meth)acrylate oligomers such as U-10HA (number of functional groups: 10, C=C valence: 8 mmol/g) and U-15HA (number of functional groups: 15, C=C valence: 6 mmol/g) manufactured by SHIN-NAKAMURA CHEMICAL CO, LTD., UA-510H (number of functional groups: 10, C=C valence: 8 mmol/g) manufactured by KYOEISHA CHEMICAL Co., LTD., KRM8452 (number of functional groups: 10, C=C valence: 7 mmol/g) manufactured by DAICEL-ALLNEX LTD., and CN8885NS (number of functional groups: 9, C=C valence: 6 mmol/g) and CN9013NS (number of functional groups: 9, C=C valence: 6 mmol/g) manufactured by Sartomer Company Inc.

Specific examples of the specific compound B1 also include epoxy (meth)acrylate oligomers such as NK OLIGO EA-7420/PGMAc (number of functional groups: 10 to 15, C=C valence: 5 mmol/g) manufactured by SHIN-NAKAMURA CHEMICAL CO, LTD., and CN153 (C=C valence: 5 mmol/g) manufactured by Sartomer Company Inc.

Specific examples of the specific compound B1 also include polyester (meth)acrylate oligomers such as CN2267 (C=C valence: 5 mmol/g) manufactured by Sartomer Company Inc.

In a case where the specific compound B1 is used, the content of the specific compound B1 with respect to the total mass of the polymerizable compounds in the image-recording layer is preferably 10% by mass to 100% by mass, more preferably 50% by mass to 100% by mass, and even more preferably 80% by mass to 100% by mass.

-Specific compound B2-

The polymerizable compound may include, as a low-molecular-weight compound, a compound having 1 or 2 ethylenically unsaturated bonding groups (hereinafter, also called specific compound B2).

Preferred aspects of the ethylenically unsaturated group contained in the specific compound B2 are the same as preferred aspects of the ethylenically unsaturated group in the specific compound B1.

Furthermore, from the viewpoint of inhibiting the deterioration of on-press developability, the specific compound B2 is preferably a compound having 2 ethylenically unsaturated bonding groups (that is, a difunctional polymerizable compound).

From the viewpoint of on-press developability and printing durability, the specific compound B2 is preferably a methacrylate compound, that is, a compound having a methacryloxy group.

From the viewpoint of on-press developability, the specific compound B2 preferably has an alkyleneoxy structure or a urethane bond.

The molecular weight of the specific compound B2 (weight-average molecular weight in a case where the compound has molecular weight distribution) is preferably 50 or more and less than 1,000, more preferably 200 to 900, and even more preferably 250 to 800.

Specific examples of the specific compound B2 will be shown below. However, the specific compound B2 is not limited thereto. In the following compound (2), for example, n + m = 10.

(1)

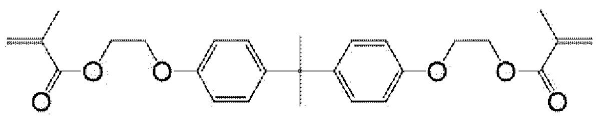

(2)

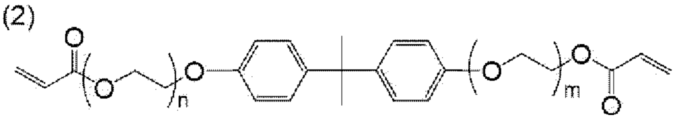

(3)

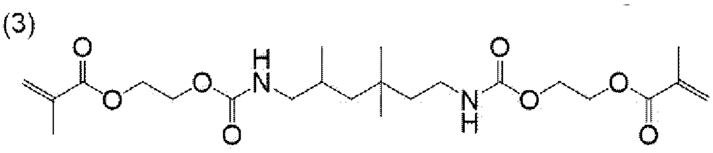

(4)

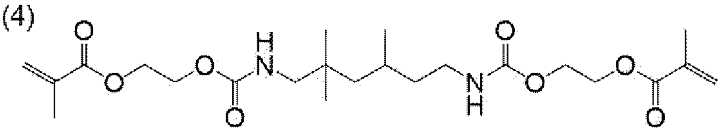

As the specific compound B2, the following commercially available products may be used. However, the specific compound B2 is not limited thereto.

Specific examples of the specific compound B2 include ethoxylated bisphenol A dimethacrylate such as BPE-80N (the above compound (1)), BPE-100, BPE-200, and BPE-500 manufactured by SHIN-NAKAMURA CHEMICAL CO, LTD., and CN104 (the above compound (1)) manufactured by Sartomer Company Inc.

Specific examples of the specific compound B2 include ethoxylated bisphenol A diacrylates such as A-BPE-10 (the above compound (2)) and A-BPE-4 manufactured by SHIN-NAKAMURA CHEMICAL CO, LTD.

Furthermore, specific examples of the specific compound B2 include difunctional methacrylate such as FST 510 manufactured by AZ Electronics.

"FST 510" described above is a product of a reaction between 1 mol of 2,2,4-trimethylhexamethylene diisocyanate and 2 mol of hydroxyethyl methacrylate, which is an 82% by mass methyl ethyl ketone solution of the compound (3).

From the viewpoint of on-press developability and printing durability, the content of the specific compound B2 with respect to the total mass of the image-recording layer is preferably 1% by mass to 60% by mass, more preferably 5% by mass to 55% by mass, and even more preferably 5% by mass to 50% by mass.

In a case where the specific compound B2 is used, the content of the specific compound B2 with respect to the total mass of the polymerizable compounds in the image-recording layer is preferably 10% by mass to 100% by mass, more preferably 50% by mass to 100% by mass, and even more preferably 80% by mass to 100% by mass.

The details of how to use the polymerizable compound, such as the structure of the compound, whether the compound is used alone or used in combination with other compounds, and the amount of the compound to be added, can be randomly set.

The content of the polymerizable compound with respect to the total mass of the image-recording layer is preferably 5% by mass to 75% by mass, more preferably 10% by mass to 70% by mass, and particularly preferably 15% by mass to 60% by mass.

-Compound satisfying $\delta p$ = 2.4 to 14 in Hansen solubility parameters-

From the viewpoint of receptivity and on-press developability, the image-recording layer in the present disclosure contains a compound satisfying $\delta p$ = 2.4 to 14 in the Hansen solubility parameters. As described above, the unit of the value of $\delta p$ of the compound satisfying $\delta p$ = 2.4 to 14 in the Hansen solubility parameters is $MPa^{0.5}$.

From the viewpoint of on-press developability and receptivity, the value of $\delta p$ of the compound satisfying $\delta p$ (polarity element) = 2.4 to 14 in the Hansen solubility parameters (SP value) is preferably 2.8 to 11.7, more preferably 2.9 to 11.5, and even more preferably 3.2 to 10.8.

In the present invention, the Hansen solubility parameters (unit: $Mpa^{0.5}$) of the compound satisfying $\delta p$ = 2.4 to 14 as described above are obtained by dividing the solubility parameters introduced by Hildebrand into three components, a dispersion element $\delta d$, a polarity element $\delta p$, and a hydrogen bond element $\delta h$, and expressing the parameters in a three-dimensional space. In the present invention, the polarity element $\delta p$ is used.

$\delta p$ [$MPa^{0.5}$] is the dipole-dipole force element in the Hansen solubility parameters, V is the molar volume, and $\mu$ is the dipole moment. As $\delta p$, the following equation simplified by Hansen and Beerbower is generally used.

$$\delta p = \frac{37.4\mu}{V^{1/2}}$$

The compound satisfying $\delta p$ = 2.4 to 14 in the Hansen solubility parameters is not particularly limited as long as

the value of δp is within the above range. This compound is preferably a hydrophilic polymer compound or a hydrophilic low-molecular-weight compound.

In the present specification, "hydrophilic" means that the value of δp is 2.4 to 14, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.

From the viewpoint of on-press developability and receptivity, the compound satisfying δp = 2.4 to 14 in the Hansen solubility parameters preferably has a molecular weight of 5,000 or less, more preferably has a molecular weight of 3,000 or less, even more preferably has a molecular weight of 1,000 or less, and particularly preferably has a molecular weight of 200 or more and 500 or less.

From the viewpoint of on-press developability and receptivity, it is preferable that the compound satisfying δp = 2.4 to 14 in the Hansen solubility parameters have a hydrophilic group.

From the viewpoint of on-press developability and receptivity, the hydrophilic group is preferably at least one kind of structure selected from the group consisting of a zwitterionic structure, a polyalkylene oxide structure, a sulfonic acid group (sulfo group), a sulfonate group, a carboxylic acid group (carboxy group), a carboxylate group, a phosphoric acid group, and a phosphate group, more preferably at least one kind of structure selected from the group consisting of a sulfonic acid group, a sulfonate group, a carboxylic acid group, a carboxylate group, a phosphoric acid group, and a phosphate group, and particularly preferably at least one kind of structure selected from the group consisting of a sulfonic acid group and a sulfonate group.

[Hydrophilic polymer compound]

Examples of the hydrophilic polymer compound include a cellulose compound and the like. Among these, a cellulose compound is preferable.

Examples of the cellulose compound include cellulose or a compound obtained by modifying at least a part of cellulose (modified cellulose compound). Among these, a modified cellulose compound is preferable.

Preferable examples of the modified cellulose compound include a compound which is obtained by substituting at least some of hydroxyl groups of cellulose with at least one kind of group selected from the group consisting of an alkyl group and a hydroxyalkyl group.

The degree of substitution of the compound, which is obtained by substituting at least some of hydroxyl groups of cellulose with at least one kind of group selected from the group consisting of an alkyl group and a hydroxyalkyl group, is preferably 0.1 to 6.0, and more preferably 1 to 4.

As the modified cellulose compound, an alkyl cellulose compound or a hydroxyalkyl cellulose compound is preferable, and a hydroxyalkyl cellulose compound is more preferable.

Preferable examples of the alkyl cellulose compound include methyl cellulose.

Preferable examples of the hydroxyalkyl cellulose compound include hydroxypropyl cellulose.

The molecular weight of the hydrophilic polymer compound (weight-average molecular weight in a case where the compound has molecular weight distribution) is preferably 3,000 to 5,000,000, and more preferably 5,000 to 200,000.

[Hydrophilic low-molecular-weight compound]

Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.

Examples of the glycol compound include glycols such as ethylene glycol, diethylene glycol, triethylene glycol, propylene glycol, dipropylene glycol, and tripropylene glycol, and ether or ester derivatives of these compounds.

Examples of the polyol compound include glycerin, pentaerythritol, tris(2-hydroxyethyl) isocyanurate, and the like.

Examples of the organic amine compound include triethanolamine, diethanolamine, monoethanolamine, salts of these, and the like.

Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.

Examples of the organic sulfuric acid compound include alkyl sulfuric acid, alkyl ether sulfuric acid, salts of these, and the like.

Examples of the organic phosphonic acid compound include phenylphosphonic acid, salts thereof, and the like.
Examples of the organic carboxylic acid compound include tartaric acid, oxalic acid, citric acid, malic acid, lactic acid, gluconic acid, salts of these, and the like.
Examples of the betaine compound include a phosphobetaine compound, a sulfobetaine compound, a carboxybetaine compound, and the like. Among these, for example, trimethylglycine is preferable.
The molecular weight of the hydrophilic low-molecular-weight compound (weight-average molecular weight in a case where the compound has molecular weight distribution) is preferably 100 or more and less than 3,000, and more preferably 300 to 2,500.

[Cyclic structure]

The compound satisfying $\delta p$ = 2.4 to 14 in the Hansen solubility parameters is preferably a compound having a cyclic structure.
The cyclic structure is not particularly limited. Examples thereof include a glucose ring in which at least some of hydroxyl groups are substituted, an isocyanuric ring, an aromatic ring which may have a heteroatom, an aliphatic ring which may have a heteroatom, and the like. Among these, for example, a glucose ring or an isocyanuric ring is preferable.
Examples of the compound having a glucose ring include the aforementioned cellulose compound.
Examples of the compound having an isocyanuric ring include the aforementioned tris(2-hydroxyethyl) isocyanurate and the like.
Examples of the compound having an aromatic ring include the toluene sulfonic acid and benzene sulfonic acid described above, and the like.
Examples of the compound having an aliphatic ring include a compound which is the aforementioned alkyl sulfate and has an alkyl group having a ring structure, and the like.
The compound having a cyclic structure preferably has a hydroxyl group.
Preferable examples of the compound having a hydroxyl group and a cyclic structure include the aforementioned cellulose compound and the aforementioned tris(2-hydroxyethyl) isocyanurate.

[Onium compound]

The compound satisfying $\delta p$ = 2.4 to 14 in the Hansen solubility parameters is preferably an onium compound.
Examples of the onium compound include an ammonium compound, a sulfonium compound, and the like. Among these, an ammonium compound is preferable.
Examples of the compound satisfying $\delta p$ = 2.4 to 14 in the Hansen solubility parameters, which is an onium compound, include trimethylglycine and the like.
Furthermore, the onium compound in the aforementioned electron-accepting polymerization initiator is a compound that does not satisfy $\delta p$ = 2.4 to 14, and is not included in the compound satisfying $\delta p$ = 2.4 to 14 in the Hansen solubility parameters.
The image-recording layer may contain only one kind of compound satisfying $\delta p$ = 2.4 to 14 in the Hansen solubility parameters, or two or more kinds of such compounds may be used in combination.
From the viewpoint of on-press developability and receptivity, the content of the compound satisfying $\delta p$ = 2.4 to 14 in the Hansen solubility parameters with respect to the total mass of the image-recording layer is preferably 0.1% by mass or more and 20% by mass or less, more preferably 0.5% by mass or more and 15% by mass or less, and even more preferably 1% by mass or more and 10% by mass or less.

-Color developing agent-

The image-recording layer preferably contains a color developing agent, and more preferably contains an acid color-developing agent.
"Color developing agent" means a compound that develops or removes color by a stimulus such as light or acid and thus changes the color of the image-recording layer. Furthermore, "acid color-developing agent" means a compound that develops or removes color by being heated in a state of accepting an electron accepting compound (for example, a proton of an acid or the like) and thus changes the color of the image-recording layer. The acid color-developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.
Examples of such an acid color-developing agent include phthalides such as 3,3-bis(4-dimethylaminophenyl)-6-dimethylaminophthalide (called "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl) phthalide, 3-(4-dimethylaminophenyl)-3-(2-methylindole-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, 3-(4-dimethylaminophenyl)-3-(1-methylpyrrol-3-yl)-6-dimethylaminophthalide,

3,3-bis[1,1-bis(4-dimethylaminophenyl)ethylen-2-yl]-4,5,6,7-tetrachlorophthalide, 3,3-bis[1,1-bis(4-pyrrolidinophenyl)ethylen-2-yl]-4,5,6,7-tetrabromophthalide, 3,3-bis[1-(4-dimethylaminophenyl)-1-(4-methoxyphenyl)ethylen-2-yl]-4,5,6,7-tetrachlorophth alide, 3,3-bis[1-(4-pyrrolidinophenyl)-1-(4-methoxyphenyl)ethylen-2-yl]-4,5,6,7-tetrachlorophthalid e, 3-[1,1-di(1-ethyl-2-methylindol-3-yl)ethylen-2-yl]-3-(4-diethylaminophenyl)phthalide, 3-[1,1-di(1-ethyl-2-methylindol-3-yl)ethylen-2-yl]-3-(4-N-ethyl-N-phenylaminophenyl)phthali de, 3-(2-ethoxy-4-diethylaminophenyl)-3-(1-n-octyl-2-methylindol-3-yl)phthalide, 3,3-bis(1-n-octyl-2-methylindol-3-yl)phthalide, and 3-(2-methyl-4-diethylaminophenyl)-3-(1-n-octyl-2-methylindol-3-yl)phthalide,

4,4-bis-dimethylaminobenzhydrinbenzyl ether, N-halophenyl-leucoauramine, N-2,4,5-trichlorophenylleucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'-chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-methylamino-6-methyl-7-anilinofluoran, 3-N-(3'-ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino)fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'-(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n)-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4 or 7-azaphthalide, 3-(2-ethoxy-4-diethylaminophenyl)-3-(1-ethyl-2-methylindol-3-yl)-4 or 7-azaphthalide, 3-(2-hexyloxy-4-diethylaminophenyl)-3-(1-ethyl-2-methylindol-3-yl)-4 or 7-azaphthalide, 3-(2-ethoxy-4-diethylaminophenyl)-3-(1-ethyl-2-phenylindol-3-yl)-4 or 7-azaphthalide, 3-(2-butoxy-4-diethylaminophenyl)-3-(1-ethyl-2-phenylindol-3-yl)-4 or 7-azaphthalide 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino)fluorene-9-spiro-3'-(6'-dimethylamino)p hthalide, and 3,6-bis(diethylamino)fluorene-9-spiro-3'-(6'-dimethylamino) phthalide,

2'-anilino-6'-(N-ethyl-N-isopentyl)amino-3'-methylspiro[isobenzofuran-1(3H),9'-(9H)xanthe n-3-one, 2'-anilino-6'-(N-ethyl-N-(4-methylphenyl))amino-3'-methylspiro[isobenzofuran-1(3H),9'-(9H )xanthen]-3-one, 3'-N,N-dibenzylamino-6'-N,N-diethylaminospiro[isobenzofuran-1(3H),9'-(9H)xanthen]-3-on e, 2'-(N-methyl-N-phenyl)amino-6'-(N-ethyl-N-(4-methylphenyl))aminospiro[isobenzofuran-1( 3H),9'-(9H)xanthen]-3-one, and the like.

Particularly, from the viewpoint of color developability, the color developing agent is preferably at least one kind of compound selected from the group consisting of a spiropyran compound, a spirooxazine compound, a spirolactone compound, and a spirolactam compound.

From the viewpoint of visibility, the hue of the colorant after color development is preferably green, blue, or black.

Furthermore, from the viewpoint of color developability and visibility of exposed portions, the acid color-developing agent is preferably a leuco colorant.

The leuco colorant is not particularly limited as long as it has a leuco structure. The leuco colorant preferably has a spiro structure, and more preferably has a spirolactone ring structure.

From the viewpoint of color developability and visibility of exposed portions, the leuco colorant preferably has a phthalide structure or a fluoran structure.

Furthermore, from the viewpoint of color developability and visibility of exposed portions, the leuco colorant having the phthalide structure or the fluoran structure is preferably a compound represented by any of Formula (Le-1) to Formula (Le-3), and more preferably a compound represented by Formula (Le-2).

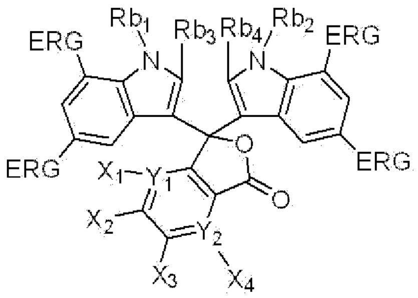

( Le - 1 )

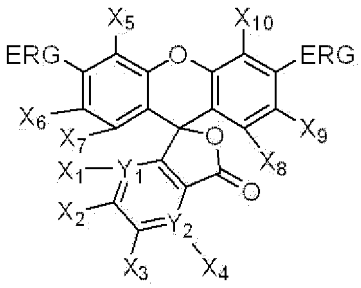

( Le - 2 )

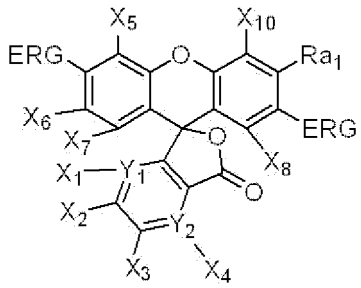

( Le - 3 )

In Formula (Le-1) to Formula (Le-3), ERG each independently represents an electron donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

As the electron donating group represented by ERG in Formula (Le-1) to Formula (Le-3), from the viewpoint of color developability and visibility of the exposed portion, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, or an cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a

methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

From the viewpoint of color developability and visibility of exposed portions, the leuco colorant having the phthalide structure or the fluoran structure is more preferably a compound represented by any of Formula (Le-4) to Formula (Le-6), and even more preferably a compound represented by Formula (Le-5).

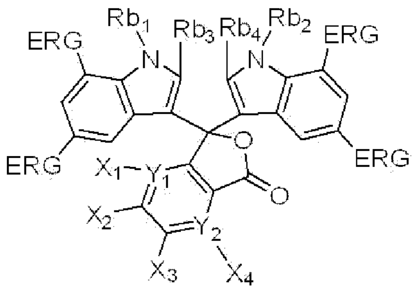
( Le - 4 )

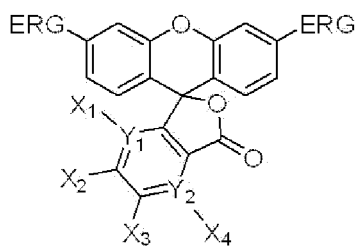
( Le - 5 )

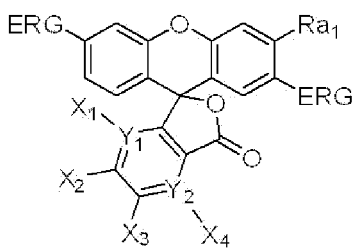
( Le - 6 )

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

From the viewpoint of color developability and visibility of exposed portions, the leuco colorant having the phthalide structure or the fluoran structure is more preferably a compound represented by any of Formula (Le-7) to Formula (Le-9), and particularly preferably a compound represented by Formula (Le-8).

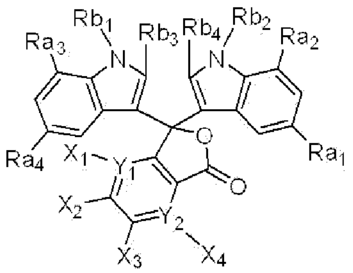
( Le - 7 )

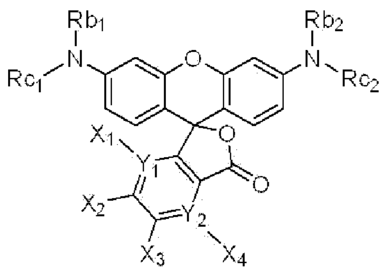
( Le - 8 )

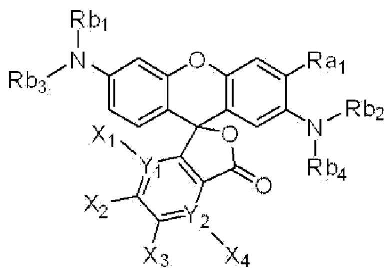
( Le - 9 )

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) to Formula (Le-9) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent a hydrogen atom, an alkyl group, or an aryl group substituted with an alkoxy group, more preferably each independently represent an alkyl group, and particularly preferably each independently represent a methyl group.

From the viewpoint of color developability and visibility of exposed portions, $Rc_1$ and $Rc_2$ in Formula (Le-8) preferably each independently represent a phenyl group or an alkylphenyl group, and more preferably each independently represent a phenyl group.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, a cyano group, and the like. These substituents may be further substituted with these substituents.

Examples of the leuco colorant having the phthalide structure or the fluoran structure that are suitably used include the following compounds. Me represents a methyl group.

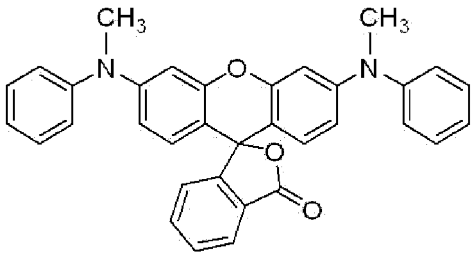

S - 1

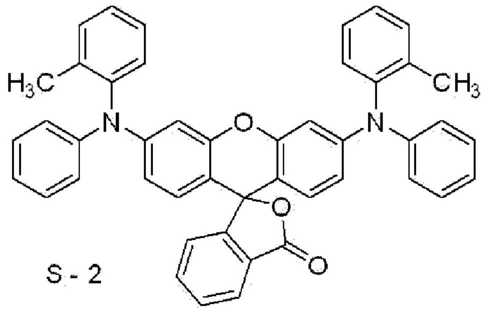

S - 2

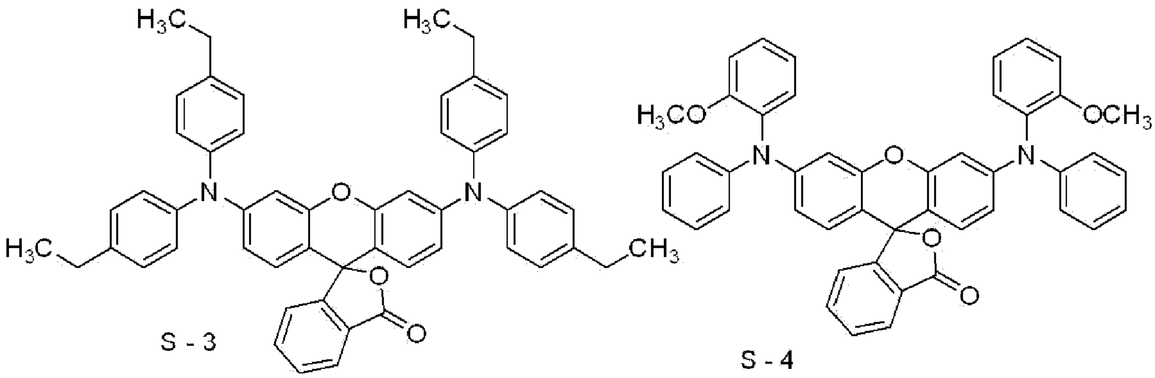

S - 3

S - 4

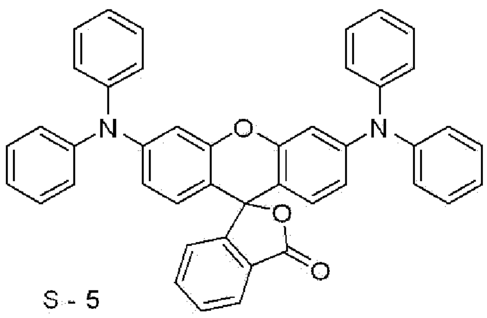

S - 5

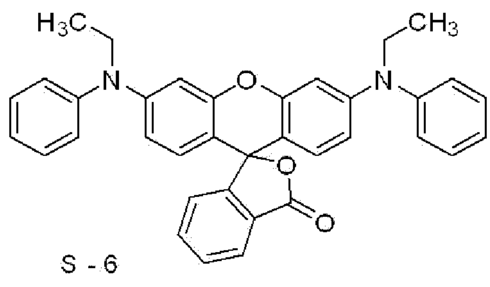

S - 6

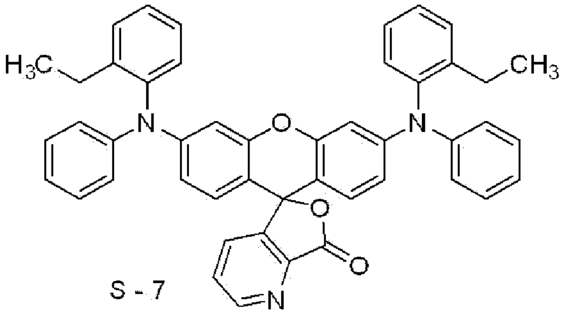

S - 7

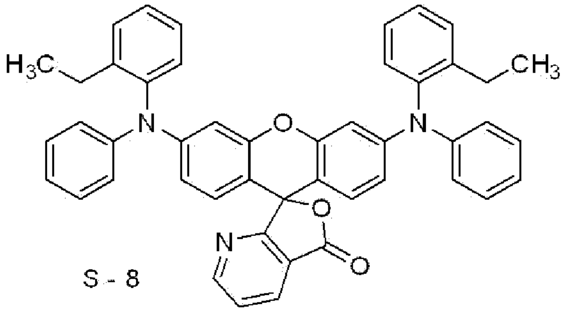

S - 8

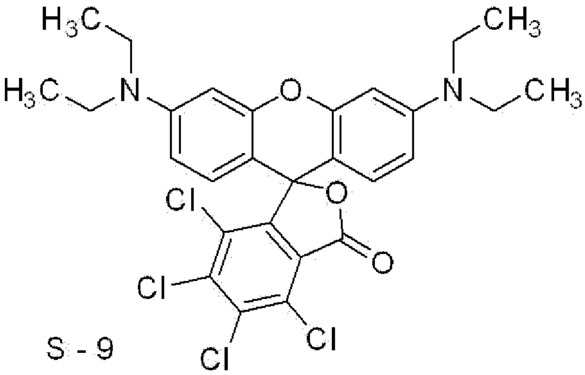

S - 9

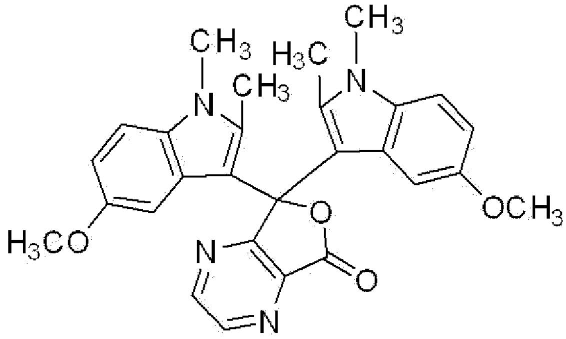

S - 10

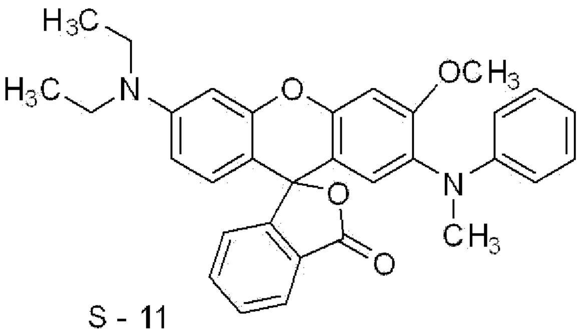

S - 11

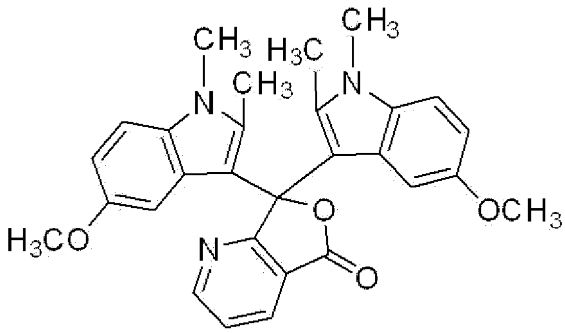

S - 12

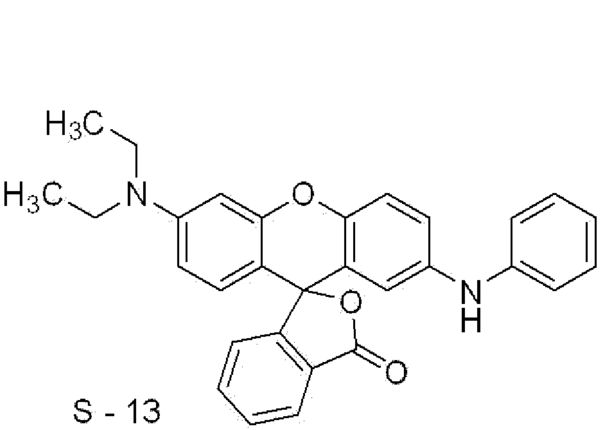

S - 13

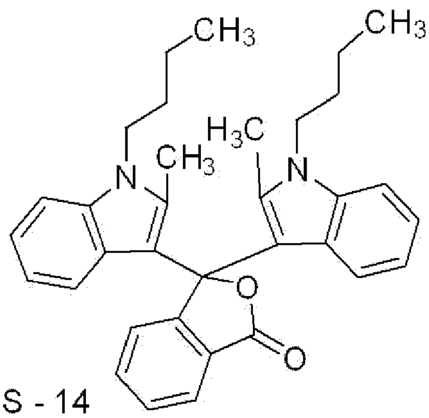

S - 14

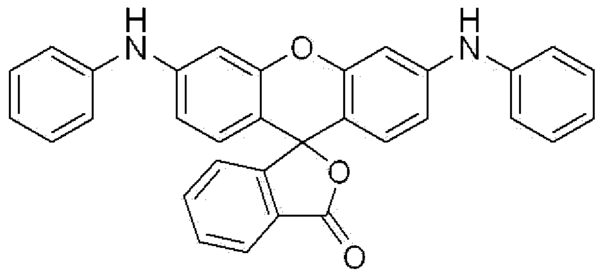

S - 15

As the color developing agent, commercially available products can be used. Examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

One kind of each of these color developing agents may be used alone. Alternatively, two or more kinds of components can be used in combination.

The content of the color developing agent with respect to the total mass of the image-recording layer is preferably 0.5% by mass to 10% by mass, and more preferably 1% by mass to 5% by mass.

-Other binder polymers-

The image-recording layer may also contain binder polymers (other binder polymers) other than the binder polymer.

For example, from the viewpoint of inhibiting on-press developability from deteriorating over time, the glass transition temperature (Tg) of other binder polymers is preferably 50°C or higher, more preferably 70°C or higher, even more preferably 80°C or higher, and particularly preferably 90°C or higher.

Furthermore, from the viewpoint of ease of permeation of water into the image-recording layer, the upper limit of the glass transition temperature of the binder polymers is preferably 200°C, and more preferably 120°C or lower.

From the viewpoint of further inhibiting on-press developability from deteriorating over time, as the binder polymer having the above glass transition temperature, polyvinyl acetal is preferable. Some polyvinyl acetals correspond to the compound satisfying $\delta p$ = 2.4 to 14 in the solubility parameters. In this case, the polyvinyl acetals are treated as the compound satisfying $\delta p$ = 2.4 to 14 in the solubility parameters.

Polyvinyl acetal is a resin obtained by acetalizing hydroxyl groups of polyvinyl alcohol with an aldehyde.

Particularly, polyvinyl butyral is preferable which is obtained by acetalizing (that is, butyralizing) hydroxyl groups of polyvinyl alcohol with butyraldehyde.

As polyvinyl acetal, a compound having a constitutional unit represented by the following (a) is preferable which is obtained by acetalizing hydroxyl groups of polyvinyl alcohol with an aldehyde.

(a)

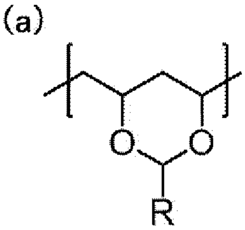

R represents a residue of aldehyde used for acetalization.

Examples of R include a hydrogen atom, an alkyl group, and an ethylenically unsaturated group which will be described later.

The content of the constitutional unit represented by (a) (also described as the amount of ethylene groups in the main chain contained in the constitutional unit represented by (a), which is also called degree of acetalization) with respect to the total content of constitutional units of the polyvinyl acetal (total amount of ethylene groups in the main chain) is preferably 50 mol% to 90 mol%, more preferably 55 mol% to 85 mol%, and even more preferably 55 mol% to 80 mol%.

The degree of acetalization is a value obtained by dividing the amount of ethylene groups to which acetal groups are bonded (amount of ethylene groups in the main chain contained in the constitutional unit represented by (a)) by the total amount of ethylene groups in the main chain and expressing the thus obtained molar fraction as a percentage.

The same shall be applied to the content of each constitutional unit of polyvinyl acetal which will be described later.

From the viewpoint of improving printing durability, the polyvinyl acetal preferably has an ethylenically unsaturated group.

The ethylenically unsaturated group that the polyvinyl acetal has is not particularly limited. From the viewpoint of reactivity, on-press developability, and printing durability, the ethylenically unsaturated group is more preferably at least one kind of group selected from the group consisting of a vinyl phenyl group (styryl group), a vinyl ester group, a vinyl ether group, an allyl group, a (meth)acryloxy group, and a (meth)acrylamide group. Among these, a vinyl group, an allyl group, a (meth)acryloxy group, and the like are still more preferable.

From the viewpoint of improving printing durability, the polyvinyl acetal preferably has an ethylenically unsaturated group-containing constitutional unit.

The ethylenically unsaturated group-containing constitutional unit may be the aforementioned constitutional unit having an acetal ring or a constitutional unit other than the constitutional unit having an acetal ring.

Particularly, from the viewpoint of increasing crosslink density during exposure, the polyvinyl acetal is preferably a compound in which an ethylenically unsaturated group is introduced into an acetal ring. That is, it is preferable that the constitutional unit represented by (a) have an ethylenically unsaturated group as R.

In a case where the ethylenically unsaturated group-containing constitutional unit is a constitutional unit other than the constitutional unit having an acetal ring, for example, the ethylenically unsaturated group-containing constitutional unit may be an acrylate group-containing constitutional unit, specifically, a constitutional unit represented by (d).

(d)

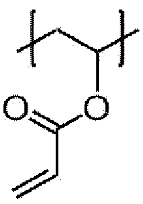

In a case where the ethylenically unsaturated group-containing constitutional unit is a constitutional unit other than the constitutional unit having an acetal ring, the content of the ethylenically unsaturated group-containing constitutional unit (also called amount of acrylate groups) with respect to the total content of constitutional units of the polyvinyl acetal is preferably 1 mol% to 15 mol%, and more preferably 1 mol% to 10 mol%.

From the viewpoint of on-press developability, the polyvinyl acetal preferably further has a hydroxyl group-containing constitutional unit. That is, the polyvinyl acetal preferably contains a constitutional unit derived from vinyl alcohol.

Examples of the hydroxyl group-containing constitutional unit include a constitutional unit represented by (b).

(b)

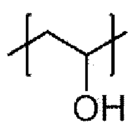

From the viewpoint of on-press developability, the content of the constitutional unit represented by (b) (also called amount of hydroxyl groups) with respect to the total content of constitutional units of the polyvinyl acetal is preferably 5 mol% to 50 mol%, more preferably 10 mol% to 40 mol%, and even more preferably 20 mol% to 40 mol%.

The polyvinyl acetal may further have other constitutional units.

Examples of those other constitutional units include an acetyl group-containing constitutional unit, specifically, a constitutional unit represented by (c).

(c)

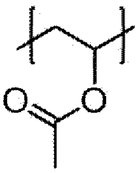

The content of the constitutional unit represented by (c) (also called amount of acetyl groups) with respect to the total content of constitutional units of the polyvinyl acetal is preferably 0.5 mol% to 10 mol%, more preferably 0.5 mol% to 8 mol%, and even more preferably 1 mol% to 3 mol%.

The degree of acetalization, the amount of acrylate groups, the amount of hydroxyl groups, and the amount of acetyl groups can be determined as follows.

That is, by $^1$H NMR spectroscopy, the content expressed as mol% is calculated from the ratio of peak surface area of protons of a methyl or methylene moiety of acetal, a methyl moiety of an acrylate group, and a methyl moiety of a hydroxyl group and an acetyl group.

The weight-average molecular weight of the polyvinyl acetal is preferably 18,000 to 150,000.

The solubility parameter (also called SP value) of the polyvinyl acetal is preferably 17.5 MPa$^{1/2}$ to 20.0 MPa$^{1/2}$, and more preferably 18.0 MPa$^{1/2}$ to 19.5 MPa$^{1/2}$.

As "solubility parameter (unit: (MPa) $^{1/2}$)", the Hansen solubility parameters are used.

The Hansen solubility parameters are obtained by dividing the solubility parameters introduced by Hildebrand into three components, a dispersion element δd, a polarity element δp, and a hydrogen bond element δh, and expressing the parameters in a three-dimensional space. The solubility parameters (hereinafter, also called SP value) are expressed as δ (unit: (MPa)$^{1/2}$), and a value calculated by the following equation is used.

$$\delta\ (\mathrm{MPa})^{1/2} = (\delta d^2 + \delta p^2 + \delta h^2)^{1/2}$$

The dispersion element δd, the polarity element δp, and the hydrogen bond element δh of various substances have been found by Hansen and his successors, and are described in detail in the Polymer Handbook (fourth edition), VII-698 to 711. The Hansen solubility parameters are also specifically described in the document "Hansen Solubility Parameters; A Users Handbook (CRC Press, 2007)" written by Charles M. Hansen.

As the Hansen solubility parameters of a partial structure of a compound, it is also possible to use values estimated from the chemical structure by using the computer software "Hansen Solubility Parameters in Practice (HSPiP ver.4.1.07)".

Furthermore, in a case where a compound is an addition polymerization-type polymer, a polycondensation-type polymer, or the like, the SP value of the compound is expressed as the total SP value obtained by multiplying the SP values of monomer units by molar fractions. Furthermore, in a case where a compound is a low-molecular-weight compound having no monomer unit, the SP value is expressed as the total solubility parameter of the compound.

The SP value of a polymer may be calculated from the molecular structure of the polymer by the Hoy method described in Polymer Handbook (fourth edition).

Specific examples of the polyvinyl acetal are shown in the following [P-1 to P-3]..

In the following structures, "1" is 50 mol% to 90 mol%, "m" is 0.5 mol% to 10 mol%, "n" is 5 mol% to 50 mol%, and "o" is 1 mol% to 15 mol%.

P-1

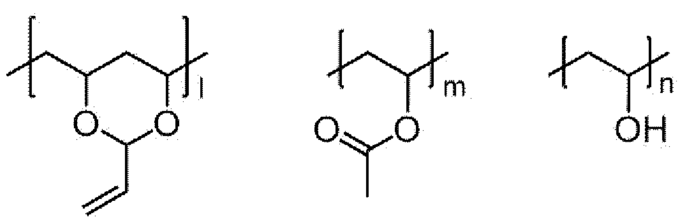

P-2

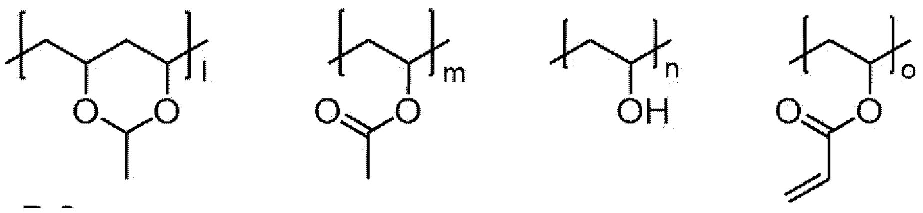

P-3

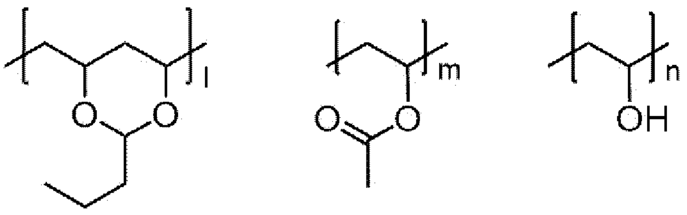

As the polyvinyl acetal, commercially available products can be used.

Examples of the commercially available products of the polyvinyl acetal include S-LEC series manufactured by SEKISUI CHEMICAL CO., LTD. (specifically, S-LEC BX-L, BX-1, BX-5, BL-7Z, BM-1, BM-5, BH-6, BH-3, and the like).

The image-recording layer preferably contains a resin having a fluorine atom as other binder polymers, and more preferably contains a fluoroaliphatic group-containing copolymer.

In a case where the resin having a fluorine atom, particularly, the fluoroaliphatic group-containing copolymer is used, it is possible to inhibit surface abnormalities resulting from foaming during the formation of the image-recording layer and to improve the condition of the coating surface, and the formed image-recording layer has higher ink receptivity.

In addition, the image-recording layer containing the fluoroaliphatic group-containing copolymer has high gradation and highly sensitive, for example, to laser light. Therefore, the obtained lithographic printing plate exhibits excellent fogging properties by scattered light, reflected light, and the like and has excellent printing durability.

The fluoroaliphatic group-containing copolymer preferably has a constitutional unit formed of a compound represented by any of Formula (F1) and Formula (F2).

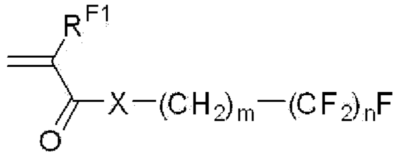

(F1)

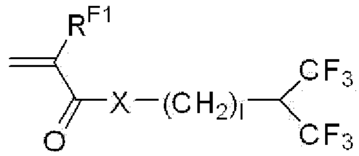

(F2)

In Formula (F1) and Formula (F2), $R^{F1}$ each independently represents a hydrogen atom or a methyl group, X each independently represents an oxygen atom, a sulfur atom, or $-N(R^{F2})-$, m represents an integer of 1 to 6, n represents an integer of 1 to 10, l represents an integer of 0 to 10, and $R^{F2}$ represents a hydrogen atom or an alkyl group having 1 to 4 carbon atoms.

The alkyl group having 1 to 4 carbon atoms represented by $R^{F2}$ in Formula (F1) and Formula (F2) is preferably a methyl group, an ethyl group, a n-propyl group, or a n-butyl group, and more preferably a hydrogen atom or a methyl group.

X in Formula (F1) and Formula (F2) is preferably an oxygen atom.

m in Formula (F1) is preferably 1 or 2, and more preferably 2.

n in Formula (F1) is preferably 2, 4, 6, 8, or 10, and more preferably 4 or 6.

l in Formula (F1) is preferably 0.

Specific examples of the monomers having a fluorine atom used in the resin having a fluorine atom will be shown below.

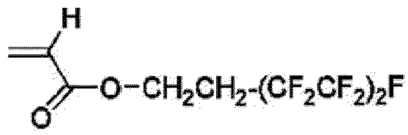

F-1

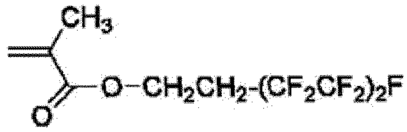

F-2

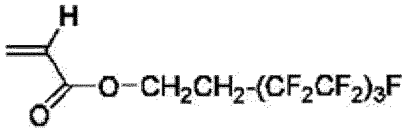

F-3

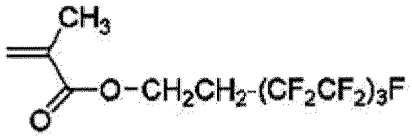

F-4

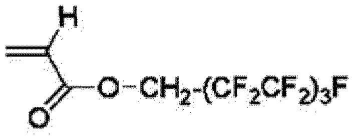

F-5

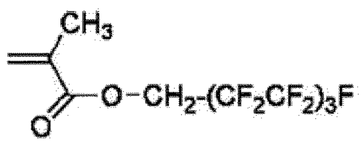

F-6

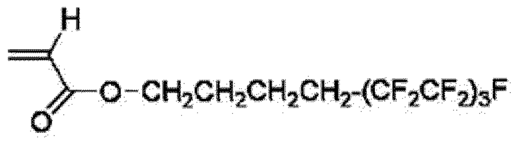

F-7

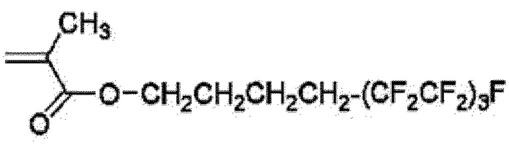

F-8

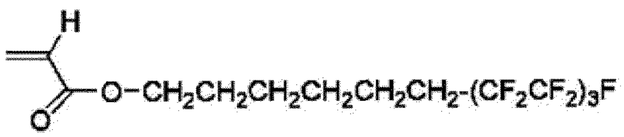

F-9

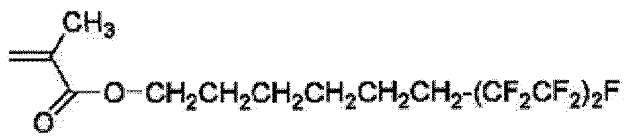

F-10

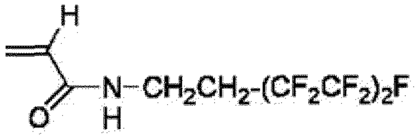

F-11

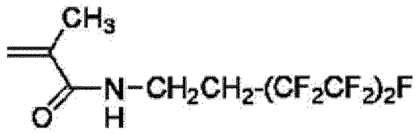

F-12

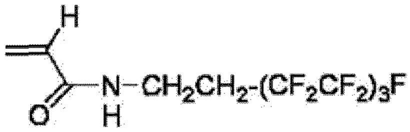

F-13

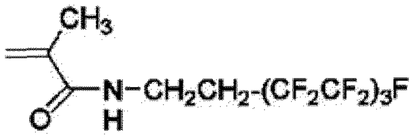

F-14

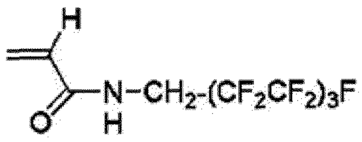

F-15

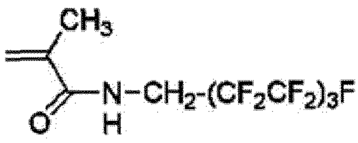

F-16

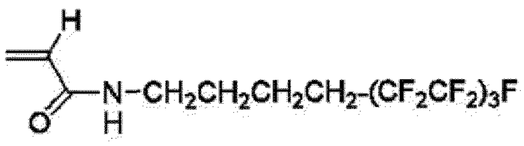

F-17

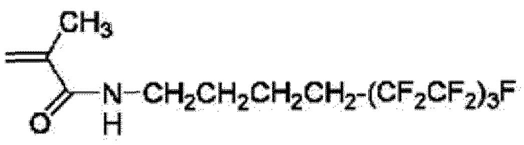

F-18

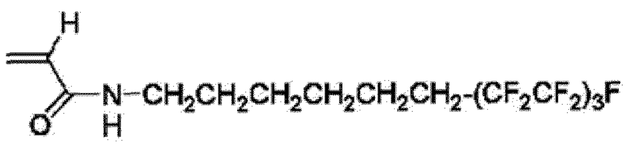

F-19

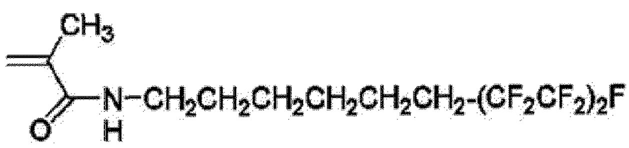

F-20

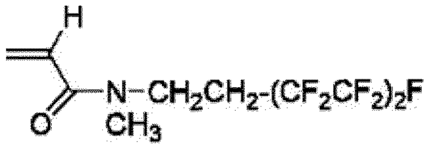

F-21

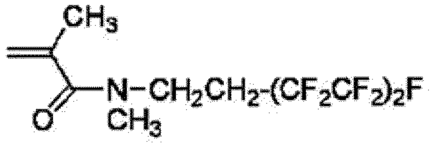

F-22

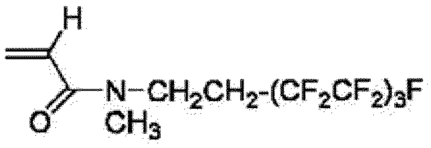

F-23

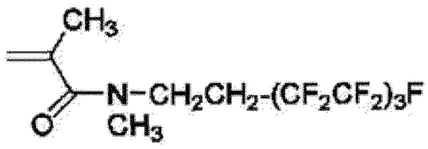

F-24

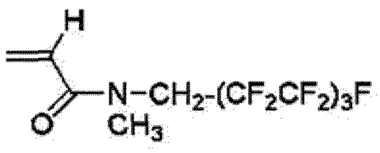

F-25

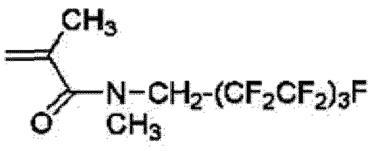

F-26

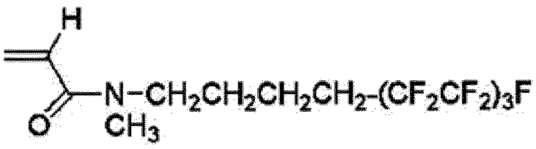

F-27

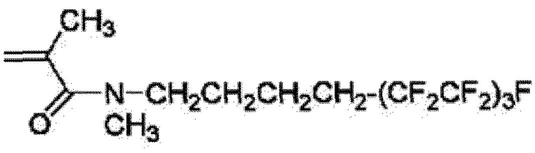

F-28

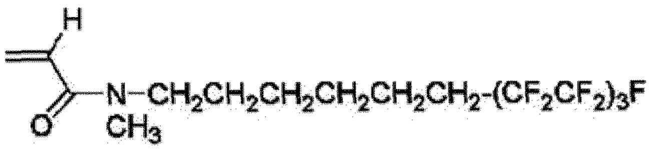

F-29

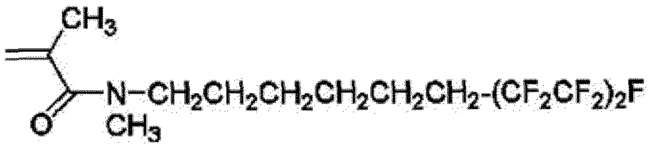

F-30

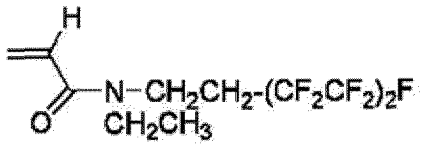

F-31

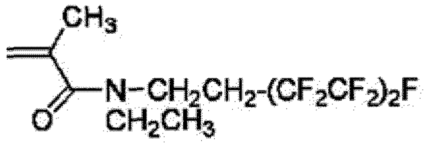

F-32

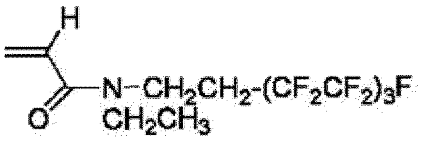

F-33

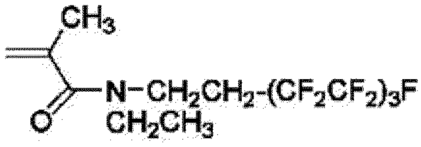

F-34

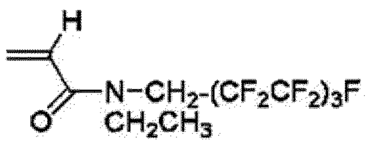

F-35

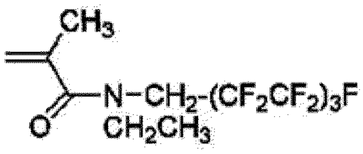

F-36

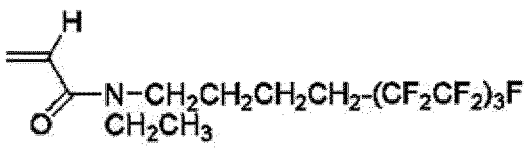

F37

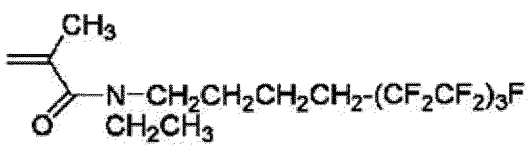

F38

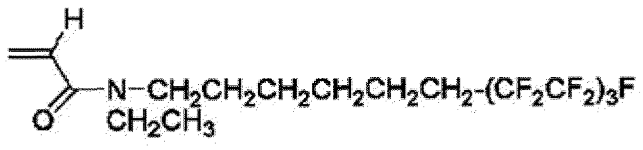

F-39

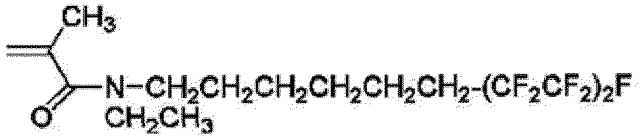

F-40

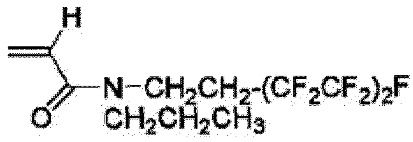

F-41

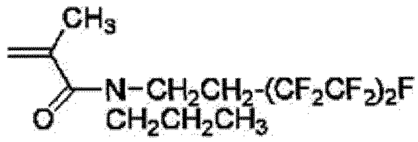

F-42

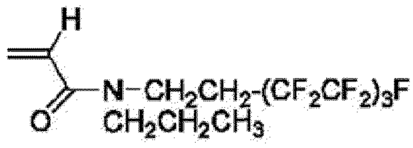

F-43

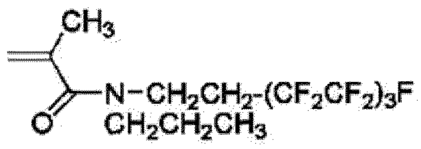

F-44

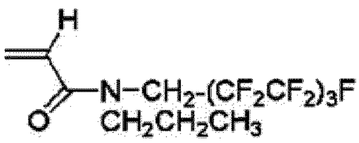

F-45

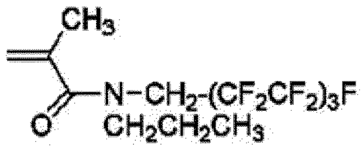

F-46

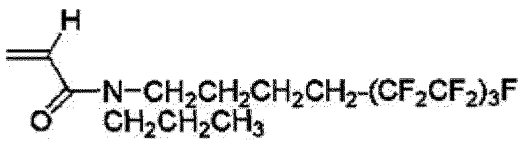

F-47

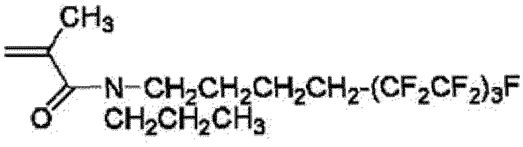

F-48

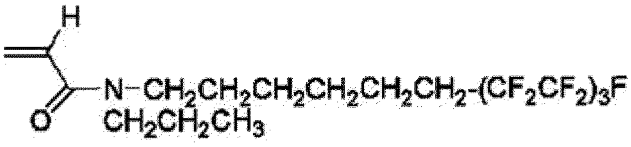

F-49

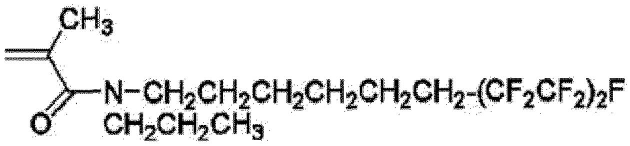

F-50

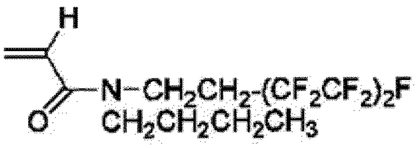

F-51

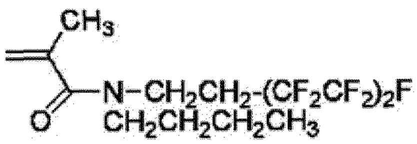

F-52

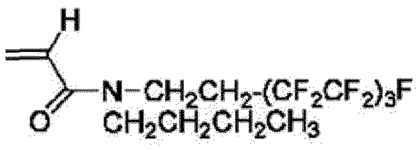

F-53

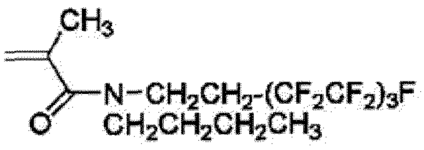

F-54

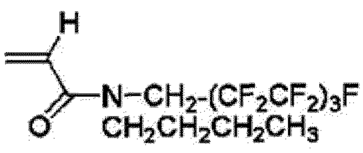

F-55

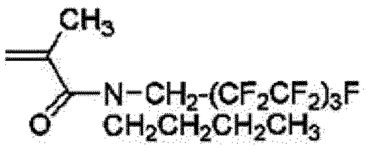

F-56

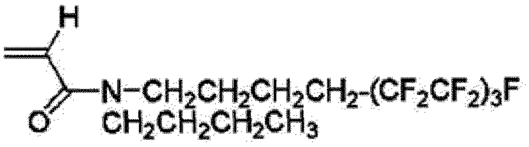

F-57

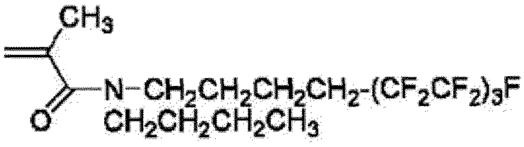

F-58

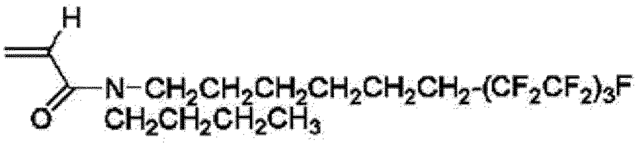

F-59

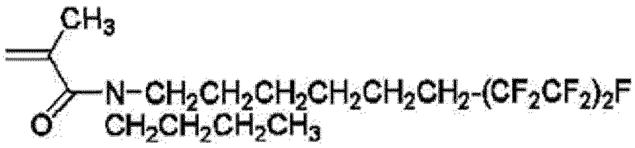

F-60

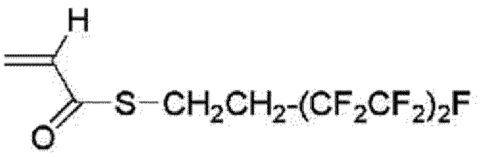

F-61

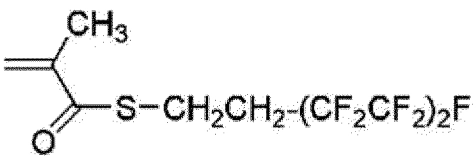

F-62

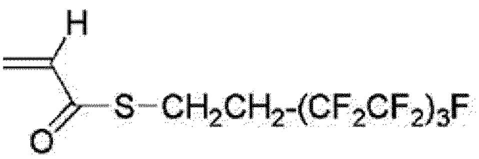

F-63

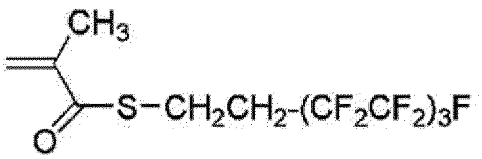

F-64

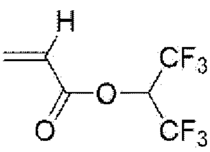

F-65

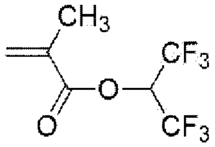

F-66

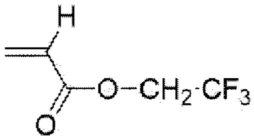

F-67

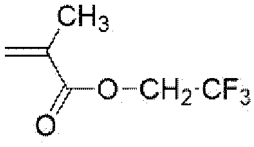

F-68

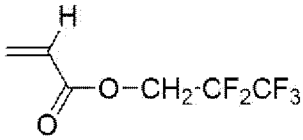

F-69

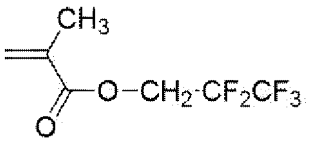

F-70

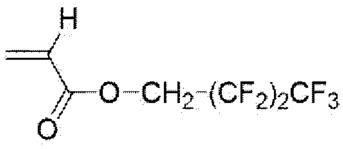

F-71

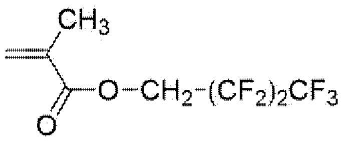

F-72

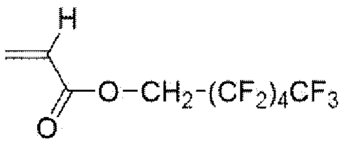

F-73

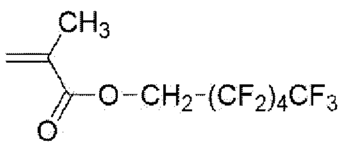

F-74

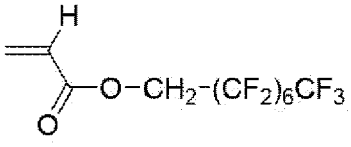

F-75

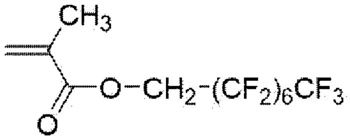

F-76

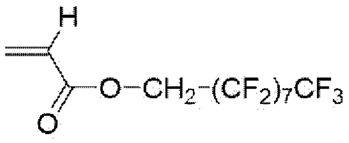

F-77

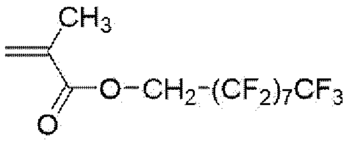

F-78

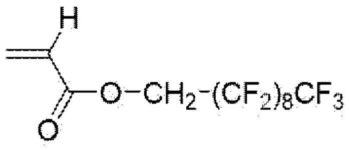

F-79

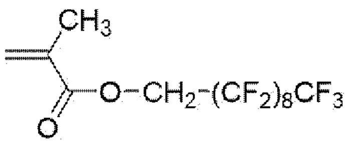

F-80

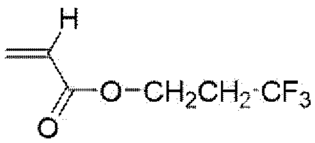

F-81

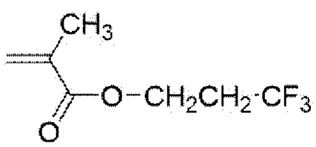

F-82

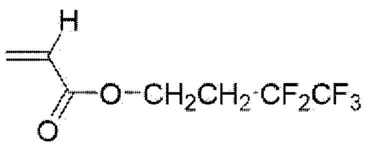

F-83

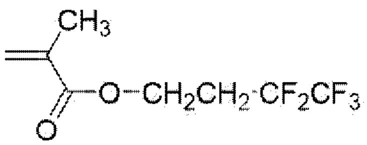

F-84

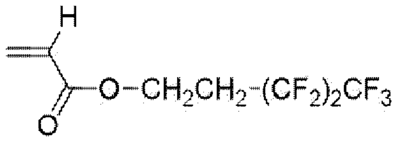

F-85

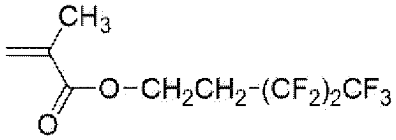

F-86

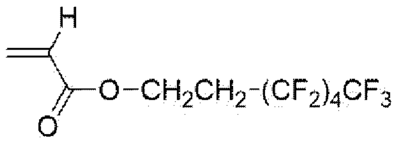

F-87

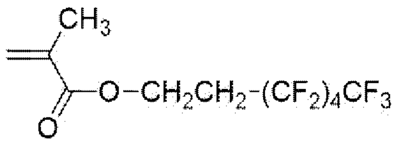

F-88

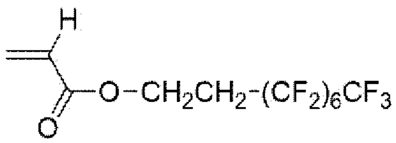

F-89

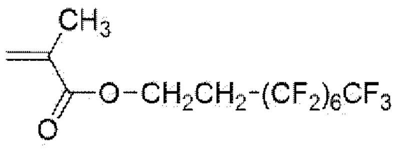

F-90

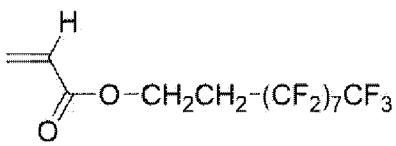

F-91

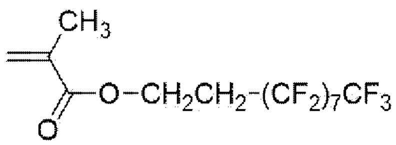

F-92

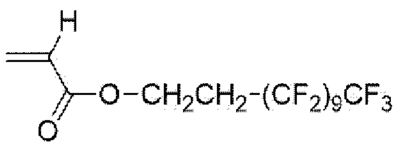

F-93

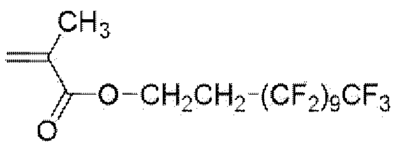

F-94

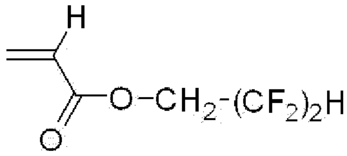
F-95

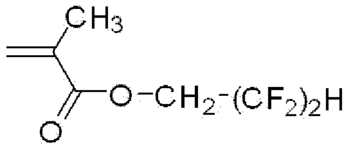
F-96

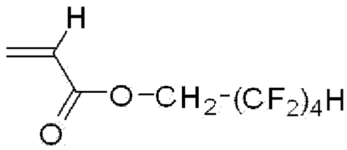
F-97

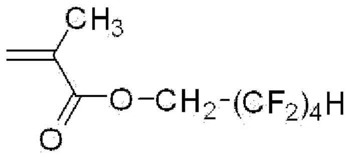
F-98

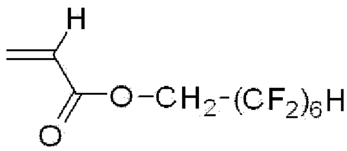
F-99

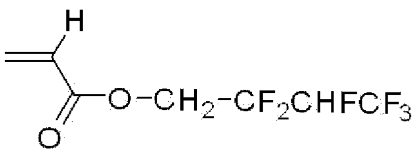
F-100

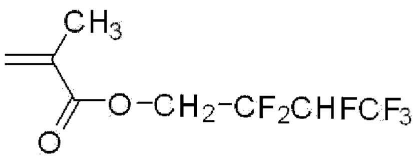
F-101

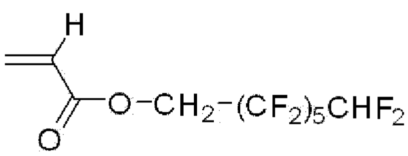
F-102

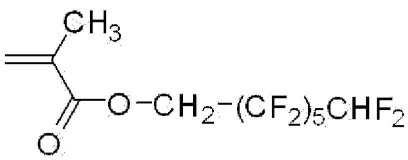
F-103

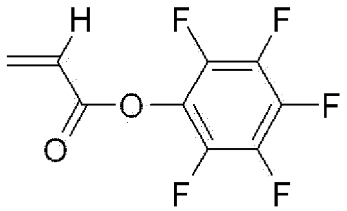

F-104

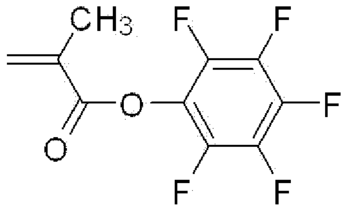

F-105

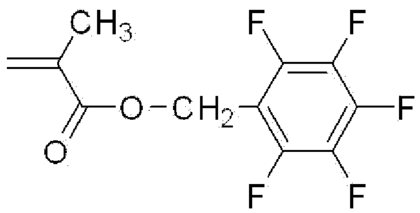

F-106

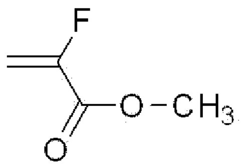

F-107

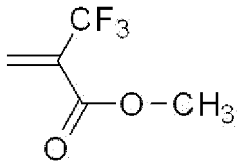

F-108

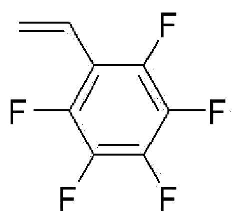

F-109

The fluoroaliphatic group-containing copolymer preferably further has a constitutional unit formed of at least one kind of compound selected from the group consisting of poly(oxyalkylene) acrylate and a poly(oxyalkylene) methacrylate, in addition to the constitutional unit formed of a compound represented by any of Formula (F1) and Formula (F2).

The polyoxyalkylene group in the poly(oxyalkylene) acrylate and poly(oxyalkylene) methacrylate can be represented by $-(OR^{F3})_x-$. $R^{F3}$ represents an alkyl group, and x represents an integer of 2 or more. $R^{F3}$ is preferably a linear or branched alkylene group having 2 to 4 carbon atoms. As the linear or branched alkylene group having 2 to 4 carbon atoms, $-CH_2CH_2-$, $-CH_2CH_2CH_2-$, $-CH(CH_3)CH_2-$, or $-CH(CH_3)CH(CH_3)-$ is preferable. x is preferably an integer of 2 to 100.

In the polyoxyalkylene groups, x pieces of "$OR^{F3}$" may be the same as or different from each other. That is, the polyoxyalkylene group may be composed of two or more kinds of "$OR^{F3}$" that are regularly or irregularly bonded to each other. For example, the polyoxyalkylene group may be composed of a linear or branched oxypropylene unit and an oxyethylene unit that are regularly or irregularly bonded to each other. More specifically, the polyoxyalkylene group may be composed of a block of a linear or branched oxypropylene unit and a block of an oxyethylene unit that are bonded to each

other.

The polyoxyalkylene group may have one or more linking groups (for example, -CONH-Ph-NHCO-, -S-, and the like, in which Ph represents a phenylene group).

The molecular weight of the polyoxyalkylene group is preferably 250 to 3,000.

As the poly(oxyalkylene) acrylate and the poly(oxyalkylene) methacrylate described above, commercially available products or synthetic products may be used.

The poly(oxyalkylene) acrylate and the poly(oxyalkylene) methacrylate can be synthesized, for example, by reacting a hydroxypoly(oxyalkylene) compound with acrylic acid, methacrylic acid, acryloyl chloride, methacryloyl chloride, acrylic acid anhydride, or the like by known methods.

As the aforementioned hydroxypoly(oxyalkylene) compound, commercially available products may be used. Examples thereof include ADEKA (registered trademark) PLURONIC manufactured by ADEKA Corporation, ADEKA polyether manufactured by ADEKA Corporation, Carbowax (registered trademark) manufactured by Union Carbide Corporation, Triton manufactured by The Dow Chemical Company., PEG manufactured by DKS Co. Ltd., and the like.

As the poly(oxyalkylene) acrylate and the poly(oxyalkylene) methacrylate, poly(oxyalkylene) diacrylate or the like synthesized by known methods may also be used.

-Chain transfer agent-

The image-recording layer may contain a chain transfer agent. The chain transfer agent contributes to the improvement of printing durability of the lithographic printing plate.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

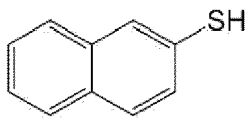

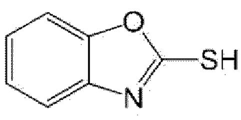
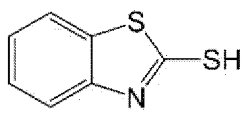
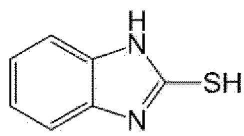

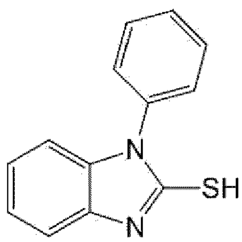
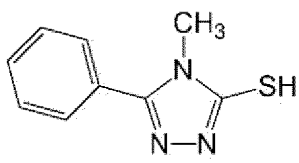
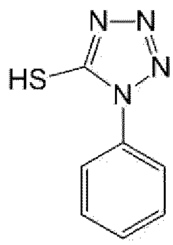

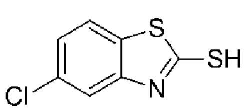
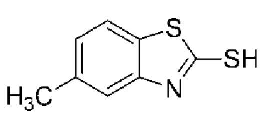
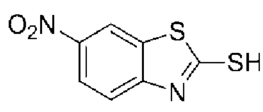
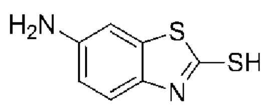

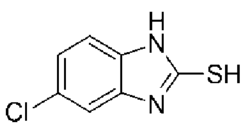
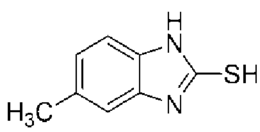
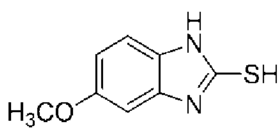
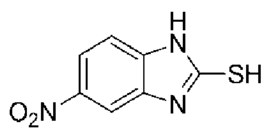

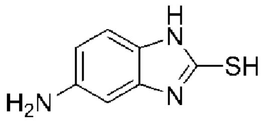 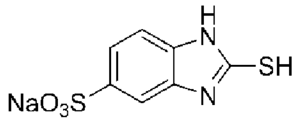 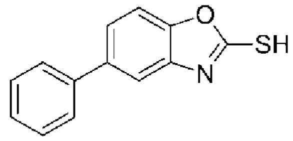

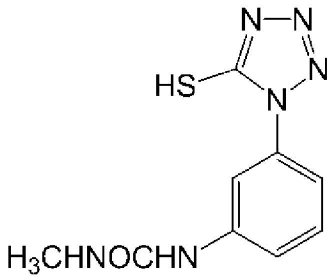 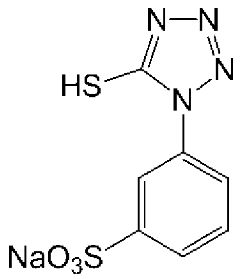

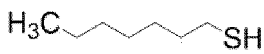
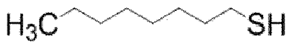
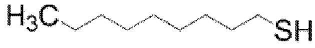
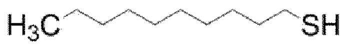
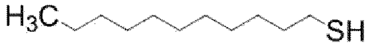
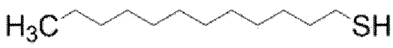
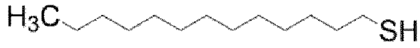
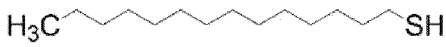
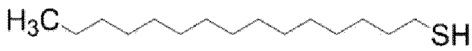
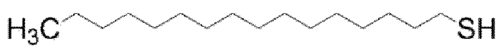
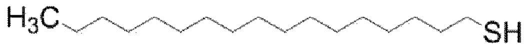
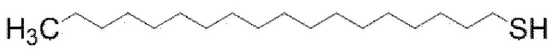
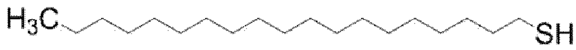
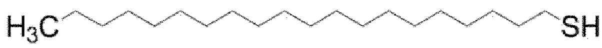
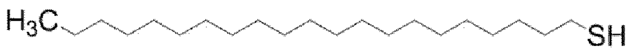
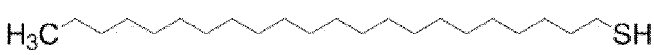

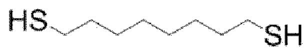
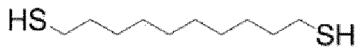
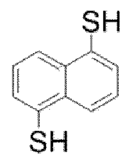 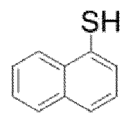
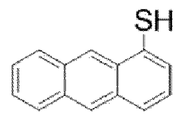 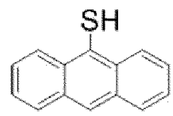
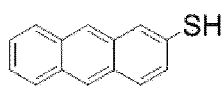 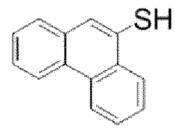
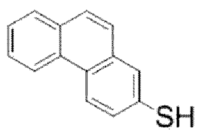 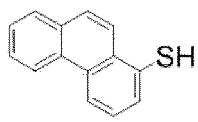
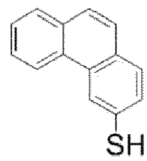 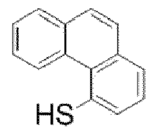

Only one kind of chain transfer agent may be added to the image-recording layer, or two or more kinds of chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

-Low-molecular-weight hydrophilic compound-

In order to suppress the deterioration of printing durability and improve on-press developability, the image-recording layer may contain a low-molecular-weight hydrophilic compound. The low-molecular-weight hydrophilic

compound is preferably a compound having a molecular weight less than 1,000, more preferably a compound having a molecular weight less than 800, and even more preferably a compound having a molecular weight less than 500.

Examples of the low-molecular-weight hydrophilic compound include water-soluble organic compounds including glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.

As the low-molecular-weight hydrophilic compound, at least one compound selected from polyols, organic sulfates, organic sulfonates, and betaines is preferably incorporated into the image-recording layer.

Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having a polyethyleneoxy chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonates such as sodium benzenesulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthyl sulfonate, disodium 1,5-naphthalene disulfonate, and trisodium 1,3,6-naphthalene trisulfonate, the compounds described in paragraphs "0026" to "0031" of JP2007-276454A and paragraphs "0020" to "0047" of JP2009-154525A, and the like. The salt may be a potassium salt or a lithium salt.

Examples of the organic sulfates include sulfates of alkyl, alkenyl, alkynyl, aryl, or heterocyclic monoether of a polyethyleneoxy structure. The number of ethyleneoxy units is preferably 1 to 4, and the salt is preferably a sodium salt, a potassium salt, or a lithium salt. Specific examples thereof include the compounds described in paragraphs "0034" to "0038" of JP2007-276454A.

As the betaines, compounds in which a nitrogen atom is substituted with a hydrocarbon substituent having 1 to 5 carbon atoms are preferable. Specifically, examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, 3-(1-pyridinio)-1-propanesulfonate, and the like.

The low-molecular-weight hydrophilic compound substantially does not perform a surface activation action because this compound has a small structure of a hydrophobic portion. Therefore, this compound prevents dampening water from permeating the exposed portion of the image-recording layer (image area) and deteriorating hydrophobicity or film hardness of the image area. Accordingly, the image-recording layer can maintain excellent ink receiving properties and printing durability.

The content of the low-molecular-weight hydrophilic compound with respect to the total mass of the image-recording layer is preferably 0.5% by mass to 20% by mass, more preferably 1% by mass to 15% by mass, and even more preferably 2% by mass to 10% by mass. In a case where the content is within this range, excellent on-press developability and printing durability can be obtained.

One kind of low-molecular-weight hydrophilic compound may be used alone, or two or more kinds of low-molecular-weight hydrophilic compounds may be used by being mixed together.

-Oil sensitizing agent-

In order to improve receptivity, the image-recording layer may contain an oil sensitizing agent such as a phosphonium compound, a nitrogen-containing low-molecular-weight compound, or an ammonium group-containing polymer. Particularly, in a case where an inorganic lamellar compound is incorporated into a protective layer, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-50660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 1,500,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacryl ate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)
(9) 2-(Butyldimethylammonio)ethylmethacrylate=hexafluorophosphate/3,6-dioxaheptylmethacryl ate/2-hydroxy-3-methacryloyloxypropylmethacrylate copolymer (molar ratio: 15/80/5, Mw: 65,000)

The content of the oil sensitizing agent with respect to the total mass of the image-recording layer is preferably 0.01% by mass to 30.0% by mass, more preferably 0.1% by mass to 15.0% by mass, and even more preferably 1% by mass to 10% by mass.

-Other components-

As other components, a surfactant, a polymerization inhibitor, a higher fatty acid derivative, a plasticizer, inorganic particles, an inorganic lamellar compound, and the like can be incorporated into the image-recording layer. Specifically, the description in paragraphs "0114" to "0159" of JP2008-284817A can be referred to.

-Formation of image-recording layer-

The image-recording layer in the lithographic printing plate precursor can be formed, for example, by preparing a coating solution by dispersing or dissolving the necessary components described above in a known solvent, coating a support with the coating solution by a known method such as bar coating, and drying the coating solution, as described in paragraphs "0142" and "0143" of JP2008-195018A.

As the solvent, known solvents can be used. Specific examples thereof include water, acetone, methyl ethyl ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate,

1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. One kind of solvent may be used alone, or two or more kinds of the solvents may be used in combination. The concentration of solid contents in the coating solution is preferably about 1% to 50% by mass.

The coating amount (solid content) of the image-recording layer after coating and drying varies with uses. However, from the viewpoint of obtaining excellent sensitivity and excellent film characteristics of the image-recording layer, the coating amount is preferably 0.3 $g/m^2$ to 3.0 $g/m^2$.

<Aluminum support>

The aluminum support of the lithographic printing plate precursor according to the present invention to be used can be appropriately selected from known aluminum supports for a lithographic printing plate precursor. Hereinafter, the aluminum support will be also simply called "support".

As the aluminum support, an aluminum support having a hydrophilic surface (hereinafter, also called "hydrophilic aluminum support") is preferable.

For the aluminum support in the lithographic printing plate precursor according to the present invention, from the viewpoint of suppressing scratches and contamination, a water contact angle on a surface of the aluminum support on the image-recording layer side that is determined by an airborne water droplet method is preferably 110° or less, more preferably 90° or less, even more preferably 80° or less, still more preferably 50° or less, particularly preferably 30° or less, more particularly preferably 20° or less, and most preferably 10° or less.

The water contact angle on a surface of the aluminum support on the image-recording layer side that is determined by an airborne water droplet method is measured by the following method.

The lithographic printing plate precursor is immersed in a solvent capable of removing the image-recording layer (for example, a solvent used in a coating solution for an image-recording layer), and the image-recording layer is scraped off with at least one of sponge or cotton or dissolved in a solvent, so that the surface of the aluminum support is exposed.

The water contact angle on a surface of the exposed aluminum support on the image-recording layer side is measured using a measurement device, a fully automatic contact angle meter (for example, DM-501 manufactured by Kyowa Interface Science Co., Ltd.), as a water droplet contact angle on the surface at 25°C (after 0.2 seconds).

As the aluminum support in the present invention, an aluminum plate is preferable which has been roughened using a known method and has undergone an anodic oxidation treatment. That is, the aluminum support in the present invention preferably has an aluminum plate and an aluminum anodic oxide film disposed on the aluminum plate.

One of the examples of preferred aspects of the aluminum support(the aluminum support according to this example is also called "support (1)") is as below.

That is, the support (1) has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, the average diameter of the micropores within the surface of the anodic oxide film is more than 10 nm and 100 nm or less, and a value of brightness L* of the surface of the anodic oxide film on the side of the image-recording layer is 70 to 100 in the L*a*b* color space.

Fig. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned so that the anodic oxide film 20a is closer to the image-recording layer side than the aluminum plate 18. That is, it is preferable that the lithographic printing plate precursor has at least an anodic oxide film, an image-recording layer, and a water-soluble resin layer in this order on an aluminum plate.

-Anodic oxide film-

Hereinafter, preferred aspects of the anodic oxide film 20a will be described.

The anodic oxide film 20a is a film prepared on a surface of the aluminum plate 18 by an anodic oxidation treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).

Within the surface of the anodic oxide film, the average diameter (average opening diameter) of the micropores 22a in the anodic oxide film 20a is preferably more than 10 nm and 100 nm or less. Particularly, from the viewpoint of balance between printing durability, antifouling properties, and image visibility, the average diameter of the micropores 22a

is more preferably 15 nm to 60 nm, even more preferably 20 nm to 50 nm, and particularly preferably 25 nm to 40 nm. The internal diameter of the pores may be larger or smaller than the pore diameter within the surface layer.

In a case where the average diameter is more than 10 nm, printing durability and image visibility are further improved. Furthermore, in a case where the average diameter is 100 nm or less, printing durability is further improved.

The average diameter of the micropores 22a is determined by observing the surface of the anodic oxide film 20a with a field emission scanning electron microscope (FE-SEM) at 150,000X magnification (N = 4), measuring the size (diameter) of 50 micropores existing in a range of $400 \times 600$ nm$^2$ in the obtained 4 images, and calculating the arithmetic mean thereof.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The depth of the micropores 22a is not particularly limited, but is preferably 10 nm to 3,000 nm, more preferably 50 nm to 2,000 nm, and even more preferably 300 nm to 1,600 nm.

The depth is a value obtained by taking a photograph (150,000X magnification) of a cross section of the anodic oxide film 20a, measuring the depths of 25 or more micropores 22a, and calculating the average thereof.

The shape of the micropores 22a is not particularly limited. In Fig. 1, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.

In the L*a*b* color space, the value of brightness L* of the surface of the aluminum support 12a on the image-recording layer side (surface of the anodic oxide film 20a on the image-recording layer side) is preferably 70 to 100. Especially, the value of brightness L* is preferably 75 to 100 and more preferably 75 to 90, because printing durability and image visibility are better balanced in this range.

The brightness L* is measured using a color difference meter Spectro Eye manufactured by X-Rite, Incorporated.

For example, an aspect is also preferable in which the micropores in the support (1) are each constituted with a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communication position, an average diameter of the large diameter portion within the surface of the anodic oxide film is 15 nm to 150 nm, and an average diameter of the small diameter portion at a communication position is 13 nm or less (hereinafter, the support according to this aspect will be also called "support (2)").

Fig. 2 is a schematic cross-sectional view of an embodiment of the aluminum support 12a that is different from what is shown in Fig. 1.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communication position to a position at a depth of 20 nm to 2,000 nm.

Hereinafter, the large diameter portion 24 and the small diameter portion 26 will be specifically described.

The average diameter of the large diameter portion 24 within the surface of the anodic oxide film 20b is the same as the average diameter of the micropores 22a in the aforementioned anodic oxide film 20a within the surface of the anodic oxide film, which is more than 10 nm and 100 nm or less. The suitable range thereof is also the same.

The method for measuring the average diameter of the large diameter portion 24 within the surface of the anodic oxide film 20b is the same as the method for measuring the average diameter of the micropores 22a in the anodic oxide film 20a within the surface of the anodic oxide film.

The bottom portion of the large diameter portion 24 is in a position at a depth of 10 nm to 1,000 nm (hereinafter, also called depth D) from the surface of the anodic oxide film. That is, the large diameter portion 24 is a pore portion extending to a position at a depth of 10 nm to 1,000 nm from the surface of the anodic oxide film in the depth direction (thickness direction). The depth is preferably 10 nm to 200 nm.

The depth is a value obtained by taking a photograph (150,000X magnification) of a cross section of the anodic oxide film 20b, measuring the depths of 25 or more large diameter portions 24, and calculating the average thereof.

The shape of the large diameter portion 24 is not particularly limited. Examples of the shape of the large diameter portion 24 include a substantially straight tubular shape (substantially cylindrical shape) and a conical shape that tapers along the depth direction (thickness direction). Among these, a substantially straight tubular shape is preferable.

As shown in Fig. 2, the small diameter portion 26 is a pore portion that is in communication with the bottom portion of the large diameter portion 24 and further extends from the communication position in the depth direction (thickness direction).

The average diameter of the small diameter portion 26 at the communication position is preferably 13 nm or less.

Particularly, the average diameter is preferably 11 nm or less, and more preferably 10 nm or less. The lower limit thereof is not particularly limited, but is 5 nm or more in many cases.

The average diameter of the small diameter portion 26 is obtained by observing the surface of the anodic oxide film 20a with FE-SEM at a 150,000X magnification (N = 4), measuring the size (diameter) of the micropores (small diameter portion) existing in a range of 400 nm × 600 nm in the obtained 4 images, and calculating the arithmetic mean thereof. In a case where the large diameter portion is deep, if necessary, the upper portion of the anodic oxide film 20b (region where the large diameter portion is located) may be cut (for example, by using argon gas), then the surface of the anodic oxide film 20b may be observed with FE-SEM described above, and the average diameter of the small diameter portion may be determined.

In a case where the shape of the small diameter portion 26 is not circular, the equivalent circular diameter is used. "Equivalent circular diameter" is a diameter determined on an assumption that the opening portion is in the form of a circle having the same projected area as the projected area of the opening portion.

The bottom portion of the small diameter portion 26 is in a position 20 nm to 2,000 nm distant from the communication position with the large diameter portion 24 in the depth direction. In other words, the small diameter portion 26 is a pore portion that extends further from the communication position with the large diameter portion 24 in the depth direction (thickness direction), and the depth of the small diameter portion 26 is 20 nm to 2,000 nm. The depth is preferably 500 nm to 1,500 nm.

The depth is a value determined by taking a photograph (50,000X magnification) of a cross section of the anodic oxide film 20b, measuring the depths of 25 or more small diameter portions, and calculating the average thereof.

The shape of the small diameter portion 26 is not particularly limited. Examples of the shape of the small diameter portion 26 include a substantially straight tubular shape (substantially cylindrical shape) and a conical shape that tapers along the depth direction. Among these, a substantially straight tubular shape is preferable.

-Method for manufacturing aluminum support-

As a method for manufacturing the aluminum support, for example, a manufacturing method is preferable in which the following steps are sequentially performed.

·Roughening treatment step: step of performing roughening treatment on aluminum plate
·Anodic oxidation treatment step: step of subjecting aluminum plate having undergone roughening treatment to anodic oxidation
·Pore widening treatment step: step of bringing aluminum plate having anodic oxide film obtained by anodic oxidation treatment step into contact with aqueous acid solution or aqueous alkali solution so that diameter of micropores in anodic oxide film increases

Hereinafter, the procedure of each step will be specifically described.

[Roughening treatment step]

The roughening treatment step is a step of performing a roughening treatment including an electrochemical roughening treatment on the surface of the aluminum plate. This step is preferably performed before the anodic oxidation treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment and mechanical roughening treatment and/or a chemical roughening treatment may be performed in combination.

In a case where the mechanical roughening treatment and the electrochemical roughening treatment are combined, it is preferable to perform the electrochemical roughening treatment after the mechanical roughening treatment.

It is preferable to perform the electrochemical roughening treatment by using direct current or alternating current in an aqueous solution containing nitric acid or hydrochloric acid as a main component.

The method of the mechanical roughening treatment is not particularly limited. Examples thereof include the method described in JP1975-40047B (JP-S50-40047B).

Furthermore, the chemical roughening treatment is not particularly limited, and examples thereof include known methods.

After the mechanical roughening treatment, it is preferable to perform the following chemical etching treatment.

By the chemical etching treatment performed after the mechanical roughening treatment, the edge portion of surface irregularities of the aluminum plate smoothed, so that ink clotting that may occur during printing is prevented, the

antifouling properties of the printing plate are improved, and unnecessary substances such as abrasive particles remaining on the surface are removed.

Examples of the chemical etching treatment include etching with an acid and etching with an alkali. One of the examples of particularly efficient etching methods is a chemical etching treatment using an aqueous alkali solution (hereinafter, also called "alkaline etching treatment").

The alkaline agent used in the aqueous alkali solution is not particularly limited. Examples thereof include caustic soda, caustic potash, sodium metasilicate, sodium carbonate, sodium aluminate, and sodium gluconate.

The aqueous alkali solution may contain aluminum ions.

The concentration of the alkaline agent in the aqueous alkali solution is preferably 0.01% by mass or more, and more preferably 3% by mass or more. Furthermore, the concentration of the alkaline agent is preferably 30% by mass or less.

In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").

The acid used in the aqueous acidic solution is not particularly limited, and examples thereof include sulfuric acid, nitric acid, and hydrochloric acid. The temperature of the aqueous acidic solution is preferably 20°C to 80°C.

As the roughening treatment step, a method is preferable in which the treatments described in an aspect A or an aspect B are performed in the following order.

~Aspect A~

(2) Chemical etching treatment using aqueous alkali solution (first alkaline etching treatment)
(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

~Aspect B~

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

If necessary, (1) mechanical roughening treatment may be performed before the treatment (2) of the aspect A or before the treatment (10) of the aspect B.

The amount of the aluminum plate dissolved by the first alkaline etching treatment and the fourth alkaline etching treatment is preferably 0.5 g/$m^2$ to 30 g/$m^2$, and more preferably 1.0 g/$m^2$ to 20 g/$m^2$.

Examples of the aqueous solution containing nitric acid as a main component used in the first electrochemical roughening treatment of the aspect A include aqueous solutions used in an electrochemical roughening treatment using direct current or alternating current. Examples thereof include an aqueous solution obtained by adding aluminum nitrate, sodium nitrate, ammonium nitrate, or the like to a 1 to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate;

hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is a graph showing an example of waveform graph of alternating current used for the electrochemical roughening treatment.

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 A/dm$^2$ to 200 A/dm$^2$ at both the anodic cycle side Ia and the cathodic cycle side Ic of the current. Ic/Ia is preferably 0.3 to 20. At a point time when the electrochemical roughening has ended, the total quantity of electricity that participates in the anodic reaction of the aluminum plate is preferably 25 C/dm$^2$ to 1,000 C/dm$^2$.

The electrochemical roughening using alternating current can be performed using the device shown in Fig. 4.

Fig. 4 is a lateral view showing an example of a radial cell in an electrochemical roughening treatment using alternating current.

In Fig. 4, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In Fig. 4, the arrow A1 represents a supply direction of an electrolytic solution, and the arrow A2 represents a discharge direction of the electrolytic solution. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined printing plate precursor, the amount of the aluminum plate dissolved by the second alkaline etching treatment is preferably 1.0 g/m$^2$ or more, and more preferably 2.0 g/m$^2$ to 10 g/m$^2$.

In view of easily manufacturing a predetermined printing plate precursor, the amount of the aluminum plate dissolved by the third alkaline etching treatment and the fourth alkaline etching treatment is preferably 0.01 g/m$^2$ to 0.8 g/m$^2$, and more preferably 0.05 g/m$^2$ to 0.3 g/m$^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

[Anodic oxidation treatment step]

The procedure of the anodic oxidation treatment step is not particularly limited as long as the aforementioned micropores can be obtained. Examples thereof include known methods.

In the first anodic oxidation treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodic oxidation treatment are appropriately set depending on the electrolytic solution used. For example, the liquid temperature is 5°C to 70°C (preferably 10°C to 60°C), the current density is 0.5 A/dm$^2$ to 60 A/dm$^2$ (preferably 5 A/dm$^2$ to 60 A/dm$^2$), the voltage is 1 V to 100 V (preferably 5 V to 50 V), the electrolysis time is 1 second to 100 seconds (preferably 5 seconds to 60 seconds), and the film amount is 0.1 g/m$^2$ to 5 g/m$^2$ (preferably 0.2 g/m$^2$ to 3 g/m$^2$).

[Pore widening treatment]

The pore widening treatment is a treatment of enlarging the diameter of micropores (pore diameter) present in the anodic oxide film formed by the aforementioned anodic oxidation treatment step (pore diameter enlarging treatment).
The pore widening treatment can be carried out by bringing the aluminum plate obtained by the anodic oxidation treatment step into contact with an aqueous acid solution or an aqueous alkali solution. The contact method is not particularly limited, and examples thereof include a dipping method and a spraying method.

<Undercoat layer>

The lithographic printing plate precursor preferably has an undercoat layer (called interlayer in some cases) between the image-recording layer and the support. The undercoat layer enhances the adhesiveness between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to infrared laser, the undercoat layer functions as an insulating layer and thus brings about an effect of preventing sensitivity reduction resulting from the diffusion of heat generated by exposure to the support.
Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups plus crosslinking groups are preferable. The compounds that are used in the undercoat layer may be low-molecular-weight compounds or polymers. If necessary, as the compounds that are used in the undercoat layer, two or more kinds of compounds may be used as a mixture.
In a case where the compounds that are used in the undercoat layer are polymers, copolymers of monomers having adsorbent groups, monomers having hydrophilic groups, and monomers having crosslinking groups are preferable.
As the adsorbent groups that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.
The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.
Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bonding groups), functional groups that interact with the surface of the support, and hydrophilic groups described in JP2005-238816A, JP2005-125749A, JP2006-239867A, and JP2006-215263A are also preferably used.
For example, the high-molecular-weight polymers having adsorbent groups that can be adsorbed onto the surface of the support, hydrophilic groups, and crosslinking groups described in JP2005-125749A and JP2006-188038A are more preferable.
The content of ethylenically unsaturated bonding group in the polymer used in the undercoat layer is preferably 0.1 mmol to 10.0 mmol per gram of the polymer, and more preferably 0.2 mmol to 5.5 mmol per gram of the polymer.
The weight-average molecular weight (Mw) of the polymer used in the undercoat layer is preferably 5,000 or more, and more preferably 10,000 to 300,000.

[Hydrophilic compound]

From the viewpoint of developability, it is preferable that the undercoat layer contain a hydrophilic compound.
The hydrophilic compound is not particularly limited, and known hydrophilic compounds used for the undercoat layer can be used.
Preferable examples of hydrophilic compounds include phosphonic acids having an amino group such as carboxymethyl cellulose and dextrin, an organic phosphonic acid, an organic phosphoric acid, an organic phosphinic acid, an amino acid, a hydrochloride of amine having a hydroxyl group, and the like.
In addition, preferable examples of hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of suppressing scratches and contamination, it is preferable that the hydrophilic compound include hydroxycarboxylic acid or a salt thereof.

Furthermore, from the viewpoint of suppressing scratches and contamination, it is preferable that the hydrophilic compound which is preferably hydroxycarboxylic acid or a salt thereof is contained in a layer on the aluminum support. In addition, the layer on the aluminum support is preferably a layer on the side where the image-recording layer is formed or a layer in contact with the aluminum support.

Preferable examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound which is preferably hydroxycarboxylic acid or a salt thereof.

In the lithographic printing plate precursor, from the viewpoint of suppressing scratches and contamination, it is preferable that the image-recording layer contain hydroxycarboxylic acid or a salt thereof.

Moreover, regarding the lithographic printing plate precursor, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer on the image-recording layer side that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method. Therefore, scratches and contamination are excellently suppressed.

"Hydroxycarboxylic acid" is the generic term for organic compounds having one or more carboxy groups and one or more hydroxyl groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represents a hydrogen atom, an alkali metal, or an onium, and mhc and nhc each independently represent an integer of 1 or more. In a case where n is 2 or more, $M^{HC}$'s may be the same or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like. Examples of the substituent other than a hydroxyl group and a carboxy group include an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like. Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples

thereof include an alkylene group, a substituted alkylene group, an arylene group, a substituted arylene group, and the like. The linking group may have a structure in which a plurality of these divalent groups are linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable. Examples of the onium include ammonium, phosphonium, sulfonium, and the like. Among these, ammonium is particularly preferable.

From the viewpoint of suppressing a scratches and contamination, $M^{HC}$ is preferably an alkali metal or an onium, and more preferably an alkali metal.

The total number of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or γ-hydroxybutyrate, malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of suppressing scratches and contamination, a compound having two or more hydroxyl groups is preferable, a compound having 3 or more hydroxyl groups is more preferable, a compound having 5 or more hydroxyl groups is even more preferable, and a compound having 5 to 8 hydroxyl groups is particularly preferable.

Furthermore, as a hydroxycarboxylic acid having one carboxy group and two or more hydroxyl groups, gluconic acid or shikimic acid is preferable.

As hydroxycarboxylic acid having two or more carboxy groups and one hydroxyl group, citric acid or malic acid is preferable.

As hydroxycarboxylic acid having two or more carboxy groups and two or more hydroxyl groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

In a case where the undercoat layer contains a hydrophilic compound which is preferably hydroxycarboxylic acid or a salt thereof, the content of the hydrophilic compound, preferably the content of hydroxycarboxylic acid and a salt thereof, with respect to the total mass of the undercoat layer is preferably 0.01% by mass to 50% by mass, more preferably 0.1% by mass to 40% by mass, and particularly preferably 1.0% by mass to 30% by mass.

In order to prevent contamination over time, the undercoat layer may contain a chelating agent, a secondary or tertiary amine, a polymerization inhibitor, and the like, in addition to the following compounds for an undercoat layer.

The undercoat layer is formed by known coating methods. The coating amount (solid content) of the undercoat layer is preferably 0.1 $mg/m^2$ to 100 $mg/m^2$, and more preferably 1 $mg/m^2$ to 30 $mg/m^2$.

<Protective layer>

The lithographic printing plate precursor may have a protective layer (also called "overcoat layer" in some cases) on the image-recording layer side. The protective layer may have a function of suppressing the reaction inhibiting image formation by blocking oxygen and a function of preventing the damage of the image-recording layer and preventing ablation during exposure to high-illuminance lasers.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected and used. If necessary, two or more kinds of such polymers can be used by being mixed together. Specifically, examples of such polymers include polyvinyl alcohol, modified polyvinyl alcohol, polyvinylpyrrolidone, a water-soluble cellulose derivative, poly(meth)acrylonitrile, and the like.

As the modified polyvinyl alcohol, acid-modified polyvinyl alcohol having a carboxy group or a sulfo group is preferably used. Specific examples thereof include modified-polyvinyl alcohols described in JP2005-250216A and JP2006-259137A.

In order to improve oxygen barrier properties, it is preferable that the protective layer contain an inorganic lamellar

compound. The inorganic lamellar compound refers to particles in the form of a thin flat plate, and examples thereof include mica groups such as natural mica and synthetic mica, talc represented by Formula 3MgO·4SiO·H2O, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica groups, examples of natural mica include white mica, soda mica, gold mica, black mica, and lepidolite. Examples of synthetic mica include non-swelling mica such as fluorphlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})$F2, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the aforementioned mica compounds, fluorine-based swelling mica is particularly useful. That is, swelling synthetic mica has a laminated structure consisting of unit crystal lattice layers having a thickness in a range of approximately 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and active light ray-transmitting property of coated surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from projection views obtained from the microphotograph of the particle. The higher the aspect ratio is, the stronger the obtained effect is.

Regarding the particle diameter of the mica compound, the average long diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, in the case of swelling synthetic mica which is a typical compound, an aspect is preferable in which the compound has a thickness of about 1 nm to 50 nm and a surface size (long diameter) of about 1 μm to 20 μm.

The content of the inorganic lamellar compound with respect to the total solid content of the protective layer is preferably 1% by mass to 60% by mass, and more preferably 3% by mass to 50% by mass. Even in a case where two or more kinds of inorganic lamellar compounds are used in combination, the total amount of the inorganic lamellar compounds preferable equals the content described above. In a case where the content is within the above range, the oxygen barrier properties are improved, and excellent sensitivity is obtained. In addition, the deterioration of receptivity can be prevented.

The protective layer may contain known additives such as a plasticizer for imparting flexibility, a surfactant for improving coating properties, and inorganic particles for controlling surface slipperiness. In addition, the oil sensitizing agent described above regarding the image-recording layer may be incorporated into the protective layer.

The protective layer is formed by known coating methods. The coating amount of the protective layer (solid content) is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.

(Method for preparing lithographic printing plate and lithographic printing method)

It is possible to prepare a lithographic printing plate by performing image exposure and a development treatment on the lithographic printing plate precursor.

The method for preparing a lithographic printing plate according to the present inventionincludes a step of exposing the lithographic printing plate precursor according to the present invention in the shape of an image (hereinafter, this step will be also called "exposure step") and a step of removing the image-recording layer in a non-image area on a printer by supplying at least one material selected from the group consisting of printing ink and dampening water (hereinafter, this step will be also called "on-press development step").

The lithographic printing method described herein preferably includes a step of exposing the lithographic printing plate precursor in the shape of an image (exposure step), a step of removing the image-recording layer in a non-image area on a printer by supplying at least one material selected from the group consisting of printing ink and dampening water so that a lithographic printing plate is prepared (on-press development step), and a step of performing printing by using the

obtained lithographic printing plate (printing step).

Hereinafter, regarding the method for preparing a lithographic printing plate according to the present invention and the lithographic printing method, preferred aspects of each step will be described in order. Note that the lithographic printing plate precursor according to the present invention can also be developed using a developer.

Hereinafter, the exposure step and the on-press development step in the method for preparing a lithographic printing plate will be described. The exposure step in the method for preparing a lithographic printing plate according to the present inventionis the same step as the exposure step in the lithographic printing method. Furthermore, the on-press development step in the method for preparing a lithographic printing plate according to the present invention is the same step as the on-press development step in the lithographic printing method.

Furthermore, presumably, a part of the outermost layer may be removed during on-press development, and a part of the outermost layer may remain on the surface of the image area or permeate the inside of the image area by a printing ink.

In the method for preparing a lithographic printing plate according to the present invention or the lithographic printing method, from the viewpoint of on-press developability and receptivity, in the lithographic printing plate precursor, a contact angle of an airborne water droplet on a surface of the outermost layer on the image-recording layer side after the exposure is preferably larger than a water contact angle of an airborne water droplet on the surface of the outermost layer on the image-recording layer side before the exposure, and more preferably at least 10° larger than a water contact angle of an airborne water droplet on the surface of the outermost on the image-recording layer side layer before the exposure.

The contact angle of an airborne water droplet on a surface of the outermost layer of the lithographic printing plate precursor on the image-recording layer side before and after exposure is measured by an airborne water droplet method by using DM-501 manufactured by Kyowa Interface Science Co., Ltd., as a contact angle of a water droplet on the surface at 25°C (after 0.2 seconds).

<Exposure step>

The method for preparing a lithographic printing plate according to the present invention includes an exposure step of exposing the lithographic printing plate precursor according to the present invention in the shape of an image so that an exposed portion and a non-exposed portion are formed. The lithographic printing plate precursor according to the present invention is preferably exposed to a laser through a transparent original picture having a linear image, a halftone dot image, or the like or exposed in the shape of an image by laser light scanning according to digital data or the like.

The wavelength of a light source to be used in preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or higher, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any one of an in-plane drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method for preparing a lithographic printing plate according to the present inventionincludes an on-press development step of removing the image-recording layer in a non-image area on a printer by supplying at least one selected from the group consisting of printing ink and dampening water.

Hereinafter, the on-press development method will be described.

[On-press development method]

In the on-press development method, the lithographic printing plate precursor having undergone image exposure is preferably supplied with an oil-based ink and an aqueous component on a printer, so that the image-recording layer in a non-image area is removed and a lithographic printing plate is prepared.

That is, in a case where the lithographic printing plate precursor is subjected to image exposure and then directly mounted on a printer without being subjected to any development treatment, or in a case where the lithographic printing plate precursor is mounted on a printer, then subjected to image exposure on the printer, and then supplied with an oil-based ink and an aqueous component for printing, at the initial stage in the middle of printing, in a non-image area, a non-cured image-recording layer is removed by either or both of the supplied oil-based ink and the aqueous component by means of dissolution or dispersion, and the hydrophilic surface is exposed in the non-image area. On the other hand, in an

exposed portion, the image-recording layer cured by exposure forms an oil-based ink-receiving portion having a lipophilic surface. Any of the oil-based ink and the aqueous component may be supplied first to the surface of the plate. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

As the laser used for performing image exposure on the lithographic printing plate precursor, a light source having a wavelength of 300 nm to 450 nm or 750 nm to 1,400 nm is preferably used. A light source having a wavelength of 300 nm to 450 nm is preferable for a lithographic printing plate precursor including an image-recording layer containing sensitizing dye having maximum absorption in such a wavelength region. The light source having a wavelength of 750 nm to 1,400 nm is preferable for the aforementioned lithographic printing plate precursor. As the light source having a wavelength of 300 nm to 450 nm, a semiconductor laser is suitable.

<Development step using developer>

The method for preparing a lithographic printing plate may be a method including a step of exposing the lithographic printing plate precursor in the shape of an image and a step of preparing a lithographic printing plate by removing the image-recording layer in a non-image area by using a developer (also called "development step using a developer)".

Furthermore, the lithographic printing method may be a method including a step of exposing the lithographic printing plate precursor in the shape of an image, a step of preparing a lithographic printing plate by removing the image-recording layer in a non-image area by using a developer, and a step of performing printing by using the obtained lithographic printing plate.

As the developer, known developers can be used.

The pH of the developer is not particularly limited, and the developer may be a strongly alkaline developer. Preferable examples of the developer include a developer having a pH of 2 to 11. Preferable examples of the developer having a pH of 2 to 11 include a developer containing at least one kind of component among surfactants and water-soluble polymer compounds.

Examples of the development treatment using a strongly alkaline developer include a method of removing the protective layer by a pre-rinsing step, then performing development using an alkali, rinsing and removing the alkali by a post-rinsing step, performing a gum solution treatment, and performing drying by a drying step.

In a case where the aforementioned developer containing a surfactant or a water-soluble polymer compound is used, development and the gum solution treatment can be simultaneously performed. As a result, the post-rinsing step is unnecessary, and it is possible to perform both the development and gum solution treatment by using one solution and to subsequently perform the drying step. Furthermore, because the removal of the protective layer can be performed simultaneously with the development and the gum solution treatment, the pre-rinsing step is unnecessary as well. After the development treatment, it is preferable to remove an excess of developer by using a squeeze roller or the like and to subsequently perform drying.

<Printing step>

The lithographic printing method includes a printing step of printing a recording medium by supplying printing ink to the lithographic printing plate.

The printing ink is not particularly limited, and various known inks can be used as desired. In addition, preferable examples of the printing ink include oil-based ink or ultraviolet-curable ink (UV ink).

In the printing step, if necessary, dampening water may be supplied.

Furthermore, the printing step may be successively carried out after the on-press development step or the development step using a developer, without stopping the printer.

The recording medium is not particularly limited, and known recording media can be used as desired.

In the method for preparing a lithographic printing plate from the lithographic printing plate precursor and in the lithographic printing method, if necessary, the entire surface of the lithographic printing plate precursor may be heated as necessary before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, stabilization of sensitivity, and the like. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a

case where this aspect is adopted, a sufficient image-strengthening action is obtained, and it is possible to inhibit problems such as the deterioration of the support or the thermal decomposition of the image area.

Examples

Hereinafter, the present invention will be specifically described based on examples, but the present invention is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value measured by gel permeation chromatography (GPC) and expressed in terms of polystyrene. In addition, unless otherwise specified, the average particle diameter means a volume average particle diameter.

In the examples, the values of capacitance Cp (0 seconds) to Cp (20 seconds) of the lithographic printing plate precursor, the value of δp in the Hansen solubility parameters, HOMO and LUMO of the infrared absorber, LUMO of the electron-accepting polymerization initiator, HOMO of the electron-donating polymerization initiator, the average diameter of micropores, the value of L* of the anodic oxide film, and the values of contact angle of an airborne water droplet on a surface of the outermost layer of the lithographic printing plate precursor on the image-recording layer side before and after exposure were measured by the methods described above.

<Preparation of support>

<<Surface Treatment A>>

[Support having large diameter portion and small diameter portion]

(A-a) Alkaline etching treatment

From a spray tube, an aqueous solution of caustic soda having a caustic soda (sodium hydroxide) concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 1.0 g/m$^2$.

(A-b) Desmutting treatment in aqueous acidic solution (first desmutting treatment)

Next, a desmutting treatment was performed in an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the desmutting liquid. Then, a rinsing treatment was performed.

(A-c) Electrochemical roughening treatment in aqueous hydrochloric acid solution

Next, an electrolytic roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride. The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/dm$^2$ in terms of the peak current value of the alternating current waveform. In addition, the quantity of electricity was 450 C/dm$^2$ which is the total quantity of electricity used for the aluminum plate to have an anodic reaction, and the electrolysis treatment was performed 4 times by conducting electricity of 125 C/dm$^2$ for 4 seconds at each treatment session. A carbon electrode was used as the counter electrode of the aluminum plate. Then, a rinsing treatment was performed.

(A-d) Alkaline etching treatment

From a spray tube, an aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/m$^2$. Then, a

rinsing treatment was performed.

(A-e) Desmutting treatment in aqueous acidic solution

Next, a desmutting treatment was performed in an aqueous acidic solution. In the desmutting treatment, a waste liquid generated in the anodic oxidation treatment step (170 g/L aqueous sulfuric acid solution containing dissolved aluminum ions at 5.0 g/L) was used as an aqueous acidic solution. The liquid temperature was 30°C. The desmutting treatment was performed for 3 seconds by spraying the desmutting liquid.

(A-f) First-stage anodic oxidation treatment

By using the anodic oxidation device for direct current electrolysis having the structure shown in Fig. 5, a first-stage anodic oxidation treatment was performed. The anodic oxidation treatment was performed under the conditions shown in Table 1, thereby forming an anodic oxide film having a predetermined film thickness.

(A-g) Pore widening treatment

The aluminum plate having undergone the above anodic oxidation treatment was immersed in an aqueous solution of caustic soda at a temperature of 35°C and having a caustic soda concentration of 5% by mass and an aluminum ion concentration of 0.5% by mass under the conditions shown in Table 1, thereby performing a pore widening treatment. Then, rinsing was performed by means of spraying.

(A-h) Second-stage anodic oxidation treatment

By using the anodic oxidation device for direct current electrolysis having the structure shown in Fig. 5, a second-stage anodic oxidation treatment was performed. The anodic oxidation treatment was performed under the conditions shown in Table 1, thereby forming an anodic oxide film having a predetermined film thickness.

By the above surface treatment A, the support S1 of the example was obtained.

Table 2 shows the average diameter (nm) of the large diameter portion within the surface of the anodic oxide film having micropores obtained after the second anodic oxidation treatment step, the average diameter (nm) of the small diameter portion at a communication position, the depth (nm) of the large diameter portion and the small diameter portion, the pit density (micropore density, unit; number of micropores/$\mu m^2$), and the thickness (nm) of the anodic oxide film from the bottom portion of the small diameter portion to the surface of the aluminum plate.

The average diameter of the micropores (average diameter of the large diameter portion and the small diameter portion) is a value obtained by observing the surface of the large diameter portion and the surface of the small diameter portion with FE-SEM at a 150,000X magnification (N= 4), and measuring the diameters of the micropores (large diameter portion and small diameter portion) in a range of 400 nm $\times$ 600 nm in the obtained 4 images, and calculating the average thereof. In a case where the large diameter portion was deep, it was difficult to measure the diameter of the small diameter portion, and the diameter of an enlarged portion in the small diameter portion needed to be measured, the upper portion of the anodic oxide film was cut, and then various diameters were calculated.

The depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000X magnification), measuring the depths of 25 random micropores in the obtained image, and calculating the average thereof.

In Table 1, Film amount (AD) in the column of First anodic oxidation treatment and Film amount (AD) in the column of Second anodic oxidation treatment represent the amount of film obtained by each treatment. As electrolytic solutions, the aqueous solutions containing the components in Table 1 were used.

<<Surface treatment B>>

[Support having large diameter portion]

(B-a) Alkaline etching treatment

An aqueous solution of caustic soda having a caustic soda concentration of 26% by mass and an aluminum ion concentration of 6.5% by mass was sprayed onto the aluminum plate from a spray tube at a temperature of 70°C, thereby performing an etching treatment. Then, rinsing was performed by means of spraying. The amount of dissolved aluminum within the surface to be subjected to the electrochemical roughening treatment later was 1.0 g/$m^2$.

(B-b) Desmutting treatment in aqueous acidic solution (first desmutting treatment)

Next, a desmutting treatment was performed in an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the desmutting liquid. Then, a rinsing treatment was performed.

(B-c) Electrochemical roughening treatment in aqueous hydrochloric acid solution

Next, an electrolytic roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/$dm^2$ which is the total quantity of electricity used for the aluminum plate to have an anodic reaction, and the electrolysis treatment was performed 4 times by conducting electricity of 125 C/$dm^2$ for 4 seconds at each treatment session. A carbon electrode was used as the counter electrode of the aluminum plate. Then, a rinsing treatment was performed.

(B-d) Alkaline etching treatment

From a spray tube, an aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/$m^2$. Then, a rinsing treatment was performed.

(B-e) Desmutting treatment in aqueous acidic solution

Next, a desmutting treatment was performed in an aqueous acidic solution. In the desmutting treatment, a waste liquid generated in the anodic oxidation treatment step (170 g/L aqueous sulfuric acid solution containing dissolved aluminum ions at 5.0 g/L) was used as an aqueous acidic solution. The liquid temperature was 30°C. The desmutting treatment was performed for 3 seconds by spraying the desmutting liquid.

(B-f) First anodic oxidation treatment

By using the anodic oxidation device for direct current electrolysis having the structure shown in Fig. 5, a first-stage anodic oxidation treatment was performed. The anodic oxidation treatment was performed under the conditions shown in Table 1, thereby forming an anodic oxide film having a predetermined film thickness.

(B-g) Pore widening treatment

The aluminum plate having undergone the above anodic oxidation treatment was immersed in an aqueous solution of caustic soda at a temperature of 35°C and having a caustic soda concentration of 5% by mass and an aluminum ion concentration of 0.5% by mass under the conditions shown in Table 1, thereby performing a pore widening treatment. Then, rinsing was performed by means of spraying.

By the above surface treatment B, a support S2 of the example was obtained. Details of the obtained support S2 are summarized in Table 2.

[Table 1]

| | Support | Surface treatment | First anodic oxidation treatment | | | | | | | Pore widening treatment | | |
|---|---|---|---|---|---|---|---|---|---|---|---|---|
| | | | Liquid type | Liquid component | Component concentration (g/L) | Temperature (°C) | Current density (Å/$dm^2$) | Time (s) | Film amount (g/$m^2$) | Liquid component | Temperature (°C) | Time (s) |
| Example | Support S1 | A | Phosphoric acid | $H_3PO_4$ | 15 | 35 | 4.5 | 12 | 1.0 | NaOH 5%/Al 0.5% | 40 | 3 |
| Example | Support S2 | B | Sulfuric acid | $H_2SO_4$/Al | 170/5 | *50* | 30 | 18 | 2.4 | NaOH 5%/Al 0.5% | 40 | 3 |

| | Support | Surface treatment | Second anodic oxidation treatment | | | | | | |
|---|---|---|---|---|---|---|---|---|---|
| | | | Liquid type | Liquid component | Component concentration (g/L) | Temperature (°C) | Current density (Å/dm$^2$) | Time (s) | Film amount (g/m$^2$) |
| Example | Support S1 | A | Sulfuric acid | $H_2SO_4$/Al | 170/5 | *50* | 15 | 10.5 | 1.4 |
| Example | Support S2 | B | - | - | - | - | - | - | - |

[Table 2]

| | Support | Surface treatment | Large diameter portion | | | | Small diameter portion | | | Micropore density (number µm$^2$) | Film thickness (nm) |
|---|---|---|---|---|---|---|---|---|---|---|---|
| | | | Average diameter (nm) | Average diameter of bottom portion (nm) | Shape | Depth (nm) | Pore diameter of communication position (nm) | Shape | Depth (nm) | | |
| Example | Support S1 | A | 35 | 35 | Straight tubular | 100 | 10 | Straight tubular | 570 | 320 | 1,000 |
| Example | Support S2 | B | 25 | 25 | Straight tubular | 980 | - | - | - | 500 | 1,000 |

In the following examples and comparative examples, the obtained support S1 was used as a support A, and the obtained support S2 was used as a support C.

Furthermore, a support was prepared by the same method as the support S1, except that the liquid component of the first anodic oxidation treatment used in the preparation of the support S1 was changed to $H_2SO_4$. The prepared support was used as a support B.

(Examples 1 to 33 and Comparative Examples 1 to 3)

<Preparation of lithographic printing plate precursor>

The lithographic printing plate precursors of Examples 1 to 33 and Comparative Examples 1 to 3 were prepared by the following method.

The aluminum support described in Table 4 or Table 6 was coated with the following coating solution an undercoat layer so that the dry coating amount was 20 mg/$m^2$, thereby forming an undercoat layer. The undercoat layer was bar-coated with the following coating solution (1) for an image-recording layer and dried in an oven at 120°C for 40 seconds, thereby forming an image-recording layer having a dry coating amount of 1.0 g/$m^2$.

Regarding the lithographic printing plate precursor having a protective layer (described as "Non-outermost layer (with OC)" in the column of "Position of image-recording layer" in Table 3 or Table 5), the image-recording layer was bar-coated with the following coating solution for a protective layer and dried in an oven at 120°C for 60 seconds so that a protective layer having a dry coating amount of 0.15 g/$m^2$ was formed.

<Preparation of coating solution for undercoat layer>

The coating solution for an undercoat layer having the following composition was prepared.

(Coating solution for undercoat layer)

·Polymer (UC-1) (shown below): 0.18 parts by mass
·Hydroxyethyl iminodiacetic acid: 0.10 parts by mass
·Water: 61.4 parts by mass

(UC-1)

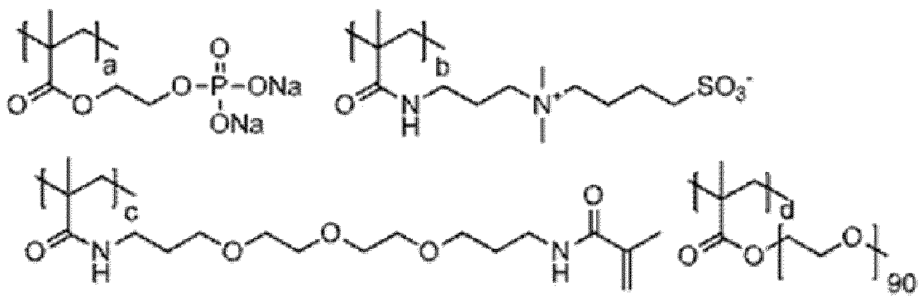

a / b / c / d = 14.2 / 71.8 / 9.0 / 5.0 (% by mass)
a / b / c / d = 19.0 / 72.8 / 7.8 / 0.4 (mol%)

Mass-average moleular weight = 200,000

<Preparation of coating solution for protective layer>

A coating solution for a protective layer having the following composition was prepared.

(Coating solution for protective layer)

·6% by mass aqueous solution of polyvinyl alcohol (CKS50 manufactured by NIHON GOSEI KAKO Co., Ltd., modified with sulfonic acid, saponification degree: 99 mol% or higher, degree of polymerization: 300): 0.55 parts by mass
·6% by mass aqueous solution of polyvinyl alcohol (PVA-405, manufactured by KURARAY CO., LTD., saponification degree: 81.5 mol%, degree of polymerization: 500): 0.03 parts by mass
·1% by mass aqueous solution of surfactant (polyoxyethylene lauryl ether, EMALEX 710 (registered trademark), manufactured by NIHON EMULSION Co., Ltd.): 0.86 parts by mass
·Deionized water: 6.0 parts by mass

<Coating solution (1) for image-recording layer>

·Addition polymerization-type resin shown in Table 3 or Table 5: 0.240 parts by mass (added amount was adjusted in Example 6.)
·Infrared absorber having counteranion shown in Table 4 or Table 6: 0.024 parts by mass.
·Electron-accepting polymerization initiator having counteranion shown in Table 4 or Table 6: 0.150 parts by mass.
·Electron-donating polymerization initiator D-1: 0.05 parts by mass
·Polymerizable compound shown in Table 4 or Table 6: 0.192 parts by mass (added amount was adjusted in Example 19.)

·Fluorine-based surfactant W-1 (shown below): 0.008 parts by mass
·Color developing agent shown in Table 4 or Table 6: 0.060 parts by mass
·2-Butanone: 1.091 parts by mass
·1-Methoxy-2-propanol: 8.609 parts by mass
·Distilled water: 2.425 parts by mass
·Compound satisfying $\delta p$ = 2.4 to 14 in the Hansen solubility parameters shown in Table 3 or Table 5 (specific polar compound): amount in image-recording layer to be obtained shown in Table 3 or Table 5

Electron-donating polymerization initiator D-1: compound having the following structure

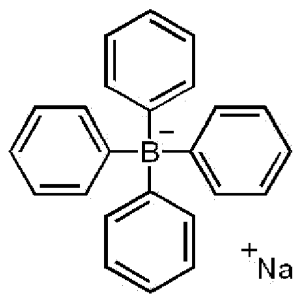

D - 1

·Fluorine-based surfactant W-1: compound having the following structure

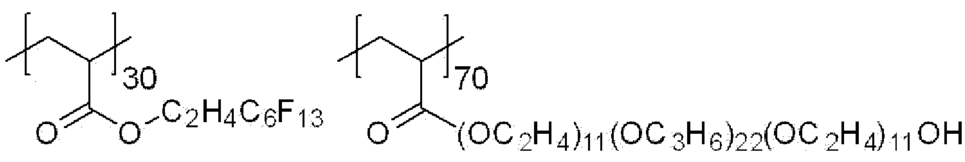

W - 1
Mw = 13,000

In the above structures of polymer compounds, the subscript at the right lower side in the parentheses of each constitutional unit represents the content ratio (mass ratio).

<Evaluation>

[Ink receptivity]

Each of the lithographic printing plate precursors obtained in examples or comparative examples was placed in Kodak (registered trademark) Trendsetter 800II Quantum plate setter (830 nm), and exposed to an 830 nm infrared (IR) laser in the shape of an exposure image including a solid image and a 50% halftone dot chart of a 20 μm dot FM screen. The obtained precursor having undergone exposure was mounted on a plate cylinder of a printer LITHRONE26 manufactured by KOMORI Corporation, without being subjected to a development treatment. By using dampening water containing Ecolity-2 (manufactured by FUJIFILM Corporation)/tap water = 2/98 (volume ratio)) and SPACE COLOR FUSION G black ink (manufactured by DIC Graphics Corporation), on-press development was performed by supplying the dampening water and ink according to the standard automatic printing start method of LITHRONE26. Thereafter, printing was performed on 100 sheets of TOKUBISHI art paper (manufactured by MITSUBISHI PAPER MILLS LIMITED., ream weight: 76.5 kg) at a printing rate of 10,000 sheets/hour.
The number of sheets of printing paper used until the ink density on the printing paper in the exposed area of the image-recording layer reached the preset standard density was counted as ink receptivity in early stage of printing, and listed in Table 4 or Table 6.

[On-press developability]

In Luxel PLATESETTER T-6000III manufactured by FUJIFILM Corporation that was equipped with an infrared semiconductor laser, each of the lithographic printing plate precursors of examples or comparative examples was exposed under the conditions of outer drum rotation speed of 1,000 rpm (revolutions per minute), a laser output of 70%, and resolution of 2,400 dpi (dot per inch, 1 inch = 2.54 mm). The exposure image included a solid image and a 50% halftone dot chart of a 20 μm dot FM screen.
The obtained precursor having undergone exposure was mounted on a plate cylinder of a printer LITHRONE26 manufactured by KOMORI Corporation, without being subjected to a development treatment. By using dampening water containing Ecolity-2 (manufactured by FUJIFILM Corporation)/tap water = 2/98 (volume ratio)) and SPACE COLOR FUSION G black ink (manufactured by DIC Graphics Corporation), on-press development was performed by supplying the dampening water and ink according to the standard automatic printing start method of LITHRONE26. Thereafter, printing was performed on 500 sheets of TOKUBISHI art paper (manufactured by MITSUBISHI PAPER MILLS LIMITED., ream weight: 76.5 kg) at a printing rate of 10,000 sheets/hour.
The number of sheets of printing paper used until no ink was transferred to a non-image area after the on-press development of the non-exposed portion of the image-recording layer on the printer was finished was counted as on-press developability, and listed in Table 4 or Table 6.

[Visibility (color developability)]

In Trendsetter 3244VX manufactured by Creo that was equipped with a water cooling-type 40 W infrared semiconductor laser, each of the lithographic printing plate precursors of examples or comparative examples was exposed under the conditions of an output of 11.5 W, an outer drum rotation speed of 220 rpm, and a resolution of 2,400 dpi (dot per inch, 1 inch = 25.4 mm). The exposure was carried out in an environment of 25°C and 50% RH.
The color development of the lithographic printing plate precursor was measured immediately after the exposure and after 2 hours of storage in a dark place (25°C) after exposure. The measurement was performed by the specular component excluded (SCE) method by using a spectrocolorimeter CM2600d and operation software CM-S100W manufactured by Konica Minolt, Inc. The color developability was evaluated by a difference ΔL between an L* value of the exposed portion and an L* value of the non-exposed portion by using L* values (brightness) of the L*a*b* color space. The higher the value of ΔL, the better the color developability. The evaluation results are shown in Table 4 or Table 6.

[Suppression of residues of on-press development]

By using Magnus 800 Quantum (platesetter) manufactured by Kodak Japan Ltd. that was equipped with an infrared semiconductor laser, the prepared lithographic printing plate precursor was exposed under the conditions of output of 27 W, an outer drum rotation speed of 450 rpm, and a resolution of 2,400 dpi (irradiation energy equivalent to 110 $mJ/cm^2$).
The exposure image included a solid image and an amplitude modulation screen (AM screen) as a 3% halftone dot chart.
The obtained exposed precursor was mounted on a Kikuban-sized (636 mm × 939 mm) cylinder of a printer

SX-74 manufactured by Heidelberger Druckmaschinen AG without being developed. This printer was connected to a 100 L-capacity dampening water circulation tank having a non-woven fabric filter and a temperature control device. A circulation device was filled with 80 L of dampening water containing 2.0% by mass of dampening water S-Z1 (manufactured by FUJIFILM Corporation), and an ultraviolet-curable ink T&K UV OFS K-HS black GE-M (manufactured by T&K TOKA CO., LTD.) was used as printing ink. The dampening water and ink were supplied by a standard automatic printing start method, and then printing was performed TOKUBISHI art paper (ream weight: 76.5 kg, manufactured by MITSUBISHI PAPER MILLS LIMITED.) at a printing rate of 10,000 sheets/hour. As soon as 50,000 sheets were printed, the state where the removed residues adhered to the dampening roller was evaluated. The evaluation standard is as follows. The evaluation results are described in Table 7.

5: No residue is found on the dampening roller.
4: Few residues are found on the dampening roller.
3: Residues are found on the dampening roller.
2: Many residues are found on the dampening roller.
1: There are so many residues found on the dampening roller.

[Table 3]

| | Time taken for satisfying Cp (t)/Cp (20 seconds) = 0.95 t (second) | Cp (0 seconds) (nf) | Position of image-recording layer | Addition polymerization-type resin | | | | | Compound satisfying δp = 2.4 to 14 in Hansen solubility parameters | | | | | |
|---|---|---|---|---|---|---|---|---|---|---|---|---|---|---|
| | | | | Type | Shape | Dispersible group: presence or absence of -Q-W-Y | Structure having dispersible group | Content ($mg/m^2$) | Type | δp ($MPa^{0.5}$) | Molecular weight | Presence or absence of hydrophilic group | Structure of hydrophilic group | Content ($mg/m^2$) |
| Example 1 | t = 6 seconds | 700 | Outermost layer | P-1 | Non-particle | Present | PEO | 200 | A-1 | 3.9 | 380 | Present | Sulfo group | 30 |
| Example 2 | t = 6 seconds | *500* | Outermost layer | P-1 | Non-particle | Present | PEO | 200 | A-1 | 3.9 | 380 | Present | Sulfo group | 3 |
| Example 3 | t = 6 seconds | 700 | Outermost layer | P-2 | Particle | Present | PEO | 200 | A-1 | 3.9 | 380 | Present | Sulfo group | 30 |
| Example 4 | t = 6 seconds | 700 | Non-outermost layer (with OC) | P-1 | Non-particle | Present | PEO | 200 | A-1 | 3.9 | 380 | Present | Sulfo group | 30 |
| Example 5 | t = 6 seconds | 700 | Outermost layer | P-3 | Non-particle | Present | PEO | 200 | A-1 | 3.9 | 380 | Present | Sulfo group | 30 |
| Example 6 | t = 6 seconds | 700 | Outermost layer | P-1 | Non-particle | Present | PEO | 100 | A-1 | 3.9 | 380 | Present | Sulfo group | 30 |
| Example 7 | t = 4 seconds | 800 | Outermost layer | P-1 | Non-particle | Present | PEO | 200 | A-2 | 9.8 | 270 | Present | Phosphoric acid group and carboxy group | 30 |
| Example 8 | t = 10 seconds | *500* | Outermost layer | P-1 | Non-particle | Present | PEO | 200 | A-3 | 0.98 | 380 | Absent | - | 30 |
| Example 9 | t = 9 seconds | 600 | Outermost layer | P-1 | Non-particle | Present | PEO | 200 | A-4 | 2.9 | 6,000 | Present | Hydroxyl group | 30 |
| Example 10 | t = 6 seconds | 700 | Outermost layer | P-4 | Non-particle | Absent | Sulfonate group | 200 | A-1 | 3.9 | 380 | Present | Sulfo group | 30 |
| Example 11 | t = 8 seconds | 600 | Outermost layer | P-5 | Non-particle | Absent | Alkyl group | 200 | A-1 | 3.9 | 380 | Present | Sulfo group | 30 |

(continued)

| | Time taken for satisfying Cp (t)/Cp (20 seconds) = 0.95 t (second) | Cp (0 seconds) (nf) | Position of image-recording layer | Addition polymerization-type resin | | | | | Compound satisfying δp = 2.4 to 14 in Hansen solubility parameters | | | | | |
|---|---|---|---|---|---|---|---|---|---|---|---|---|---|---|
| | | | | Type | Shape | Dispersible group: presence or absence of -Q-W-Y | Structure having dispersible group | Content ($mg/m^2$) | Type | δp ($MPa^{0.5}$) | Molecular weight | Presence or absence of hydrophilic group | Structure of hydrophilic group | Content ($mg/m^2$) |
| Example 12 | t = 6 seconds | 700 | Outermost layer | P-1 | Non-particle | Present | PEO | 200 | A-1 | 3.9 | 380 | Present | Sulfo group | 30 |
| Example 13 | t = 6 seconds | 700 | Outermost layer | P-1 | Non-particle | Present | PEO | 200 | A-1 | 3.9 | 380 | Present | Sulfo group | 30 |
| Example 14 | t = 6 seconds | 700 | Outermost layer | P-1 | Non-particle | Present | PEO | 200 | A-1 | 3.9 | 380 | Present | Sulfo group | 30 |
| Example 15 | t = 6 seconds | 700 | Outermost layer | P-1 | Non-particle | Present | PEO | 200 | A-1 | 3.9 | 380 | Present | Sulfo group | 30 |
| Example 16 | t = 6 seconds | 700 | Outermost layer | P-1 | Non-particle | Present | PEO | 200 | A-1 | 3.9 | 380 | Present | Sulfo group | 30 |
| Example 17 | t = 6 seconds | 700 | Outermost layer | P-1 | Non-particle | Present | PEO | 200 | A-1 | 3.9 | 380 | Present | Sulfo group | 30 |
| Example 18 | t = 6 seconds | 700 | Outermost layer | P-1 | Non-particle | Present | PEO | 200 | A-1 | 3.9 | 380 | Present | Sulfo group | 30 |
| Example 19 | t = 6 seconds | 700 | Outermost layer | P-1 | Non-particle | Present | PEO | 200 | A-1 | 3.9 | 380 | Present | Sulfo group | 30 |
| Example 20 | t = 6 seconds | 700 | Outermost layer | P-1 | Non-particle | Present | PEO | 200 | A-1 | 3.9 | 380 | Present | Sulfo group | 30 |
| Example 21 | t = 6 seconds | 700 | Outermost layer | P-1 | Non-particle | Present | PEO | 200 | A-1 | 3.9 | 380 | Present | Sulfo group | 30 |
| Example 22 | t = 9 seconds | *500* | Outermost layer | P-2 | Particle | Present | PEO | 200 | A-4 | 2.9 | 10,000 | Present | Hydroxyl group | 30 |
| Comparative Example 1 | t = 15 seconds | 200 | Outermost layer | P-1 | Non-particle | Present | PEO | 200 | - | - | - | - | - | - |

(continued)

| | Time taken for satisfying Cp (t)/Cp (20 seconds) = 0.95 t (second) | Cp (0 seconds) (nf) | Position of image-recording layer | Addition polymerization-type resin | | | | | Compound satisfying δp = 2.4 to 14 in Hansen solubility parameters | | | | | |
|---|---|---|---|---|---|---|---|---|---|---|---|---|---|---|
| | | | | Type | Shape | Dispersible group: presence or absence of -Q-W-Y | Structure having dispersible group | Content (mg/m$^2$) | Type | δp (MPa$^{0.5}$) | Molecular weight | Presence or absence of hydrophilic group | Structure of hydrophilic group | Content (mg/m$^2$) |
| Comparative Example 2 | t = 14 seconds | 300 | Outermost layer | P-2 | Particle | Present | PEO | 200 | A-4 | 2.9 | 10,000 | Present | Hydroxyl group | 10 |
| Comparative Example 3 | t = 14 seconds | 300 | Non-outermost layer with OC) | - | N/A | - | - | - | A-4 | 2.9 | 10,000 | Present | Hydroxyl group | 10 |

[Table 4]

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content ($mg/m^2$) | Type | Average diameter of micropores and L*value | Large diameter portion and small diameter portion | | Receptivity | On-press developability |
| Example 1 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 5 |
| Example 2 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 3 |
| Example 3 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 5 |
| Example 4 | 0.7 eV or less | 0.7 eV or less | G-1 | An-1 | An-3 | M-1 | 300 | Support A | 15 mm, L* value = 80 | Formed of large diameter portion and small diameter portion | 0° or more and 10° or less | 3 | 5 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content (mg/m$^2$) | Type | Average diameter of micropores and L*value | Large diameter portion and small diameter portion | | Receptivity | On-press developability |
| Example 5 | 0.7 eV or less | 0.7 eV or less | G-1 | An-1 | An-3 | M-1 | 300 | Support A | 15 mm, L* value = 80 | Formed of large diameter portion and small diameter portion | > 10° | 3 | 5 |
| Example 6 | 0.7 eV or less | 0.7 eV or less | G-1 | An-1 | An-3 | M-1 | 300 | Support A | 15 mm, L* value = 80 | Formed of large diameter portion and small diameter portion | > 10° | 4 | 5 |
| Example 7 | 0.7 eV or less | 0.7 eV or less | G-1 | An-1 | An-3 | M-1 | 300 | Support A | 15 mm, L* value = 80 | Formed of large diameter portion and small diameter portion | > 10° | 4 | 5 |
| Example 8 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 2 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content ($mg/m^2$) | Type | Average diameter of micropores and L*value | Large diameter portion and small diameter portion | | Receptivity | On-press developability |
| Example 9 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 4 |
| Example 10 | 0.7 eV or less | 0.7 eV or less | G-1 | An-1 | An-3 | M-1 | 300 | Support A | 15 mm, L* value = 80 | Formed of large diameter portion and small diameter portion | 0° or more and 10° or less | 3 | 5 |
| Example 11 | 0.7 eV or less | 0.7 eV or less | G-1 | An-1 | An-3 | M-1 | 300 | Support A | 15 mm, L* value = 80 | Formed of large diameter portion and small diameter portion | > 10° | 5 | 4 |
| Example 12 | 1eV | 0.7 eV or less | G-1 | An-1 | An-3 | M-1 | 300 | Support A | 15 mm, L* value = 80 | Formed of large diameter portion and small diameter portion | > 10° | 5 | 5 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content ($mg/m^2$) | Type | Average diameter of micropores and L*value | Large diameter portion and small diameter portion | | Receptivity | On-press developability |
| Example 13 | 0.7 eV or less | 1eV | G-1 | An-1 | An-3 | M-1 | 300 | Support A | 15 mm, L* value = 80 | Formed of large diameter portion and small diameter portion | > 10° | 5 | 5 |
| Example 14 | 0.7 eV or less | 0.7 eV or less | - | An-1 | An-3 | M-1 | 300 | Support A | 15 mm, L* value = 80 | Formed of large diameter portion and small diameter portion | > 10° | 5 | 5 |
| Example 15 | 0.7 eV or less | 0.7 eV or less | G-2 | An-1 | An-3 | M-1 | 300 | Support A | 15 mm, L* value = 80 | Formed of large diameter portion and small diameter portion | > 10° | 5 | 5 |
| Example 16 | 0.7 eV or less | 0.7 eV or less | G-1 | An-2 | An-3 | M-1 | 300 | Support A | 15 mm, L* value = 80 | Formed of large diameter portion and small diameter portion | > 10° | 5 | 5 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content ($mg/m^2$) | Type | Average diameter of micropores and L*value | Large diameter portion and small diameter portion | | Receptivity | On-press developability |
| Example 17 | 0.7 eV or less | 0.7 eV or less | G-1 | An-1 | An-4 | M-1 | 300 | Support A | 15 mm, L* value = 80 | Formed of large diameter portion and small diameter portion | > 10° | 5 | 5 |
| Example 18 | 0.7 eV or less | 0.7 eV or less | G-1 | An-1 | An-3 | M-2 | 300 | Support A | 15 mm, L* value = 80 | Formed of large diameter portion and small diameter portion | > 10° | 4 | 5 |
| Example 19 | 0.7 eV or less | 0.7 eV or less | G-1 | An-1 | An-3 | M-1 | 150 | Support A | 15 mm, L* value = 80 | Formed of large diameter portion and small diameter portion | > 10° | 5 | 4 |
| Example 20 | 0.7 eV or less | 0.7 eV or less | G-1 | An-1 | An-3 | M-1 | 300 | Support B | 15 mm, L* value < 70 | Formed of large diameter portion and small diameter portion | > 10° | 5 | 5 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | |
|---|---|---|---|---|---|---|---|---|---|---|---|---|---|
| | | | | | | Type | Content (mg/m²) | Type | Average diameter of micropores and L*value | Large diameter portion and small diameter portion | | Receptivity | On-press developability |
| Example 21 | 0.7 eV or less | 0.7 eV or less | G-1 | An-1 | An-3 | M-1 | 300 | Support C | 15 mm, L* value = 85 | Large diameter portion only | > 10° | 5 | 5 |
| Example 22 | 0.7 eV or less | 0.7 eV or less | G-2 | An-1 | An-3 | M-3 | 300 | Support C | 15 mm, L* value = 85 | Large diameter portion only | > 10° | 4 | 2 |
| Comparative Example 1 | 0.7 eV or less | 0.7 eV or less | - | An-2 | An-2 | M-4 | 300 | Support C | 15 mm, L* value = 85 | Large diameter portion only | > 10° | 3 | 1 |
| Comparative Example 2 | 0.7 eV or less | 0.7 eV or less | G-1 | An-2 | An-2 | M-3 | 300 | Support C | 15 mm, L* value = 85 | Large diameter portion only | > 10° | 3 | 1 |
| Comparative Example 3 | 0.7 eV or less | 0.7 eV or less | - | An-2 | An-2 | M-2 | 300 | Support C | 15 mm, L* value = 85 | Large diameter portion only | 0° or more and 10° or less | 2 | 1 |

[Table 5]

| | Time taken for satisfying Cp (t)/Cp (20 seconds) = 0.95 t (second) | Cp (0 seconds) (nf) | Position of image-recor ding layer | Addition polymerization-type resin | | | | | Compound satisfying δp = 2.4 to 14 in Hansen solubility parameters | | | | | |
|---|---|---|---|---|---|---|---|---|---|---|---|---|---|---|
| | | | | Type | Shape | Dispersible group: presence or absence of -Q-W-Y | Structure having dispersible group | Content ($mg/m^2$) | Type | δp ($MPa^{0.5}$) | Molecular weight | Presence or absence of hydrophilic group | Structure of hydrophilic group | Content ($mg/m^2$) |
| Example 23 | t = 6 seconds | 700 | Outermost layer | P-1 | Non-particle | Present | PEO | 200 | A-1 | 3.9 | 380 | Present | Sulfo group | 30 |
| Example 24 | t = 6 seconds | 700 | Outermost layer | P-1 | Non-particle | Present | PEO | 200 | A-1 | 3.9 | 380 | Present | Sulfo group | 30 |
| Example 25 | t = 6 seconds | 700 | Outermost layer | P-1 | Non-particle | Present | PEO | 200 | A-1 | 3.9 | 380 | Present | Sulfo group | 30 |
| Example 26 | t = 6 seconds | 700 | Outermost layer | P-1 | Non-particle | Present | PEO | 200 | A-1 | 3.9 | 380 | Present | Sulfo group | 30 |
| Example 27 | t = 6 seconds | 700 | Outermost layer | P-1 | Non-particle | Present | PEO | 200 | A-1 | 3.9 | 380 | Present | Sulfo group | 30 |
| Example 28 | t = 6 seconds | 700 | Outermost layer | P-1 | Non-particle | Present | PEO | 200 | A-1 | 3.9 | 380 | Present | Sulfo group | 30 |
| Example 29 | t = 6 seconds | 700 | Outermost layer | P-1 | Non-particle | Present | PEO | 200 | A-1 | 3.9 | 380 | Present | Sulfo group | 30 |
| Example 30 | t = 6 seconds | 700 | Outermost layer | P-6 | Non-particle | Present | PPO | 200 | A-1 | 3.9 | 380 | Present | Sulfo group | 30 |
| Example 31 | t = 6 seconds | 700 | Outermost layer | P-7 | Non-particle | Present | PEO + PPO | 200 | A-1 | 3.9 | 380 | Present | Sulfo group | 30 |
| Example 32 | t = 6 seconds | 700 | Outermost layer | P-6 | Particle | Present | PPO | 200 | A-1 | 3.9 | 380 | Present | Sulfo group | 30 |
| Example 33 | t = 6 seconds | 700 | Outermost layer | P-7 | Particle | Present | PEO + PPO | 200 | A-1 | 3.9 | 380 | Present | Sulfo group | 30 |

[Table 6]

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | | |
|---|---|---|---|---|---|---|---|---|---|---|---|---|---|---|
| | | | | | | Type | Content (mg/m$^2$) | Type | Average diameter of micropores and L*value | Large diameter portion and small diameter portion | | Receptivity | On-press developability | Visibility |
| Example 23 | 0.7 eV or less | 0.7 eV or less | S-1 | An-1 | An-3 | M-1 | 300 | Support A | 15 mm, L* value = 80 | Formed of large diameter portion and small diameter portion | > 10° | 5 | 5 | 12 |
| Example 24 | 0.7 eV or less | 0.7 eV or less | S-6 | An-1 | An-3 | M-1 | 300 | Support A | 15 mm, L* value = 80 | Formed of large diameter portion and small diameter portion | > 10° | 5 | 5 | 11 |
| Example 25 | 0.7 eV or less | 0.7 eV or less | S-4 | An-1 | An-3 | M-1 | 300 | Support A | 15 mm, L* value = 80 | Formed of large diameter portion and small diameter portion | > 10° | 5 | 5 | 9 |
| Example 26 | 0.7 eV or less | 0.7 eV or less | S-11 | An-1 | An-3 | M-1 | 300 | Support A | 15 mm, L* value = 80 | Formed of large diameter portion and small diameter portion | > 10° | 5 | 5 | 6 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Evaluation result | | |
|---|---|---|---|---|---|---|---|---|---|---|---|---|---|---|
| | | | | | | Type | Content (mg/m$^2$) | Type | Average diameter of micropores and L*value | Large diameter portion and small diameter portion | | Receptivity | On-press developability | Visibility |
| Example 27 | 0.7 eV or less | 0.7 eV or less | S-12 | An-1 | An-3 | M-1 | 300 | Support A | 15 mm, L* value = 80 | Formed of large diameter portion and small diameter portion | > 10° | 5 | 5 | 6 |
| Example 28 | 0.7 eV or less | 0.7 eV or less | S-13 | An-1 | An-3 | M-1 | 300 | Support A | 15 mm, L* value = 80 | Formed of large diameter portion and small diameter portion | > 10° | 5 | 5 | 4 |
| Example 29 | 0.7 eV or less | 0.7 eV or less | S-14 | An-1 | An-3 | M-1 | 300 | Support A | 15 mm, L* value = 80 | Formed of large diameter portion and small diameter portion | > 10° | 5 | 5 | 4.5 |

[Table 7]

| | Evaluation result |
|---|---|
| | Suppression of residues of on-press development |
| Example 1 | 4 |
| Example 3 | 4 |
| Example 30 | 5 |
| Example 31 | 5 |
| Example 32 | 5 |
| Example 33 | 5 |

In Table 3 and Table 5, PEO represents a polyethyleneoxy structure, PPO represents a polypropyleneoxy structure, and PEO + PPO shows that the resin has both the polyethyleneoxy structure and polypropyleneoxy structure.

In Table 4 and Table 6, ΔLUMO represents the value of LUMO of the infrared absorber - LUMO of electron-accepting polymerization initiator, ΔHOMO represents the value of HOMO of the infrared absorber - HOMO of electron-donating polymerization initiator, Δ Contact angle represents the value of contact angle of an airborne water droplet on the surface of the outermost layer after exposure - contact angle of an airborne water droplet on the surface of the outermost layer of the lithographic printing plate precursor on the image-recording layer side before exposure.

The details of the compounds listed in Table 3 to Table 6 other than those described above are as follows.

<Addition polymerization-type resin>

P-1: resin having the following structure, Mw = 50,000, n = 50
P-2: resin having the following structure, Mw = 50,000, n = 50
P-3: resin having the following structure, Mw = 50,000, n = 50
P-4: resin having the following structure, Mw = 50,000
P-5: resin having the following structure, Mw = 50,000
P-6: resin having the following structure, Mw = 50,000, m = 10
P-7: resin having the following structure, Mw = 50,000, m = 10, n = 45

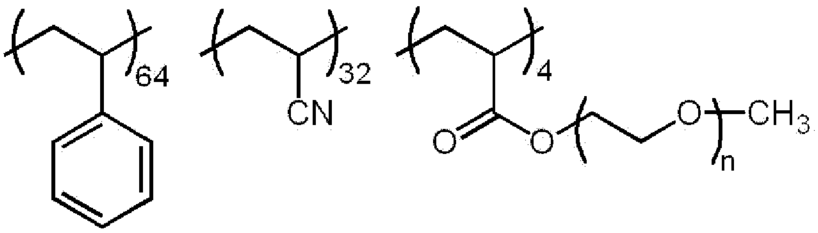

P - 1

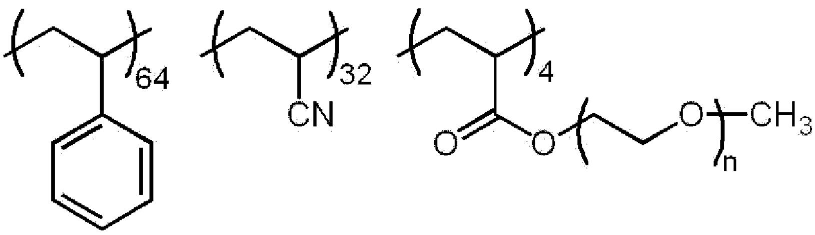

P - 2

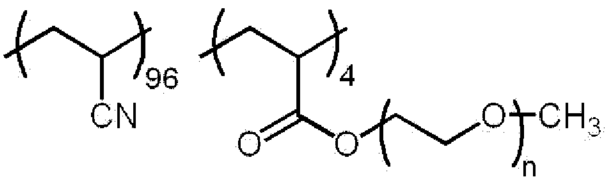

P - 3

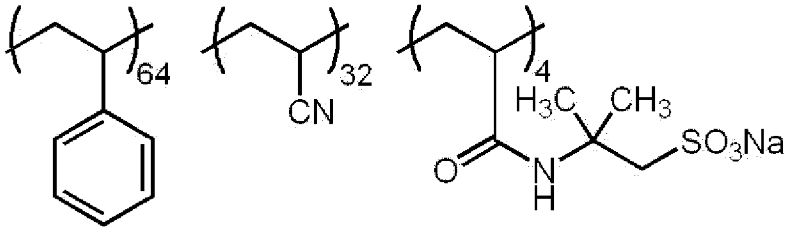

P - 4

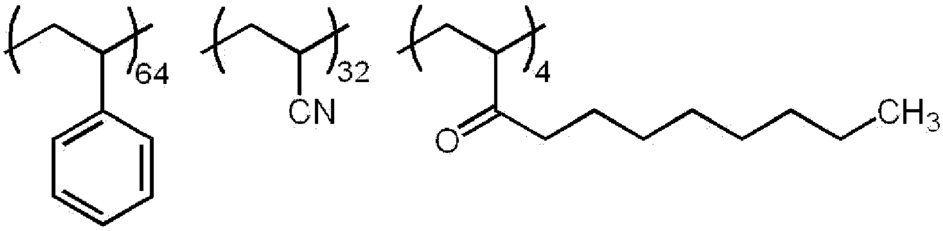

P - 5

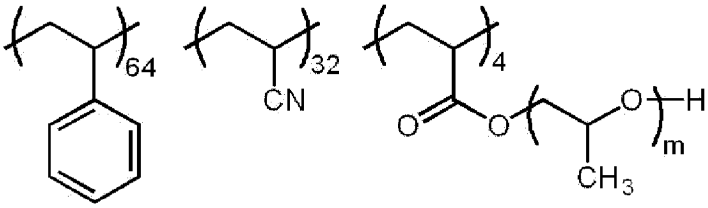

P - 6

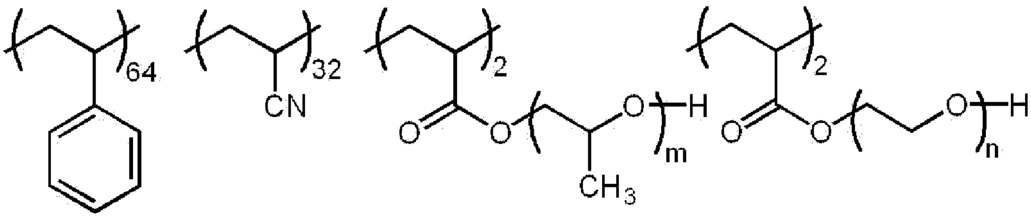

P - 7

<Compound satisfying δp = 2.5 to 14 in Hansen solubility parameters>

A-1: the following compound

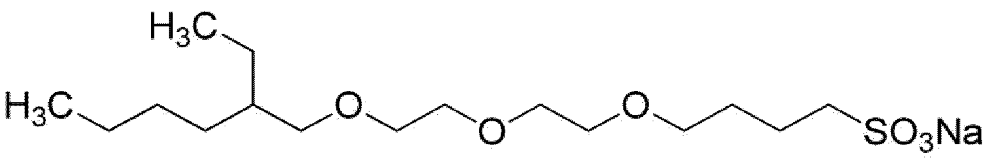

A - 1

A-2: BAYHIBIT AM, manufactured by Bayer AG, the following compound

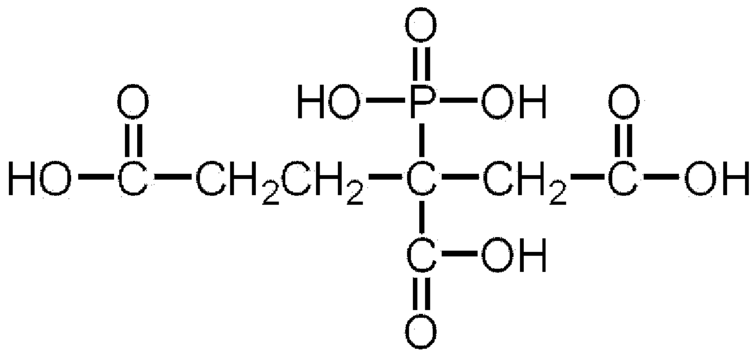

A - 2

A-3: the following compound

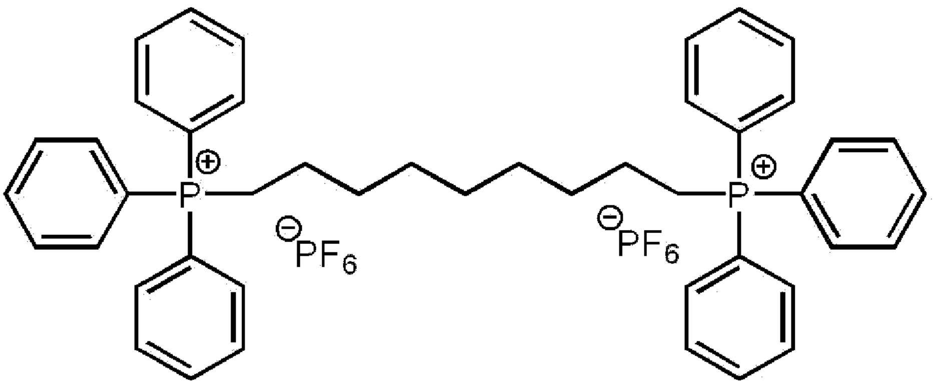

A - 3

A-4: hydroxypropyl cellulose, manufactured by NIPPON SODA CO., LTD.

<Infrared absorber>

Infrared absorber Dye-1: compound having the following structure (infrared absorber having counteranion An-1)
Infrared absorber Dye-2: compound having the following structure (infrared absorber having counteranion An-2)

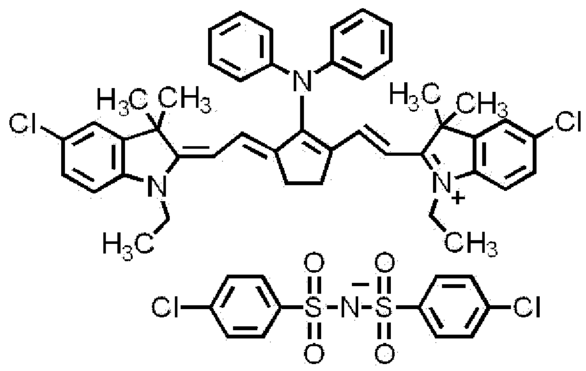

Dye - 1

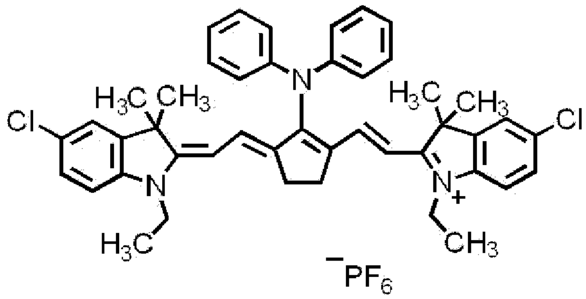

Dye - 2

<Electron-accepting polymerization initiator>

Electron-accepting polymerization initiator I-1: compound having the following structure (electron-accepting polymerization initiator having counteranion An-3)
Electron-accepting polymerization initiator I-2: compound having the following structure (electron-accepting polymerization initiator having counteranion An-4)

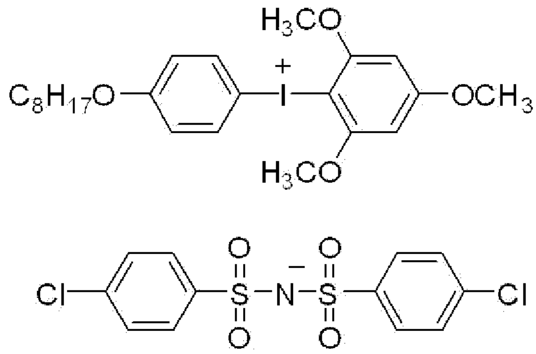

I - 1

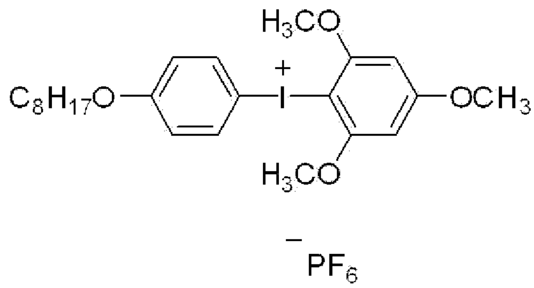

I - 2

<Polymerizable compounds>

M-1 to M-4: compounds having the following structures

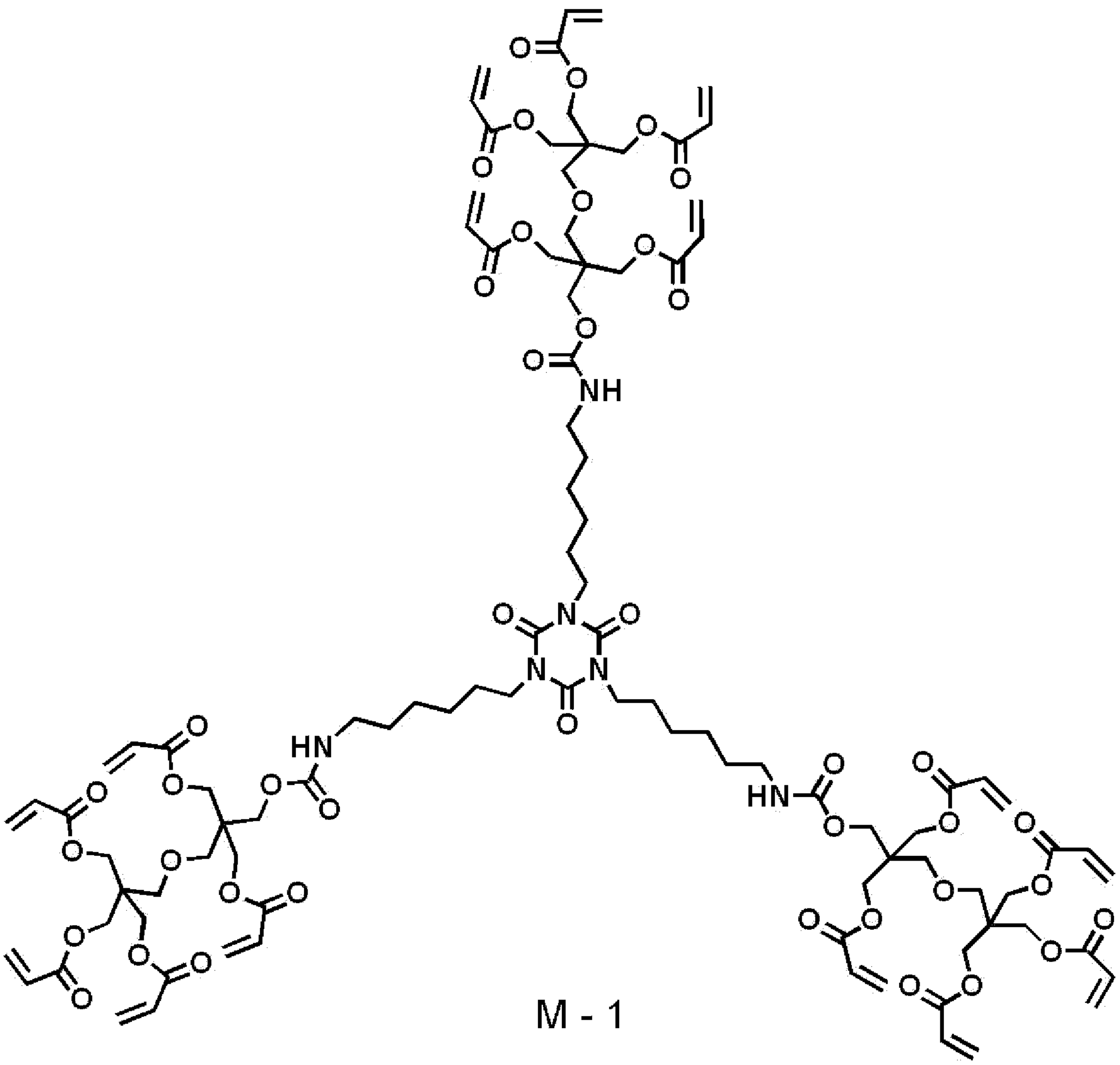

M - 1

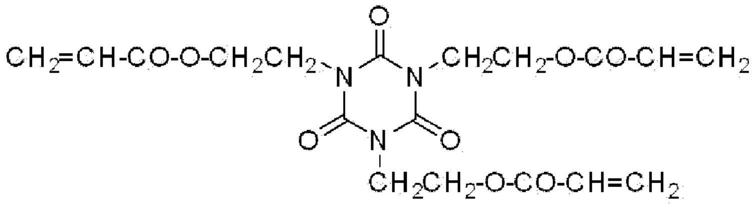

M - 2

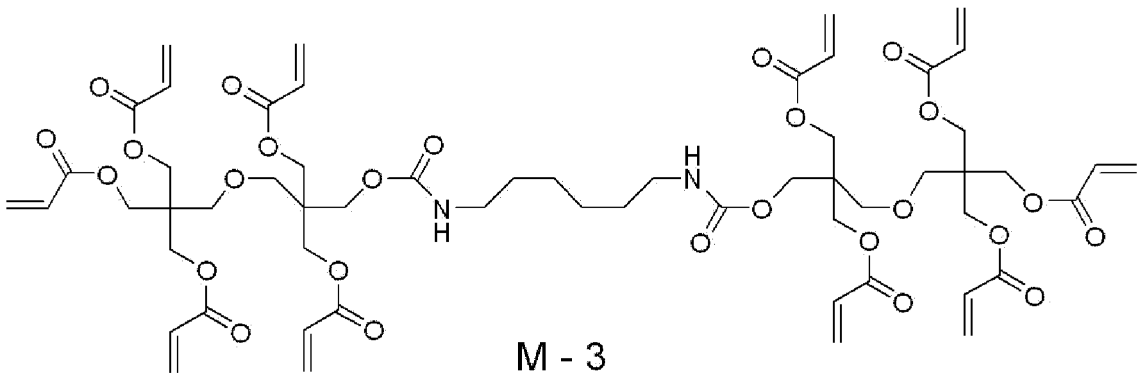

M - 3

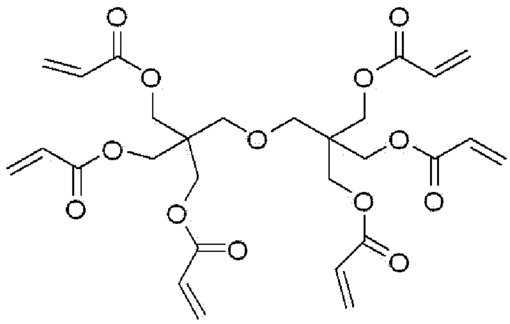

M - 4

<Color developing agent>

Color developing agent G-1: compound having the following structure
Color developing agent G-2: compound having the following structure
Color developing agents S-1, S-4, S-6, or S-11 to S-14: the same compounds as S-1, S-4, S-6, or S-11 to S-14 described above were used.

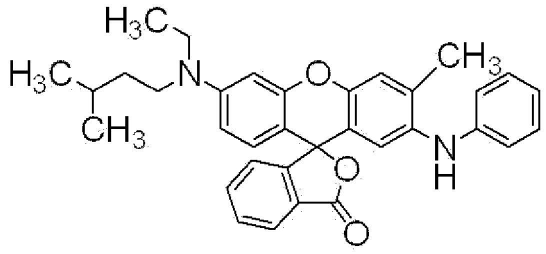

G - 1

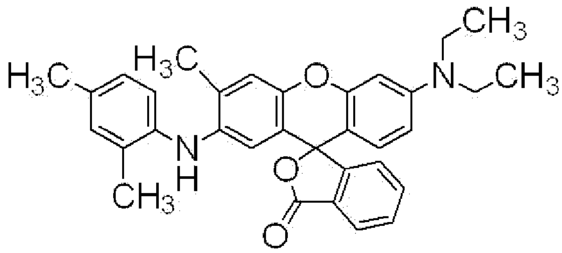

G - 2

As is evident from the results shown in Table 3 to Table 6, according to the lithographic printing plate precursors of examples, it is possible to obtain a lithographic printing plate precursor that has excellent on-press developability and can provide a lithographic printing plate having excellent receptivity.
Furthermore, as shown in Table 5 and Table 6, in all the examples using a leuco colorant as a color developing agent, excellent visibility was obtained, and the visibility was better than the visibility in Example 1 or Example 15.
In addition, as shown in Table 7, in a case where the resin has a polypropylene oxide structure as the dispersible group described above, the residues of on-press development are further suppressed.

<Preparation of coating solutions (2) and (3) for undercoat layer >

Coating solutions (2) and (3) for an undercoat layer having the following compositions were prepared.

-Composition of coating solution (2) for undercoat layer-

·Polymer (UC-1): 0.18 parts
·Surfactant (EMALEX 710, manufactured by NIHON EMULSION Co., Ltd.): 0.03 parts
·Water: 28.0 parts

-Composition of coating solution (3) for undercoat layer-

·Polymer (UC-1): 0.18 parts
·Surfactant (EMALEX 710, manufactured by NIHON EMULSION Co., Ltd.): 0.03 parts

·Hydrophilic compound: amounts listed in Table 8.
·Water: 28.0 parts

(Examples 34 to 39)

<Preparation of lithographic printing plate precursor>

Lithographic printing plate precursors of Examples 34 to 39 were prepared in the same manner as in Example 23, except that the coating solution described in Table 8 was used as a coating solution for an undercoat layer, the hydrophilic compound described in Table 8 were used in the added amount described in Table 8, and the infrared absorber having a counteranion described in Table 8, the electron-accepting polymerization initiator having a counteranion described in Table 8, the polymerizable compound described in Table 8, and the color developing agent described in Table 8 were used in the coating solution (1) for an image-recording.

<Evaluation of suppression of scratches and contamination>

In Luxel PLATESETTER T-6000III manufactured by FUJIFILM Corporation that was equipped with an infrared semiconductor laser, each of the obtained lithographic printing plate precursors was exposed under the conditions of outer drum rotation speed of 1,000 rpm (revolutions per minute), a laser output of 70%, and resolution of 2,400 dpi (dot per inch). After the exposure treatment, the lithographic printing plate obtained in an environment of a temperature of 25°C and a humidity of 70% RH was scratched by a scratch tester.

As the scratch tester, HEIDON scratching Intersity TESTER HEIDEN-18 was used. In addition, a sapphire needle having a diameter of 0.1 mm was used, and the scratch load was set to 50 (g). Without being subjected to a development treatment, the scratched plate was mounted on the plate cylinder of DIA IF2 printer manufactured by Mitsubishi Heavy Industries, Ltd. By using dampening water containing IF102 (manufactured by FUJIFILM Corporation)/tap water = 3/97 (volume ratio) and Values-G(N) black ink (manufactured by DIC Corporation), on-press development was performed by supplying the dampening water and the ink according to the standard automatic printing start method of DIA IF2. Then, printing was performed using TOKUBISHI art paper (ream weight: 76.5 kg) at a printing rate of 10,000 sheets/hour, and whether the scratched portion turned into a printing stain was evaluated. In addition, regarding the intermediate points such as 9 points and 7 points, in a case where the scratches and contamination of an example are at the intermediate level of the upper evaluation standard, the intermediate points were given to the example. The evaluation standards of 10 to 6 points are preferable. The results are shown in Table 8.

-Evaluation standard-

10 points: The scratched portion does not turn into a printing stain.
8 points: Slight printing stains that cannot be visually identified are observed on the scratched portion.
6 points: Slight printing stains are visually observed on the scratched portion.
4 points: Printing stains are visually observed on the scratched portion.
2 points: Noticeable printing stains are observed on the scratched portion.

[Table 8]

| | ΔLUMO | ΔHOMO | Color developing agent | Counteranion of infrared absorber | Counteranion of electron-accepting polymerization initiator | Polymerizable compound | | Aluminum support | | | Δ Contact angle | Coating solution for undercoat layer | Hydrophilic compound in undercoat layer | | Evaluation result |
|---|---|---|---|---|---|---|---|---|---|---|---|---|---|---|---|
| | | | | | | Type | Content ($mg/m^2$) | Type | Average diameter of micropores and L*value | Large diameter portion and small diameter portion | | Type | Type | Added amount (part by mass) | Suppression of scratches and contamination |
| Example 34 | 0.7 eV or less | 0.7 eV or less | S-1 | An-1 | An-3 | M-1 | 300 | Support A | 15 mm, L* value = 80 | Formed of large diameter portion and small diameter portion | 80 | (2) | - | - | 5 |
| Example 35 | 0.7 eV or less | 0.7 eV or less | S-1 | An-1 | An-3 | M-1 | 300 | Support A | 15 mm, L* value = 80 | Formed of large diameter portion and small diameter portion | 60 | (3) | Ethylenediaminetetraacetic acid 4Na | 0.01 | 6 |
| Example 36 | 0.7 eV or less | 0.7 eV or less | S-1 | An-1 | An-3 | M-1 | 300 | Support A | 15 mm, L* value = 80 | Formed of large diameter portion and small diameter portion | 20 | (3) | Ethylenediaminetetraacetic acid 4Na | 0.03 | 7 |

(continued)

| | ΔLUMO | ΔHOMO | Color developing agent | Counteranion of infrared absorber | Counteranion of electron-accepting polymerization initiator | Polymerizable compound | | Aluminum support | | | Δ Contact angle | Coating solution for undercoat layer | Hydrophilic compound in undercoat layer | | Evaluation result |
|---|---|---|---|---|---|---|---|---|---|---|---|---|---|---|---|
| | | | | | | Type | Content ($mg/m^2$) | Type | Average diameter of micropores and L*value | Large diameter portion and small diameter portion | | Type | Type | Added amount (part by mass) | Suppression of scratches and contamination |
| Example 37 | 0.7 eV or less | 0.7 eV or less | S-1 | An-1 | An-3 | M-1 | 300 | Support A | 15 mm, L* value = 80 | Formed of large diameter portion and small diameter portion | 9 | (3) | Tartaric acid 2K | 0.08 | 10 |
| Example 38 | 0.7 eV or less | 0.7 eV or less | S-1 | An-1 | An-3 | M-1 | 300 | Support A | 15 mm, L* value = 80 | Formed of large diameter portion and small diameter portion | 8 | (3) | Shikimic acid Na | 0.06 | 10 |
| Example 39 | 0.7 eV or less | 0.7 eV or less | S-1 | An-1 | An-3 | M-1 | 300 | | 15 mm, L* value = 80 | Formed of large diameter portion and small diameter portion | 6 | (3) | Gluconic acid Na | 0.07 | 10 |

"Δ Contact angle" shown in Table 8 represents a water contact angle on a surface of the aluminum support on the image-recording layer side that is measured by an airborne water droplet method. The contact angle was measured by the method described above.

The details of the hydrophilic compounds shown in Table 8 are as follows.

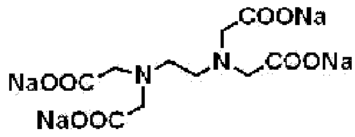
Ethylenediaminetetraacetic acid 4Na

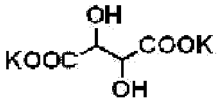
Tartaric acid 2K

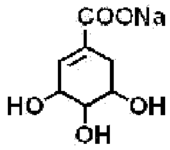
Shikimic acid Na

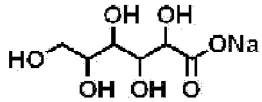
Gluconic acid Na

(Examples 40 to 45)

<Preparation of lithographic printing plate precursor>

The lithographic printing plate precursors of Examples 40 to 45 were prepared by the following method.

The aluminum support described in Table 10 was coated with the following coating solution for an undercoat layer so that the dry coating amount was 20 mg/$m^2$, thereby forming an undercoat layer. The undercoat layer was bar-coated with the following coating solution (2) for an image-recording layer and dried in an oven at 120°C for 40 seconds so that an image-recording layer having a dry coating amount of 1.0 g/$m^2$ was formed. In this way, a lithographic printing plate precursor was obtained.

The obtained lithographic printing plate precursor was evaluated in terms of various items, in the same manner as in Example 23. The evaluation results are shown in Table 10.

<Coating solution (23) for image-recording layer>

·Addition polymerization-type resin shown in Table 9: 0.240 parts (amount that results in the amount in the obtained image-recording layer shown in Table 9).
·Infrared absorber having counteranion shown in Table 10: 0.024 parts by mass.
·Electron-accepting polymerization initiator having counteranion shown in Table 10: 0.150 parts by mass.
·Electron-donating polymerization initiator D-1: 0.05 parts by mass
·Particles shown in Table 10: amounts in the obtained image-recording layer shown in Table 10.
·Polymerizable compound shown in Table 10: amounts in the obtained image-recording layer shown in Table 10.
·Surfactant shown in Table 10: amount in the obtained image-recording layer shown in Table 10.
·Other binder polymers shown in Table 10: amount in the obtained image-recording layer shown in Table 10.
·Additive shown in Table 10: amount in the obtained image-recording layer shown in Table 10.
·Color developing agent shown in Table 10: 0.060 parts by mass
·2-Butanone: 1.091 parts by mass
·1-Methoxy-2-propanol: 8.609 parts by mass
·Distilled water: 2.425 parts by mass
·Compound satisfying δp = 2.4 to 14 in the Hansen solubility parameters shown in Table 9 (specific polar compound): amount in the obtained image-recording layer shown in Table 9

In addition, a support D and components other than those described above will be shown below.

<Preparation of support D>

In Example 45, a support D was prepared by the following procedure.

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the

surface to be subjected to the electrochemical roughening treatment later was 3 g/$m^2$.

-Desmutting treatment using aqueous acidic solution (first desmutting treatment)-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 C/$dm^2$, which is the total quantity of electricity that the aluminum plate keeps during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C so that an etching amount was 0.1 g/$m^2$ or less, thereby performing an etching treatment. Then, a rinsing treatment was performed.

-Desmutting treatment using aqueous acidic solution-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Anodic oxidation treatment-

An anodic oxidation treatment was performed using 170 g/L of a sulfuric acid solution and direct current at a liquid temperature of 40°C so that the amount of the anodic oxide film was 3 g/$m^2$.

<Preparation of polymer particles P-8>

-Preparation of oil-phase component-

WANNATE (registered trademark) PM-200 (polyfunctional isocyanate compound: manufactured by Wanhua Chemical Group Co., Ltd.): 6.66 g, a 50% by mass ethyl acetate solution of TAKENATE (registered trademark) D-116N (adduct of trimethylolpropane (TMP), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of SR399 (dipentaerythritol pentaacrylate, manufactured by Sartomer Company Inc.): 11.24 g, ethyl acetate: 14.47 g, and PIONIN (registered trademark) A-41-C (manufactured by TAKEMOTO OIL & FAT Co., Ltd.): 0.45 g mixed together and stirred at room temperature (25°C) for 15 minutes, thereby obtaining an oil-phase component.

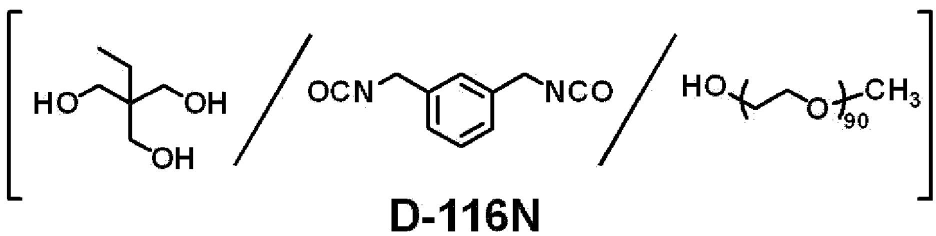

**D-116N**

-Preparation of water-phase component-

As a water-phase component, 47.2 g of distilled water was prepared.

-Microcapsule forming step-

The oil-phase component and the water-phase component were mixed together, and the obtained mixture was emulsified at 12,000 rpm for 16 minutes by using a homogenizer, thereby obtaining an emulsion.

Distilled water (16.8 g) was added to the obtained emulsion, and the obtained liquid was stirred at room temperature for 180 minutes.

After stirring, the liquid was heated at 45°C, and stirred for 5 hours in a state of being kept at 45°C so that ethyl acetate was distilled away from the liquid. Distilled water was added thereto so that the concentration of solid contents was adjusted to 20% by mass, thereby obtaining an aqueous dispersion of polymer particles P-8. P-8 had a volume average particle diameter of 165 nm that was measured using a laser diffraction/scattering-type particle diameter distribution analyzer LA-920 (manufactured by HORIBA, Ltd.).

<Color developing agent>

S-15: S-15 described above

<Infrared absorber>

D'-1 to D'-3: the following compounds

<Electron-accepting polymerization initiator>

I'-1 and I'-2: the following compounds

Bu represents a n-butyl group, and $TsO^-$ represents a tosylate anion.

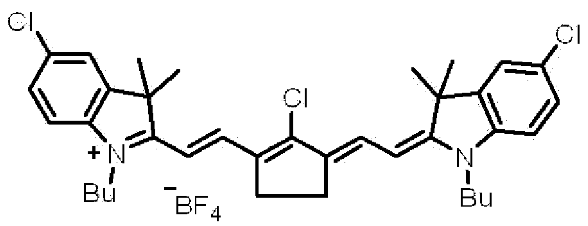

D' - 1

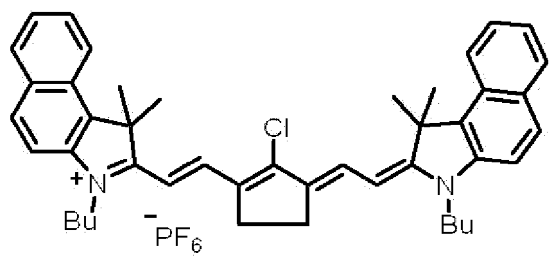

D' - 2

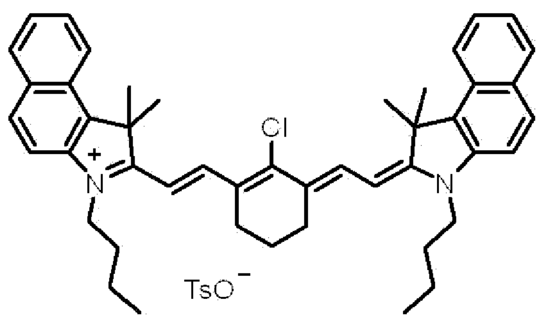

D' - 3

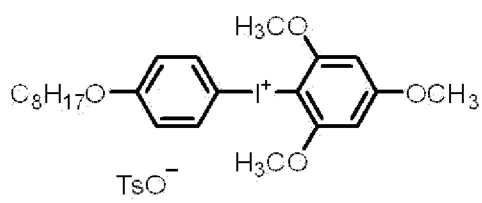

I' - 1

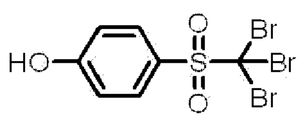

I' - 2

<Surfactant>

U'-2: the following polymer, fluoroaliphatic group-containing copolymer

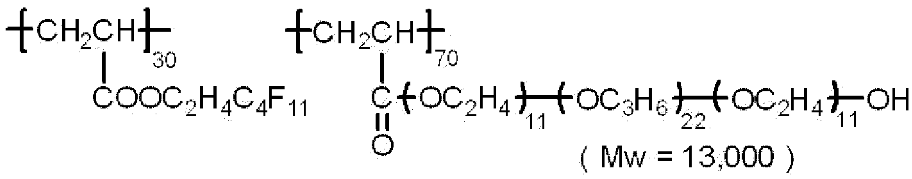

U' - 2

<Polymerizable compound>

M'-1: urethane acrylate synthesized according to the following synthesis example, ethylenically unsaturated bond valence: 7.22 mmol/g

<Synthesis of M'-1>

A mixed solution of TAKENATE D-160N (polyisocyanate, manufactured by Mitsui Chemicals, Inc., 4.7 parts by mass), ARONIX M-403 (hydroxyl group-containing polyfunctional acrylate, manufactured by TOAGOSEI CO., LTD.) in such an amount that the ratio of the NCO value of TAKENATE D-160N to the hydroxyl number of ARONIX M-403 is 1:1, 0.02 parts by mass of t-butylbenzoquinone, and 11.5 parts by mass of methyl ethyl ketone was heated at 65°C. NEOSTANN U-600 (bismuth-based polycondensation catalyst, manufactured by NITTO KASEI CO., LTD., 0.11 parts by mass) was added to the reaction solution, and the reaction solution was heated at the same temperature for 4 hours. The reaction solution was cooled to room temperature (25°C), and methyl ethyl ketone was added thereto, thereby synthesizing a urethane acrylate solution having a solid content of 50% by mass.

Subsequently, by using recycling GPC (instrument: LC908-C60, column: JAIGEL-1H-40 and 2H-40 (manufactured by Japan Analytical Industry Co., Ltd.) and tetrahydrofuran (THF) as an eluent, molecular weight fractionation of the urethane acrylate solution was performed, thereby obtaining urethane acrylate M'-1.

<Binder polymer>

P'-1: Partially acetylated polyvinyl butyral, S-LEC BL10 manufactured by SEKISUI CHEMICAL CO., LTD.

<Additive>

O'-1: The following compound

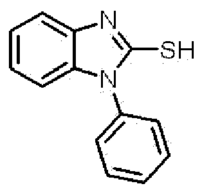

O' - 1

[Table 9]

| | Time taken for satisfying Cp (t)/Cp (20 seconds) = 0.95 t (second) | Cp (0 seconds) (nf) | Position of image-record ing layer | Addition polymerization-type resin | | | | | Compound satisfying δp = 2.4 to 14 in Hansen solubility parameters | | | | | |
|---|---|---|---|---|---|---|---|---|---|---|---|---|---|---|
| | | | | Type | Shape | Dispersible group: presence or absence of -Q-W-Y | Structure having dispersible group | Content ($mg/m^2$) | Type | δp ($MPa^{0.5}$) | Molecular weight | Presence or absence of hydrophilic group | Structure of hydrophilic group | Content ($mg/m^2$) |
| Example 40 | t = 6 seconds | 700 | Outermost layer | P-1 | Non-particle | Present | PEO | 200 | A-1 | 3.9 | 380 | Present | Sulfo group | 30 |
| Example 41 | t = 6 seconds | 700 | Outermost layer | - | - | - | - | - | A-1 | 3.9 | 380 | Present | Sulfo group | 30 |
| Example 42 | t = 6 seconds | 700 | Outermost layer | P-1 | Non-particle | Present | PEO | 200 | A-1 | 3.9 | 380 | Present | Sulfo group | 30 |
| Example 43 | t = 6 seconds | 700 | Outermost layer | P-1 | Non-particle | Present | PEO | 200 | A-1 | 3.9 | 380 | Present | Sulfo group | 30 |
| Example 44 | t = 6 seconds | 700 | Outermost layer | P-1 | Non-particle | Present | PEO | 200 | A-1 | 3.9 | 380 | Present | Sulfo group | 30 |
| Example 45 | t = 6 sec-onds | 700 | Outermost layer | - | - | - | - | - | - | - | - | - | - | - |

[Table 10]

| | ΔLUMO | ΔHOMO | Color developing agent | Particles | | Counteranion of infrared absorber | Counteranion of electron-accepting polymerization initiator | Surfactant | | Polymerizable compound | | Other polymer binders | | Additive | | Aluminum support | | | Δ Contact angle | Evaluation result | | |
|---|---|---|---|---|---|---|---|---|---|---|---|---|---|---|---|---|---|---|---|---|---|---|
| | | | | Type | Content (mg/m²) | | | Type | Content (mg/m²) | Type | Content (mg/m²) | Type | Content (mg/m²) | Type | Content (mg/m²) | Type | Average diameter of micropores and L*value | Large diameter portion and small diameter portion | | Receptivity | On-press developability | Visibility |
| Example 40 | 0.7 eV or less | 0.7 eV or less | S-15 | - | - | An-1 | An-3 | W-1 | 4.16 | M-1 | 300 | - | - | - | - | Support A | 15 mm, L* value = 80 | Formed of large diameter portion and small diameter portion | > 10° | 5 | 5 | 12 |
| Example 41 | 0.7 eV or less | 0.7 eV or less | S-15 | - | - | An-1 | An-3 | W-1 | 4.16 | M-1 | 300 | - | - | - | - | Support A | 15 mm, L* value = 80 | Formed of large diameter portion and small diameter portion | > 10° | 5 | 5 | 12 |
| Example 42 | 0.7 eV or less | 0.7 eV or less | S-15 | - | - | An-1 | An-3 | U'-2 | 4.16 | M-1 | 300 | - | - | - | - | Support A | 15 mm, L* value = 80 | Formed of large diameter portion and small diameter portion | > 10° | 5 | 5 | 12 |
| Example 43 | 0.7 eV or less | 0.7 eV or less | S-15 | - | - | D'-1 | I'-1 | W-1 | 4.16 | M'-1 | 300 | - | - | O'-1 | 0.04 | Support A | 15 mm, L* value = 80 | Formed of large diameter portion and small diameter portion | > 10° | 5 | 5 | 12 |
| Example 44 | 0.7 eV or less | 0.7 eV or less | S-15 | P-8 | 0.4 | D'-2 | I'-1 | W-1 | 4.16 | M'-1 | 300 | - | - | O'-1 | 0.04 | Support A | 15 mm, L* value = 80 | Formed of large diameter portion and small diameter portion | > 10° | 5 | 5 | 12 |
| Example 45 | 0.7 eV or less | 0.7 eV or less | S-15 | - | - | D'-3 | I'-2 | W-1 | 4.16 | M-1 | 300 | P'-1 | 0.25 | - | - | Support D | 16.5 mm, L* value = 78 | Large diameter portion only | > 10° | 5 | 5 | 12 |

As is evident from the results shown in Table 9 and Table 10, according to the lithographic printing plate precursors of Examples 40 to 45, it is possible to obtain a lithographic printing plate precursor that has excellent on-press developability and can provide a lithographic printing plate having excellent receptivity.

Furthermore, as shown in Tables 9 and 10, in all the examples using a leuco colorant as a color developing agent, excellent visibility was obtained.

Explanation of References

18: aluminum plate
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate
10: lithographic printing plate precursor
12a, 12b: aluminum support
14: undercoat layer
16: image-recording layer
20a, 20b: anodic oxide film
22a, 22b: micropore
24: large diameter portion
26: small diameter portion
D: depth of large diameter portion
50: main electrolytic cell
51: alternating current power source
52: radial drum roller
53a, 53b: main pole
54: electrolytic solution supply port
55: electrolytic solution
56: auxiliary anode
60: auxiliary anode tank

W: aluminum plate
A1: solution supply direction
A2: electrolytic solution discharge direction
410: anodic oxidation treatment device
412: power supply tank
414: electrolytic treatment tank
416: aluminum plate
418, 426: electrolytic solution
420: power supply electrode
422, 428: roller
424: nip roller
430: electrolysis electrode
432: cell wall
434: direct current power source

**Claims**

1. A lithographic printing plate precursor comprising:

an aluminum support; and
an image-recording layer on the aluminum support,
wherein the image-recording layer contains an infrared absorber, a polymerization initiator, a polymerizable compound, and an addition polymerization-type resin having a dispersible group, **characterized in that** in a case where a capacitance Cp of the lithographic printing plate precursor is set to satisfy Cp (t)/Cp (20 seconds) = 0.95, t satisfies t < 12 seconds, the capacitance Cp of the lithographic printing plate precursor is measured by bringing at least a measurement portion of the image-recording layer into contact with a 2% by mass aqueous sodium chloride solution at 25°C, t represents an elapsed time from when the measurement portion is covered with the aqueous sodium chloride solution, and Cp (t) represents a capacitance measured after t seconds;

wherein the addition polymerization-type resin includes a resin having a constitutional unit formed of an aromatic vinyl compound and a constitutional unit formed of an acrylonitrile compound, wherein the content of the constitutional unit formed of the aromatic vinyl compound with respect to the total mass of the addition polymerization-type resin is 30% by mass to 70% by mass;
wherein the image-recording layer contains a compound that satisfies $\delta p$ = 2.4 to 14 in the Hansen solubility parameters; and
wherein the dispersible group includes a group represented by Formula Z,

*-Q-W-Y        Formula Z

in Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

2. The lithographic printing plate precursor according to claim 1,
wherein the addition polymerization-type resin includes particles.

3. The lithographic printing plate precursor according to claim 1 or 2,
wherein in a case where the capacitance Cp of the lithographic printing plate precursor is set to satisfy Cp (t)/Cp (20 seconds) = 0.95, t satisfies t < 6.5 seconds.

4. The lithographic printing plate precursor according to any one of claims 1 to 3,
wherein the image-recording layer is an outermost layer.

5. The lithographic printing plate precursor according to claim 1,
wherein the compound that satisfies $\delta p$ = 2.4 to 14 has a molecular weight of 5,000 or less.

**6.** The lithographic printing plate precursor according to claim 1, wherein the compound that satisfies δp = 2.4 to 14 has a hydrophilic group.

**7.** The lithographic printing plate precursor according to claim 6, wherein the hydrophilic group is at least one kind of structure selected from the group consisting of a zwitterionic structure, a polyalkylene oxide structure, a sulfonic acid group, a sulfonate group, a carboxylic acid group, a carboxylate group, a phosphoric acid group, and a phosphate group.

**8.** The lithographic printing plate precursor according to any one of claims 1 to 7, wherein the image-recording layer further contains a color developing agent.

**9.** The lithographic printing plate precursor according to any one of claims 1 to 8,

wherein the polymerization initiator includes an electron-accepting polymerization initiator, and
the electron-accepting polymerization initiator includes a compound represented by Formula (II),

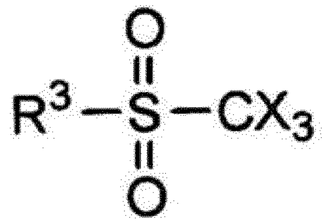
(II)

in Formula (II), X represents a halogen atom, and $R^3$ represents an aryl group.

**10.** The lithographic printing plate precursor according to any one of claims 1 to 9, wherein the image-recording layer further contains polyvinyl acetal.

**11.** The lithographic printing plate precursor according to any one of claims 1 to 10, which is an on-press development type lithographic printing plate precursor.

**12.** A method for preparing a lithographic printing plate, comprising:

a step of exposing the lithographic printing plate precursor according to any one of claims 1 to 11 in the shape of an image; and
a step of supplying at least one material selected from the group consisting of a printing ink and dampening water on a printer so as to remove the image-recording layer in a non-image area.

**Patentansprüche**

**1.** Lithographischer Druckplattenvorläufer, umfassend:

einen Aluminiumträger; und
eine Bildaufzeichnungsschicht auf dem Aluminiumträger,
wobei die Bildaufzeichnungsschicht einen Infrarotabsorber, einen Polymerisationsinitiator, eine polymerisierbare Verbindung und ein Harz des Additionspolymerisationstyps mit einer dispergierbaren Gruppe enthält, **dadurch gekennzeichnet, dass**
in einem Fall, in dem eine Kapazität Cp des lithographischen Druckplattenvorläufers so eingestellt ist, dass sie Cp (t)/Cp (20 Sekunden) = 0,95 erfüllt, t t < 12 Sekunden erfüllt, die Kapazität Cp des lithographischen Druckplattenvorläufers durch In-Kontakt-Bringen mindestens eines Messabschnitts der Bildaufzeichnungsschicht mit einer 2 Massen-% wässrigen Natriumchloridlösung bei 25 °C gemessen wird, t eine verstrichene Zeit seit dem Bedecken des Messabschnitts mit der wässrigen Natriumchloridlösung darstellt, und Cp (t) eine Kapazität, die nach t Sekunden gemessen wird, darstellt;
wobei das Harz des Additionspolymerisationstyps ein Harz mit einer Konstitutionseinheit, die aus einer aromatischen Vinylverbindung gebildet ist, und einer Konstitutionseinheit, die aus einer Acrylnitrilverbindung gebildet ist, enthält, wobei der Gehalt der Konstitutionseinheit, die aus der aromatischen Vinylverbindung gebildet ist, in

Bezug auf die Gesamtmasse des Harzes des Additionspolymerisationstyps 30 Massen-% bis 70 Massen-% beträgt;
wobei die Bildaufzeichnungsschicht eine Verbindung enthält, die $\delta p$ = 2,4 bis 14 bei den Hansen-Löslichkeitsparametern erfüllt; und
wobei die dispergierbare Gruppe eine durch Formel Z dargestellte Gruppe enthält,

*-Q-W-Y Formel Z

wobei in Formel Z Q eine divalente Verbindungsgruppe darstellt, W eine divalente Gruppe mit einer hydrophilen Struktur oder eine divalente Gruppe mit einer hydrophoben Struktur darstellt, Y eine monovalente Gruppe mit einer hydrophilen Struktur oder eine monovalente Gruppe mit einer hydrophoben Struktur darstellt, entweder W oder Y eine hydrophile Struktur aufweist und * eine Bindungsstelle mit anderen Strukturen darstellt.

**2.** Lithographischer Druckplattenvorläufer nach Anspruch 1,
wobei das Harz des Additionspolymerisationstyps Partikel enthält.

**3.** Lithographischer Druckplattenvorläufer nach Anspruch 1 oder 2,
wobei in einem Fall, in dem die Kapazität Cp des lithographischen Druckplattenvorläufers so eingestellt ist, dass sie Cp (t)/Cp (20 Sekunden) = 0,95 erfüllt, t t < 6,5 Sekunden erfüllt.

**4.** Lithographischer Druckplattenvorläufer nach einem der Ansprüche 1 bis 3,
wobei die Bildaufzeichnungsschicht eine äußerste Schicht ist.

**5.** Lithographischer Druckplattenvorläufer nach Anspruch 1,
wobei die Verbindung, die $\delta p$ = 2,4 bis 14 erfüllt, ein Molekulargewicht von 5.000 oder weniger aufweist.

**6.** Lithographischer Druckplattenvorläufer nach Anspruch 1,
wobei die Verbindung, die $\delta p$ = 2,4 bis 14 erfüllt, eine hydrophile Gruppe aufweist.

**7.** Lithographischer Druckplattenvorläufer nach Anspruch 6,
wobei die hydrophile Gruppe mindestens eine Art von Struktur ist, die aus der Gruppe, die aus einer zwitterionischen Struktur, einer Polyalkylenoxidstruktur, einer Sulfonsäuregruppe, einer Sulfonatgruppe, einer Carbonsäuregruppe, einer Carboxylatgruppe, einer Phosphorsäuregruppe und einer Phosphatgruppe besteht, ausgewählt wird.

**8.** Lithographischer Druckplattenvorläufer nach einem der Ansprüche 1 bis 7, wobei die Bildaufzeichnungsschicht ferner ein Farbentwicklungsmittel enthält.

**9.** Lithographischer Druckplattenvorläufer nach einem der Ansprüche 1 bis 8,

wobei der Polymerisationsinitiator einen elektronenannehmenden Polymerisationsinitiator umfasst, und
der elektronenannehmende Polymerisationsinitiator eine Verbindung enthält, die durch Formel (II) dargestellt wird,

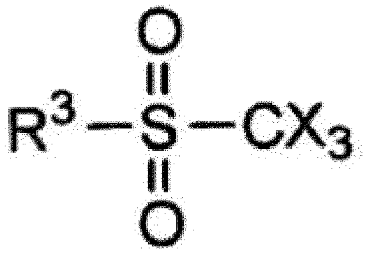
(II)

wobei in Formel (II) X ein Halogenatom darstellt und $R^3$ eine Arylgruppe darstellt.

**10.** Lithographischer Druckplattenvorläufer nach einem der Ansprüche 1 bis 9,
wobei die Bildaufzeichnungsschicht ferner Polyvinylacetal enthält.

**11.** Lithographischer Druckplattenvorläufer nach einem der Ansprüche 1 bis 10, der ein lithographischer Druckplattenvorläufer des Auf-Presse-Entwicklungstyps ist.

**12.** Verfahren zum Herstellen einer lithographischen Druckplatte, umfassend:

einen Schritt des Belichtens des lithographischen Druckplattenvorläufers nach einem der Ansprüche 1 bis 11 in der Form eines Bildes; und
einen Schritt des Zuführens von mindestens einem Material, das aus der Gruppe ausgewählt wird, die aus einer Druckfarbe und Feuchtwasser besteht, auf einen Drucker, so dass die Bildaufzeichnungsschicht in einem Nichtbildbereich entfernt wird.

## Revendications

**1.** Précurseur de plaque d'impression lithographique comprenant :

un support en aluminium ; et
une couche d'enregistrement d'images sur le support en aluminium,
dans lequel la couche d'enregistrement d'images contient un absorbeur infrarouge, un initiateur de polymérisation, un composé polymérisable et une résine de type polymérisation par addition ayant un groupe dispersible,
**caractérisé en ce que**
dans un cas où une capacitance Cp du précurseur de plaque d'impression lithographique est réglée pour satisfaire Cp (t)/Cp (20 secondes) = 0,95, t satisfait t < 12 secondes, la capacitance Cp du précurseur de plaque d'impression lithographique est mesurée en mettant au moins une partie de mesure de la couche d'enregistrement d'images en contact avec une solution aqueuse de chlorure de sodium à 2 % en masse à 25 °C, t représente un temps écoulé depuis que la partie de mesure est recouverte de la solution aqueuse de chlorure de sodium, et Cp (t) représente une capacitance mesurée après t secondes ;
dans lequel la résine de type polymérisation par addition inclut une résine ayant une unité constitutionnelle formée d'un composé vinyle aromatique et une unité constitutionnelle formée d'un composé d'acrylonitrile, dans lequel la teneur de l'unité constitutionnelle formée du composé vinyle aromatique par rapport à la masse totale de la résine de type polymérisation par addition est de 30 % en masse à 70 % en masse ;
dans lequel la couche d'enregistrement d'images contient un composé qui satisfait $\delta p$ = 2,4 à 14 dans les paramètres de solubilité de Hansen ; et
dans lequel le groupe dispersible inclut un groupe représenté par Formule Z,

*-Q-W-Y Formule Z

dans Formule Z, Q représente un groupe de liaison divalent, W représente un groupe divalent ayant une structure hydrophile ou un groupe divalent ayant une structure hydrophobe, Y représente un groupe monovalent ayant une structure hydrophile ou un groupe monovalent ayant une structure hydrophobe, soit W soit Y a une structure hydrophile, et * représente un site de liaison avec d'autres structures.

**2.** Précurseur de plaque d'impression lithographique selon la revendication 1,
dans lequel la résine de type polymérisation par addition inclut des particules.

**3.** Précurseur de plaque d'impression lithographique selon la revendication 1 ou la revendication 2,
dans lequel dans un cas où la capacitance Cp du précurseur de plaque d'impression lithographique est réglée pour satisfaire Cp (t)/Cp (20 secondes) = 0,95, t satisfait t < 6,5 secondes.

**4.** Précurseur de plaque d'impression lithographique selon l'une quelconque des revendications 1 à 3,
dans lequel la couche d'enregistrement d'images est une couche la plus externe.

**5.** Précurseur de plaque d'impression lithographique selon la revendication 1,
dans lequel le composé qui satisfait $\delta p$ = 2,4 à 14 a un poids moléculaire de 5 000 ou moins.

**6.** Précurseur de plaque d'impression lithographique selon la revendication 1,
dans lequel le composé qui satisfait $\delta p$ = 2,4 à 14 a un groupe hydrophile.

**7.** Précurseur de plaque d'impression lithographique selon la revendication 6,

dans lequel le groupe hydrophile est au moins un type de structure sélectionné parmi le groupe constitué d'une structure zwitterionique, d'une structure de polyalkylène glycol, d'un groupe acide sulfonique, d'un groupe sulfonate, d'un groupe acide carboxylique, d'un groupe carboxylate, d'un groupe acide phosphorique et d'un groupe phosphate.

**8.** Précurseur de plaque d'impression lithographique selon l'une quelconque des revendications 1 à 7, dans lequel la couche d'enregistrement d'images contient en outre un agent de développement de couleur.

**9.** Précurseur de plaque d'impression lithographique selon l'une quelconque des revendications 1 à 8,

dans lequel l'initiateur de polymérisation inclut un initiateur de polymérisation accepteur d'électrons, et l'initiateur de polymérisation accepteur d'électrons inclut un composé représenté par Formule (II),

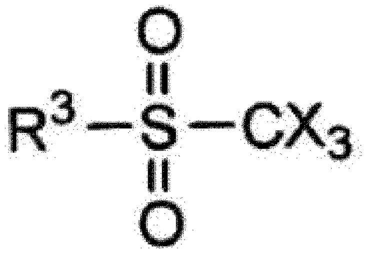

(II)

dans Formule (II), X représente un atome d'halogène et $R^3$ représente un groupe aryle.

**10.** Précurseur de plaque d'impression lithographique selon l'une quelconque des revendications 1 à 9, dans lequel la couche d'enregistrement d'images contient en outre de l'acétal de polyvinyle.

**11.** Précurseur de plaque d'impression lithographique selon l'une quelconque des revendications 1 à 10, qui est un précurseur de plaque d'impression lithographique de type développement sur presse.

**12.** Procédé de préparation d'une plaque d'impression lithographique, comprenant :

une étape d'exposition du précurseur de plaque d'impression lithographique selon l'une quelconque des revendications 1 à 11 sous la forme d'une image ; et
une étape de fourniture d'au moins un matériau sélectionné parmi le groupe constitué d'une encre d'impression et d'eau de mouillage sur une presse de manière à éliminer la couche d'enregistrement d'images dans une zone sans image.

FIG. 1

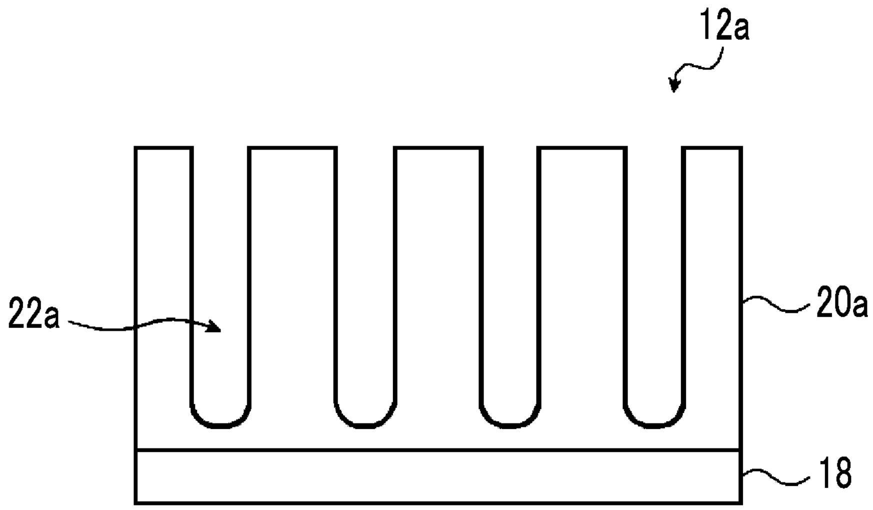


FIG. 2

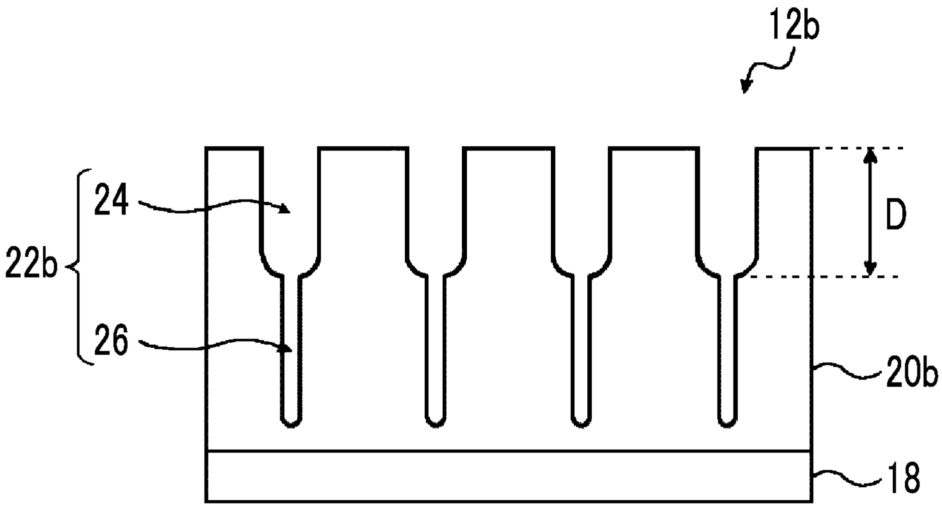

FIG. 3

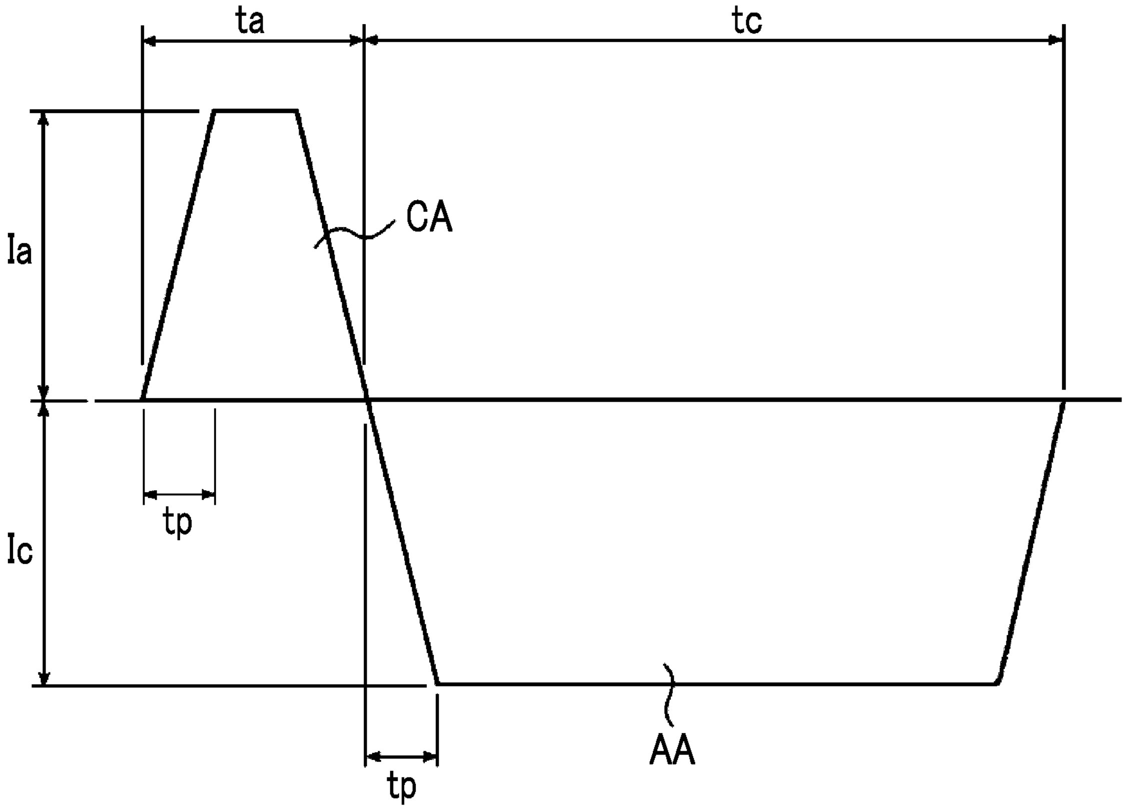

FIG. 4

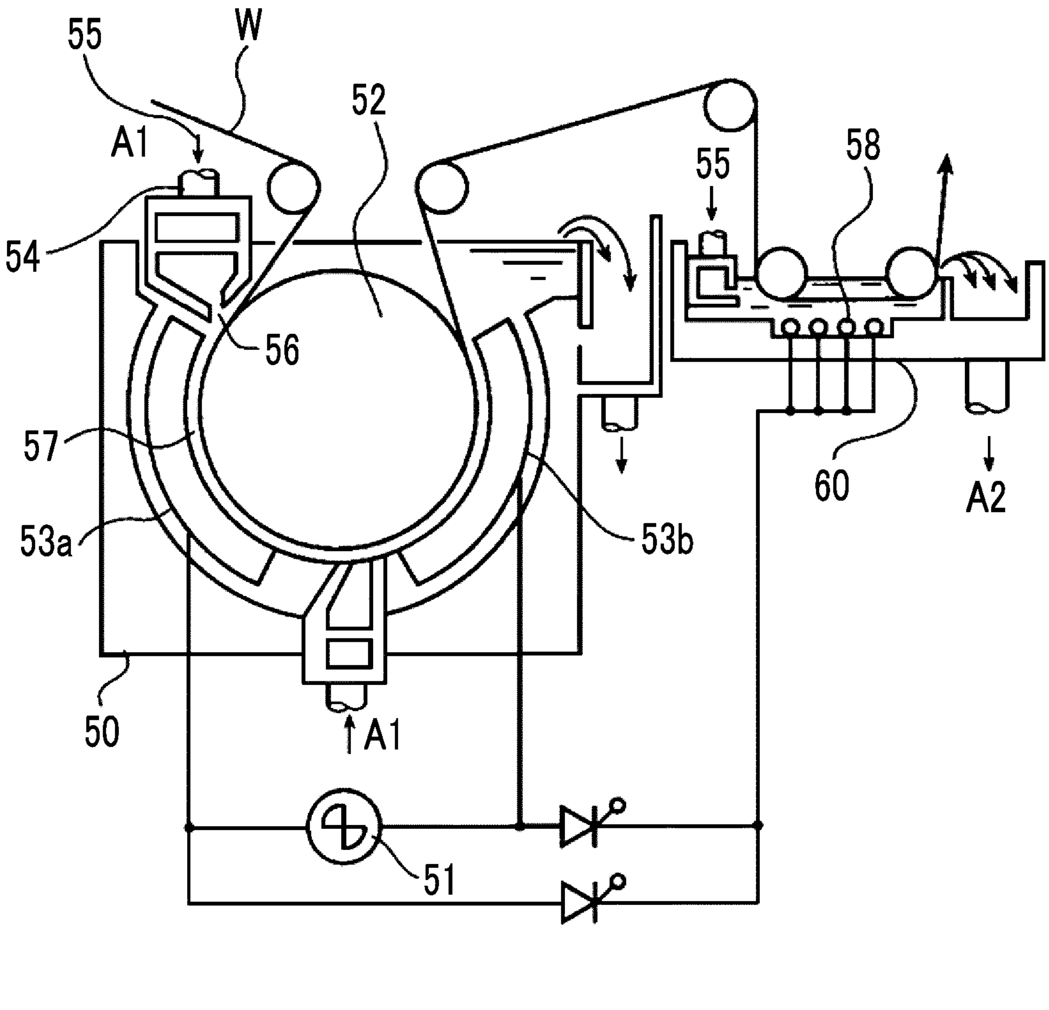

FIG. 5

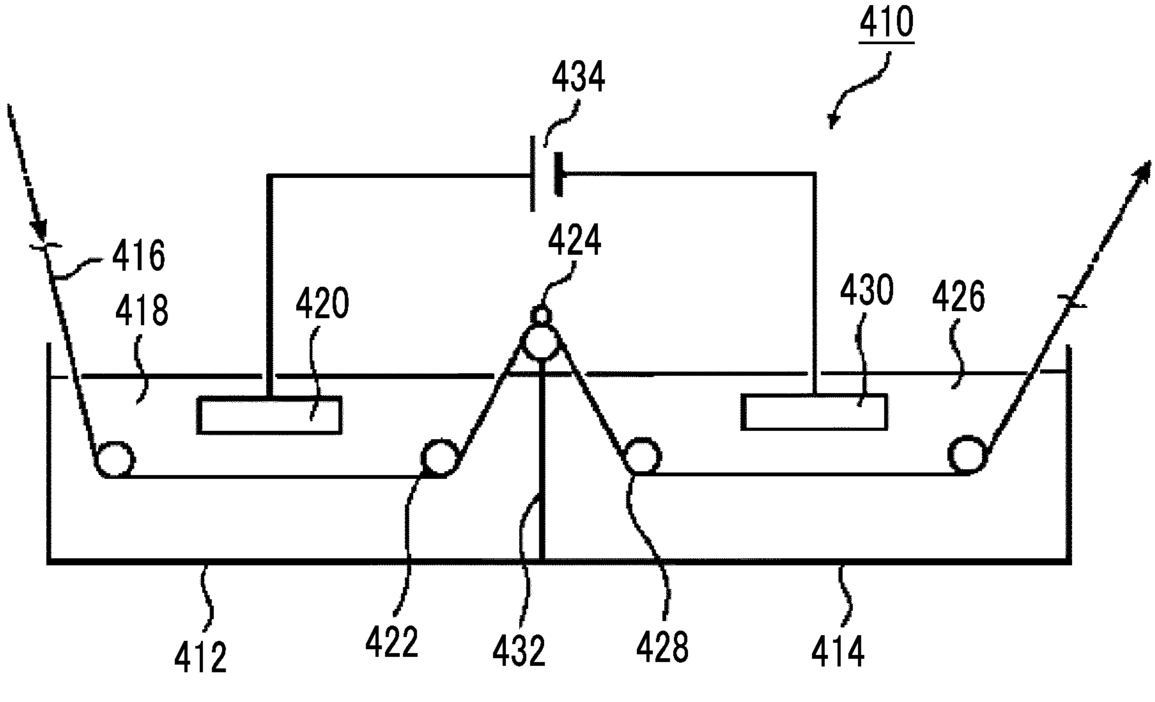

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018508385 A
- JP 2013199130 A
- WO 2019013268 A1
- EP 1449650 A2
- EP 1449653 A2
- EP 1972439 A2
- EP 2297611 A1
- EP 2113381 A2
- EP 2105298 A1
- EP 3409498 A1
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H05005005 A
- JP 2001222101 A
- JP 2008544322 A
- WO 2016027886 A
- WO 2017141882 A
- WO 2018043259 A
- JP 8108621 A
- JP H08108621 A
- JP 61166544 A
- JP S61166544 A
- JP 2002328465 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP 51037193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 50040047 B
- JP S5040047 B
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S5549729 B
- JP 2005250216 A
- JP 2006259137 A

**Non-patent literature cited in the description**


- Dye Handbooks. Society of Synthetic Organic Chemistry, 1970
- Hansen Solubility Parameters. **CHARLES M. HANSEN**. A Users Handbook. CRC Press, 2007
- Polymer Handbook, vol. VII, 698-711
- **IWANAMI**. Dictionary of Physics and Chemistry. Iwanami Shoten, Publishers, 1998